(19) Europäisches Patentamt
European Patent Office
Office européen des brevets

(11) EP 4 159 460 B1

(12) **EUROPEAN PATENT SPECIFICATION**

(45) Date of publication and mention of the grant of the patent:
**22.04.2026 Bulletin 2026/17**

(21) Application number: **21813060.7**

(22) Date of filing: **27.05.2021**

(51) International Patent Classification (IPC):
***B41N 3/00*** *(2006.01)* ***B41N 1/14*** *(2006.01)*
***G03F 7/00*** *(2006.01)* ***G03F 7/004*** *(2006.01)*
***G03F 7/027*** *(2006.01)* ***G03F 7/029*** *(2006.01)*
***G03F 7/031*** *(2006.01)* ***G03F 7/09*** *(2006.01)*
***G03F 7/11*** *(2006.01)*

(52) Cooperative Patent Classification (CPC):
**B41C 1/1008;** B41C 1/1016; B41C 2201/04; B41C 2210/08; B41C 2210/22

(86) International application number:
**PCT/JP2021/020220**

(87) International publication number:
**WO 2021/241693 (02.12.2021 Gazette 2021/48)**

(54) **LAYERED BODY**

SCHICHTKÖRPER

CORPS STRATIFIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.05.2020 JP 2020095074**

(43) Date of publication of application:
**05.04.2023 Bulletin 2023/14**

(73) Proprietor: **FUJIFILM Corporation**
**Tokyo 106-8620 (JP)**

(72) Inventor: **SAKAGUCHI, Akira**
**Haibara-gun, Shizuoka 421-0396 (JP)**

(74) Representative: **HGF**
**HGF Limited**
**4th Floor, 1 City Square**
**Leeds LS1 2ES (GB)**

(56) References cited:
**WO-A1-2016/027886**
**WO-A1-2018/092661**
**WO-A1-2018/159710**
**WO-A1-2019/044087**
**CN-A- 1 579 893**
**JP-A- 2002 234 272**
**JP-A- 2005 246 966**
**JP-A- 2006 096 027**
**JP-A- 2010 008 561**
**JP-A- 2013 504 084**
**US-A1- 2009 269 699**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### BACKGROUND OF THE INVENTION

1. Field of the Invention

The present invention relates to a laminate of a lithographic printing plate precursor and interleaving paper.

2. Description of the Related Art

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (non-ink-receiving portion) respectively, the adhesiveness of ink is varied within the surface of the lithographic printing plate such that only the image area receives the ink, and then printing is performed by the transfer of the ink to a printing substrate such as paper.

In the related art, in order to prepare this lithographic printing plate, a lithographic printing plate precursor (PS plate) has been widely used which is obtained by providing a lipophilic photosensitive resin layer (image-recording layer) on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. As one of simple production methods, a method called "on-press development" is being carried out. That is, on-press development is a method of exposing a lithographic printing plate precursor, then immediately mounting the precursor on a printer without performing development of the related art, and removing an unnecessary portion of the image-recording layer at an early stage of the ordinary printing step.

In the present invention, a lithographic printing plate precursor that can be used for such on-press development is called "on-press development type lithographic printing plate precursor"

Examples of the laminate of lithographic printing plate precursors in the related art include the laminate described in JP2010-76336A.

JP2010-76336A describes a laminate of lithographic printing plate precursors obtained by alternately piling up and integrating lithographic printing plate precursors and interleaving paper, in which each of the lithographic printing plate precursors has a support and an image-recording layer that is on the support, contains (A) infrared absorber, (B) radical polymerization initiator, and (C) polymerizable compound and enables a non-exposed portion to be removed by the supply of a printing ink and dampening water, the content of chloride ions in the interleaving paper is 0.5% by mass or less, and a centerline average roughness (Ra) of the interleaving paper is 2.4 $\mu$m to 5 $\mu$m.

JP2005246966 discloses a laminate for lithographic printing plate precursors formed by alternately laminating the precursors for the lithographic printing plate and interleaving sheets. The lithographic printing plate precursors comprise an image recording layer containing (A) an infrared absorber, (B) a polymerization initiator and (C) polymerizable compound on an aluminum support having a roughened surface-treated.

JP2010008561 discloses a positive lithographic printing plate material produced by disposing on an aluminum support a photosensitive layer containing an alkali-soluble resin having phenolic hydroxyl groups and a near-infrared absorbing dye having an absorption maximum at a wavelength of 700-1,200 nm, and carrying out heat treatment, wherein an atmosphere around a printing plate material in the heat treatment is an acidic atmosphere of pH 3-6.

### SUMMARY OF THE INVENTION

An object of an embodiment of the present invention is to provide a laminate in which speck-like color defects of laminated lithographic printing plate precursors are excellently suppressed.

The invention is defined in the appended claim set.

According to an embodiment of the present invention, it is possible to provide a laminate in which speck-like color defects of laminated lithographic printing plate precursors are excellently suppressed.

## BRIEF DESCRIPTION OF THE DRAWINGS

Fig. 1 is a schematic cross-sectional view of an embodiment of an aluminum support suitably used.
Fig. 2 is a schematic cross-sectional view of an embodiment of an aluminum support having an anodic oxide film.
Fig. 3 is an example of a waveform graph of alternating current used for an electrochemical roughening treatment in a manufacturing method of an aluminum support having an anodic oxide film.

## DESCRIPTION OF THE PREFERRED EMBODIMENTS

Hereinafter, the contents of the present invention will be specifically described. The following configuration requirements will be described on the basis of typical embodiments of the present invention, but the present invention is not limited to such embodiments.
In the present specification, a numerical range expressed using "to" includes numerical values listed before and after "to" as the lower limit and the upper limit.
In addition, in the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).
In the present specification, "(meth)acryl" is a term used to explain a concept including both the acryl and methacryl, and "(meth)acryloyl" is a term used to explain a concept including both the acryloyl and methacryloyl.
In addition, the term "step" in the present specification means not only an independent step but also a step that cannot be clearly differentiated from other steps as long as the intended goal of the step is achieved. Herein, "% by mass" has the same definition as "% by weight", and "part by mass" has the same definition as "part by weight".
Herein, unless otherwise specified, as each component contained in a composition or each structural unit contained in a polymer, one kind of component or one kind of structural unit may be used alone, or two or more kinds of components or two or more kinds of structural units may be used in combination.
Furthermore, in a case where there is a plurality of substances corresponding to each component in a composition, or in a case where there is a plurality of structural units corresponding to each structural unit in a polymer, unless otherwise specified, the amount of each component in the composition or the amount of each structural unit in the polymer means the total amount of the plurality of corresponding substances present in the composition or the total amount of the plurality of corresponding structural units present in the polymer.
Herein, a combination of two or more preferred aspects is a more preferred aspect.
In addition, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.
The term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.
In the present invention, "excellent in printing durability" means that a large number of sheets can be printed using a lithographic printing plate, and printing durability exhibited in a case where a UV ink used as a printing ink will be also described as "UV printing durability" hereinafter.
Hereinafter, the present invention will be specifically described.

(Laminate)

The laminate according to the present invention is laminate including a lithographic printing plate precursor and interleaving paper, in which the lithographic printing plate precursor is an on-press development type lithographic printing plate precursor containing an acid color developing agent in at least any of layers, and a pH of the interleaving paper is 5 or more.
The inventors of the present invention have found that a laminate of interleaving paper and a lithographic printing

plate precursor containing an acid color developing agent in the related art, such as the laminate in the related art described in JP2010-76336A, has a problem in that speck-like (spot-like or dot-like) color defects occurs with the passage of time.

As a result of intensive studies, the inventors of the present invention have found that adopting the above constitution makes it possible to provide a laminate in which speck-like color defects are excellently suppressed.

In the related art, interleaving paper having a pH less than 5 is frequently used. Presumably, in a case where a laminate is made of the interleaving paper and a lithographic printing plate precursor containing an acid color developing agent, some of the components of an image-recording layer containing the acid color developing agent may be aggregated in the image-recording layer with the passage of time, and acids diffused to the aggregated components from the interleaving paper may react with the acid color developing agent in the aggregated portions and develop color, which may cause speck-like color defects.

Presumably, in a case where interleaving paper having a pH of 5 or more is used, the diffusion of acids may be suppressed, and the speck-like color defects may be excellently suppressed.

The laminate according to the present invention may be a laminate of two or more sheets of lithographic printing plate precursors and one or more sheets of interleaving paper, and is preferably a laminate in which the lithographic printing plate precursors and the interleaving paper are alternately laminated.

The upper limit of the number of lithographic printing plate precursors and interleaving paper to be laminated is not particularly limited, and may be appropriately selected as desired. For example, thousands of lithographic printing plate precursors may be laminated.

The lamination direction of the lithographic printing plate precursors in the laminate according to the present invention is not particularly limited. All the lithographic printing plate precursors may be laminated in the same direction. Alternatively, the lithographic printing plate precursors may be laminated, such that one sheet of interleaving paper is interposed between two sheets of lithographic printing plate precursors and comes into contact with each of the outermost layers on the side of the image-recording layer of the lithographic printing plate precursors. In this case, the interleaving paper may or may not be laminated between the sides of supports of the lithographic printing plate precursors.

The laminate may be packaged with a packaging member such as wrapping paper or a packaging container. As the packaging member, known materials can be used. Examples thereof include a packaging member having light shielding properties and moisture proofing properties.

In addition, the laminate may have a protective member, such as a protector cardboard, on top and bottom of the laminate.

[[Interleaving paper]]

The laminate according to the present invention is a laminate of a lithographic printing plate precursor and interleaving paper, and the pH of the interleaving paper is 5 or more.

From the viewpoints of speck-like color defect suppressiveness and on-press developability, the pH of the interleaving paper is preferably 6 or more, more preferably 6 to 8, and particularly preferably 6.5 to 7.5.

The pH of the interleaving paper is measured by a cold water extraction method specified in JIS P8133 (2012).

Specifically, the pH is measured by the following method.

The interleaving paper to be measured is cut or torn in a size of about 1 $cm^2$. The sample is weighed in 2.0 g $\pm$ 0.1 g and put in a 250 mL flask with a ground glass joint. Water (100 mL) is added to the flask with a ground glass joint containing the sample pieces, and whether all the sample pieces are immersed in the water is checked. The flask is closed with the stopper of the ground glass joint, and left to stand for 1 hour at 20°C to 25°C. During this period, the flask with a ground glass joint is shaken at least once.

The extract is filtered through a glass filter with a large mesh size, the filtrate is moved to a small beaker, 2 mL of a 1 mol/L potassium chloride solution is added thereto, the pH is measured, and the obtained pH is adopted as the pH of the interleaving paper.

In order to reduce the material cost, it is preferable to select low-cost raw materials as the material of the interleaving paper used in the present invention. For example, it is possible to use paper using wood pulp 100% by mass, paper using wood pulp together with synthetic pulp, paper composed of the above paper and a low-density or high-density polyethylene layer provided on the surface of the paper, and the like.

Specifically, examples thereof include acidic paper made of paper stock prepared by adding a sizing agent and a paper strengthening agent to paper stock obtained by beating bleached kraft pulp and then diluting the beaten pulp to a concentration of 4% by mass such that the amounts of the sizing agent and paper strengthening agent are 0.1% by mass and 0.2% by mass respectively with respect to the mass of the paper stock and then adding aluminum sulfate thereto until the pH reaches 5.0. It is preferable to use alkaline paper having a pH of 7 to 8 in which a neutral sizing agent, such as an alkyl ketene dimer (AKD) or an alkenyl succinic anhydride (ASA), is used as a sizing agent and calcium carbonate is used as a filler instead of aluminum sulfate.

As the interleaving paper, among these, paper is preferable, paper containing aluminum sulfate or calcium

carbonate is more preferable, and paper containing calcium carbonate is particularly preferable.

The material of the interleaving paper is preferably paper containing 50% by mass or more of pulp, more preferably paper containing 70% by mass or more of pulp, and particularly preferably paper containing 80% by mass or more of pulp.

In the interleaving paper, the calcium content with respect to the total mass of the interleaving paper is preferably 0.15% by mass to 0.5% by mass, more preferably 0.2% by mass to 0.45% by mass, and particularly preferably 0.25% by mass to 0.4% by mass.

The calcium content of the interleaving paper is obtained by performing X-ray fluorescence spectrometry on the interleaving paper.

The calcium contained in paper is mainly calcium carbonate which is widely used as a filler for alkaline paper, and performs an action of increasing whiteness of the paper.

The basis weight of the interleaving paper (determined by measuring method specified in JIS P8124 (2011)) is not particularly limited, but is preferably 29 $g/m^2$ to 60 $g/m^2$, more preferably 35 $g/m^2$ to 55 $g/m^2$, and particularly preferably 40 $g/m^2$ to 50 $g/m^2$.

The thickness of the interleaving paper (determined by the measuring method specified in JIS P8118 (2014)) is not particularly limited, but is preferably 20 μm to 100 μm, more preferably 42 μm to 80 μm, even more preferably 45 μm to 65 μm, and particularly preferably 45 μm to 55 μm.

From the viewpoint of speck-like color defect suppressiveness, the moisture content of the interleaving paper (moisture content of the interleaving paper stored at 25°C/50%RH until the moisture content of the interleaving paper is stabilized) with respect to the total mass of the interleaving paper is preferably 0% by mass to 20% by mass, more preferably 0% by mass to 15% by mass, and particularly preferably 0% by mass to 10% by mass.

As the interleaving paper, among the interleaving paper described in JP2010-76336A, the interleaving paper having a pH of 5 or more can be suitably used.

The shape of the interleaving paper is not particularly limited, and examples thereof include a shape which is the same as or larger than the shape of the lithographic printing plate precursor in the plane direction.

[[Lithographic printing plate precursor]]

The laminate according to the present invention is a laminate of a lithographic printing plate precursor and interleaving paper, in which the lithographic printing plate precursor is an on-press development type lithographic printing plate precursor containing an acid color developing agent in at least any of layers.

The lithographic printing plate precursor preferably has a support and an image-recording layer, more preferably has a support, an image-recording layer, and an outermost layer in this order, and particularly preferably has a support, an undercoat layer, an image-recording layer, and a outermost layer in this order.

Furthermore, it is preferable that the lithographic printing plate precursor additionally have an outermost layer on the image-recording layer.

In the lithographic printing plate precursor, at least one of the image-recording layer or the outermost layer preferably contains the aforementioned acid color developing agent. It is more preferable that the image-recording layer contain the aforementioned acid color developing agent.

In a case where the lithographic printing plate precursor in the laminate is subjected to exposure to infrared at a wavelength of 830 nm at an energy density of 110 $mJ/cm^2$, a brightness change $\Delta L$ of an exposed portion of the lithographic printing plate precursor before and after the exposure is preferably 5.0 or more, more preferably 6.0 or more, even more preferably 8 or more, and particularly preferably 10 to 20.

In a case where the image-recording layer is subjected to exposure to an infrared laser having a wavelength of 830 nm at an energy density of 110 $mJ/cm^2$, the brightness change $\Delta L$ of the image-recording layer before and after the exposure is measured by the following method.

In Luxel PLATESETTER T-9800 manufactured by FUJIFILM Graphic Systems that is equipped with an infrared semiconductor laser with a wavelength of 830 nm, the lithographic printing plate precursor is exposed under the conditions of output of 99.5%, outer drum rotation speed of 220 rpm (revolutions per minute), and resolution of 2,400 dpi (dots per inch, 1 inch = 25.4 mm (energy density of 110 $mJ/cm^2$). The exposure is performed in an environment of 25°C and 50%RH.

The brightness change of the lithographic printing plate precursor before and after exposure is measured. The brightness change is measured using a spectrocolorimeter eXact manufactured by X-Rite, Incorporated. By using the L* value (brightness) in the L*a*b* color system, the absolute value of a difference between the L* value of the image-recording layer after the exposure and the L* value of the image-recording layer before the exposure is adopted as the brightness change $\Delta L$.

In the lithographic printing plate precursor, from the viewpoint of further exerting the effect of suppressing speck-like color defects, the maximum value of a molar absorption coefficient $\varepsilon$ that the color developing substance generated from the acid color developing agent has at 400 nm to 800 nm is preferably 10,000 to 200,000, more preferably 25,000 to

200,000, even more preferably 35,000 to 200,000, and particularly preferably 50,000 to 150,000.

The molar absorption coefficient ε of the color developing substance generated from the acid color developing agent is measured by the following method.

The acid color developing agent to be measured is weighed in 0.04 mmol and put in a 100 mL volumetric flask.

Acetic acid (about 90 mL) is added thereto. After it is visually confirmed that the measurement sample has completely dissolved, acetic acid is added thereto such that the volume increases up to 100 mL, thereby preparing a colorant solution A.

Acetic acid (about 80 mL) is added to another 100 mL volumetric flask, 5 mL of deionized water and 5 mL of the colorant solution A are then added thereto by using a 5 mL transfer pipette, and the solution is gently shaken.

After it is visually confirmed that the solution has no precipitate of the acid color developing agent, acetic acid is added thereto such that the volume increases up to 100 mL, thereby preparing a colorant solution B. In the colorant solution B, the concentration of the color developing substance precursor is 0.02 mmol/L.

A measurement cell (quartz glass, optical path width: 10 mm) is filled with the colorant solution B, and the solution is measured using an ultraviolet-visible spectrophotometer (UV-1800, manufactured by Shimadzu Corporation.).

As a blank, a solution of water:acetic acid = 5:95 is used.

From the obtained spectrum, the maximum absorption wavelength in the visible light region (380 nm to 750 nm) is read. From the absorbance at the wavelength, the molar absorption coefficient ε is calculated.

In a case where the image-recording layer is subjected to exposure to infrared at a wavelength of 830 nm at an energy density of 110 mJ/cm$^2$, from the viewpoint of visibility, a maximum absorption wavelength λmax of the image-recording layer in a wavelength range of 380 nm to 750 nm is preferably 400 nm to 650 nm, more preferably 500 nm to 650 nm, even more preferably 520 nm to 600 nm, particularly preferably 530 nm to 580 nm, and most preferably 540 nm to 570 nm.

In a case where the lithographic printing plate precursor is subjected to exposure to infrared at a wavelength of 830 nm at an energy density of 110 mJ/cm$^2$, the ratio of the aforementioned color developing substance to the total mass of the aforementioned acid color developing agent and the color developing substance generated from the acid color developing agent (ring-opening rate) is preferably 1 mol % to 100 mol%, more preferably 5 mol% to 100 mol%, even more preferably 15 mol% to 100 mol%, and particularly preferably 30 mol% or more and 99 mol% or less.

Ring-opening rate = molar absorption coefficient of acid color developing agent to which 1 molar equivalent of acid is added/molar absorption coefficient ε of acid color developing agent × 100

Herein, the ring-opening rate and λmax are measured by the following methods.

-Preparation of colorant solution C-

The color developing substance precursor is weighed (0.1 mmol) and put in a 50 mL volumetric flask.

Acetonitrile (about 40 mL) is added thereto. After it is visually confirmed that the measurement sample has completely dissolved, acetonitrile is added thereto such that the volume increases up to 50 mL, thereby preparing a colorant solution C.

-Preparation of acid solution D-

CSA (10-camphorsulfonic acid, 0.2 mmol) is added to a 100 mL volumetric flask, and about 80 mL of acetonitrile is added thereto. After it is confirmed that CSA has completely dissolved, acetonitrile is added thereto such that the volume increases up to 100 mL, thereby preparing an acid solution D.

-Preparation of measurement solution E-

Deionized water (5 mL) is added to a 100 mL volumetric flask by using a transfer pipette, and 80 mL of acetonitrile is added thereto. The colorant solution C (1 mL) and 1 mL of the acid solution D are added thereto such that the volume increases up to 100 mL, thereby preparing a measurement solution E.

In the measurement solution E, the concentration of the color developing substance precursor including the generated color developing substance is 0.02 mmol/L.

A measurement cell (quartz glass, optical path width: 10 mm) is filled with the colorant solution E, and the solution is measured using an ultraviolet-visible spectrophotometer (UV-1800, manufactured by Shimadzu Corporation.).

As a blank, a solution of water: acetonitrile = 5:95 is used.

From the obtained spectrum, the maximum absorption wavelength λmax in the visible light region (380 nm to 750 nm) is read. From the absorbance at the wavelength, the molar absorption coefficient ε is calculated.

The ring-opening rate is calculated according to the following equation.

Ring-opening rate = molar absorption coefficient of color developing substance precursor to which 1 molar equivalent of acid is added/molar absorption coefficient $\varepsilon$ of color developing substance precursor $\times$ 100

Hereinafter, each of the configuration requirements in the lithographic printing plate precursor will be specifically described.

<Image-recording layer>

The image-recording layer is preferably a negative tone image-recording layer and more preferably a water-soluble or water-dispersible negative tone image-recording layer.

In the lithographic printing plate precursor, from the viewpoint of on-press developability, a non-exposed portion of the image-recording layer is preferably removable by at least any of dampening water or printing ink.

It is preferable that the image-recording layer contain the aforementioned acid color developing agent.

The image-recording layer preferably contains an infrared absorber and an electron-accepting polymerization initiator, and more preferably contains an infrared absorber, an electron-accepting polymerization initiator, and an electron-donating polymerization initiator.

From the viewpoint of speck-like color defect suppressiveness and on-press developability, the image-recording layer preferably contains a polymerizable compound having a molecular weight of 2,500 or less. The content of the polymerizable compound having a molecular weight of 2,500 or less is more preferably 50% by mass or less with respect to the total mass of the image-recording layer.

From the viewpoint of speck-like color defect suppressiveness and on-press developability, the image-recording layer preferably contains a polymer having a weight-average molecular weight of 10,000 or more. The content of the polymer having a weight-average molecular weight of 10,000 or more is more preferably 10% by mass or more with respect to the total mass of the image-recording layer.

Hereinafter, each of the components to be incorporated into the image-recording layer will be specifically described.

[Acid color developing agent]

It is preferable that the image-recording layer contain an acid color developing agent. Furthermore, the acid color developing agent includes a leuco compound.

"Acid color developing agent" means a compound having a property of developing or removing color by being heated in a state of accepting an electron accepting compound (for example, a proton of an acid or the like) and thus changing the color of the image-recording layer. The acid color developing agent is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.

Examples of such an acid color developing agent include the compounds described in paragraphs "0184" to "0191" of JP2019-18412A.

Particularly, from the viewpoint of visibility, the acid color developing agent used in the present disclosure is preferably at least one kind of compound selected from the group consisting of a spiropyran compound, a spirooxazine compound, a spirolactone compound, and a spirolactam compound.

From the viewpoint of visibility, the color of a colorant after color development preferably has maximum absorption wavelength in the range of 450 to 650 nm. The tint is preferably red, purple, blue, or dark green.

From the viewpoint of visibility and visibility of exposed portions, the acid color developing agent is a leuco colorant.

The aforementioned leuco colorant is not particularly limited as long as it has a leuco structure. The leuco colorant preferably has a spiro structure, and more preferably has a spirolactone ring structure.

From the viewpoint of visibility and visibility of exposed portions, the leuco colorant is a leuco colorant having a phthalide structure or a fluoran structure.

Furthermore, from the viewpoint of visibility and visibility of exposed portions, the leuco colorant having a phthalide structure or a fluoran structure is a compound represented by any of Formula (Le-1) to Formula (Le-3), and more preferably a compound represented by Formula (Le-2).

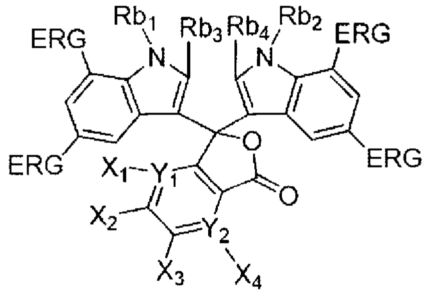

( Le - 1 )

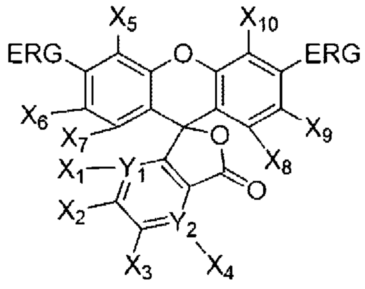

( Le - 2 )

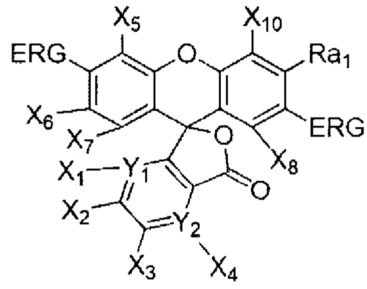

( Le - 3 )

In Formula (Le-1) to Formula (Le-3), ERG each independently represent an electron-donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group.

As the electron-donating groups represented by ERG in Formula (Le-1) to Formula (Le-3), from the viewpoint of visibility and visibility of exposed portions, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable an arylamino group, a monoalkyl monoarylamino group, or a diarylamino group is even more preferable, and an arylamino group or a monoalkyl monoarylamino group is particularly preferable.

From the viewpoint of visibility and visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of visibility and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxy group, an alkoxy group, an aryloxy group, an acyl group, an alkoxycarbonyl group, an aryloxycarbonyl group, or a cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of visibility and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoint of visibility and visibility of exposed portions, $Ra_1$ in Formula (Le-3) is preferably an alkyl group or an alkoxy group, more preferably an alkoxy group, and particularly preferably a methoxy group.

From the viewpoint of visibility and visibility of exposed portions, $Rb_1$ to $Rb_4$ in Formula (Le-1) preferably each independently represent a hydrogen atom or an alkyl group, more preferably each independently represent an alkyl group, and particularly preferably each independently represent a methyl group.

From the viewpoint of visibility and visibility of exposed portions, the leuco colorant having a phthalide structure or a fluoran structure is more preferably a compound represented by any of Formula (Le-4) to Formula (Le-6), and even more preferably a compound represented by Formula (Le-5).

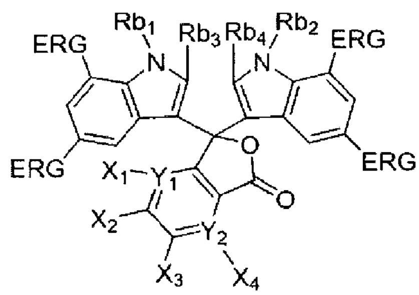

( Le - 4 )

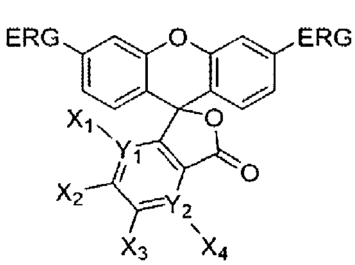

( Le - 5 )

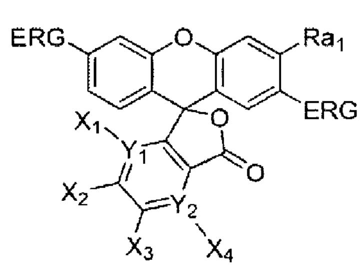

( Le - 6 )

In Formula (Le-4) to Formula (Le-6), ERG each independently represent an electron-donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

From the viewpoint of visibility and visibility of exposed portions, the leuco colorant having a phthalide structure or a fluoran structure is more preferably a compound represented by any of Formula (Le-7) to Formula (Le-9), and particularly preferably a compound represented by Formula (Le-8).

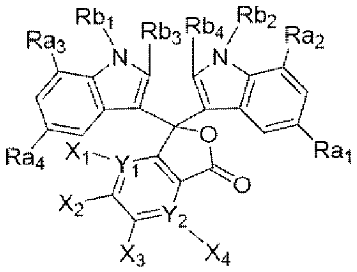

(Le - 7)

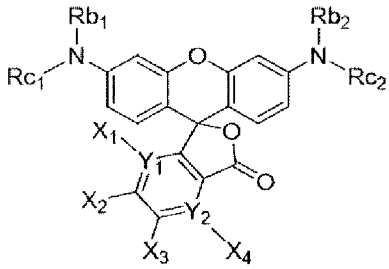

(Le - 8)

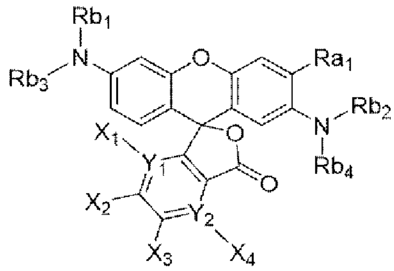

(Le - 9)

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where Yi is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent a hydrogen atom, an alkyl group, or an aryl group, and $Rc_1$ and $Rc_2$ each independently represent an aryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoint of visibility and visibility of exposed portions, $Ra_1$ to $Ra_4$ in Formula (Le-7) preferably each independently represent an alkyl group or an alkoxy group, more preferably each independently represent an alkoxy group, and particularly preferably each independently represent a methoxy group.

From the viewpoint of visibility and visibility of exposed portions, $Rb_1$ to $Rb_4$ in Formula (Le-7) to Formula (Le-9) preferably each independently represent a hydrogen atom, an alkyl group, or an aryl group substituted with an alkyl group or alkoxy group, more preferably each independently represent a hydrogen atom or an alkyl group, and particularly preferably each independently represent a hydrogen atom or a methyl group.

From the viewpoint of visibility and visibility of exposed portions, $Rc_1$ and $Rc_2$ in Formula (Le-8) preferably each independently represent a phenyl group or an alkylphenyl group, and more preferably each independently represent a phenyl group.

In Formula (Le-8), from the viewpoint of visibility and visibility of exposed portions, $X_1$ to $X_4$ preferably each represent a hydrogen atom, and $Y_1$ and $Y_2$ preferably each represent C.

From the viewpoint of visibility and visibility of exposed portions, $Rb_1$ and $Rb_2$ in Formula (Le-8) preferably each independently represent a hydrogen atom, an alkyl group, or an aryl group substituted with an alkyl group or an alkoxy group, more preferably each independently represent a hydrogen atom or an alkyl group.

From the viewpoint of color developability and visibility of exposed portions, the acid color developing agent preferably includes a compound represented by Formula (Le-10).

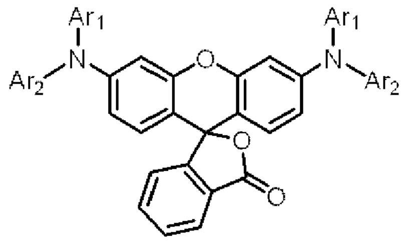

( Le - 10 )

In Formula (Le-10), $Ar_1$ each independently represents an aryl group or a heteroaryl group, and $Ar_2$ each independently represents an aryl group having a substituent at at least one ortho position or a heteroaryl group having a substituent at at least one ortho position.

$Ar_1$ in Formula (Le-10) has the same definition as $Rb_1$ and $Rb_2$ in Formula (Le-7) to Formula (Le-9), and preferred aspects thereof are also the same.

$Ar_2$ in Formula (Le-10) has the same definition as $Rc_1$ and $Rc_2$ in Formula (Le-7) to Formula (Le-9), and preferred aspects thereof are also the same.

The alkyl group in Formula (Le-1) to Formula (Le-9) may be linear or branched or may have a ring structure.

The number of carbon atoms in the alkyl group in Formula (Le-1) to Formula (Le-9) is preferably 1 to 20, more preferably 1 to 8, even more preferably 1 to 4, and particularly preferably 1 or 2.

The number of carbon atoms in the aryl group in Formula (Le-1) to Formula (Le-10) is preferably 6 to 20, more preferably 6 to 10, and particularly preferably 6 to 8.

Specific examples of the aryl group in Formula (Le-1) to Formula (Le-10) include a phenyl group, a naphthyl group, an anthracenyl group, a phenanthrenyl group, and the like which may have a substituent.

Specific examples of the heteroaryl group in Formula (Le-1) to Formula (Le-10) include a furyl group, a pyridyl group, a pyrimidyl group, a pyrazoyl group, a thiophenyl group, and the like which may have a substituent.

Each of the groups in Formula (Le-1) to Formula (Le-10), such as a monovalent organic group, an alkyl group, an aryl group, a heteroaryl group, a dialkylanilino group, an alkylamino group, and an alkoxy group, may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, a cyano group, and the like. These substituents may be further substituted with these substituents.

In the invention, the acid color developing agent comprises a compound represented by any one of Formulae (Le-1) to (Le-3) or the compound CL-5. Examples of the leuco colorant having the phthalide structure or the fluoran structure that are suitably used are included in the following compounds.

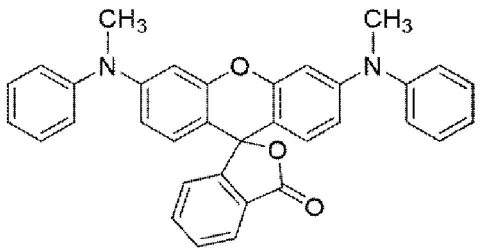

S - 1

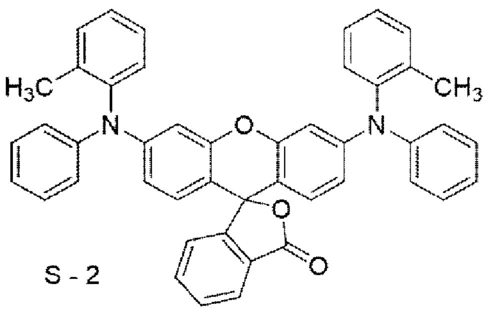

S - 2

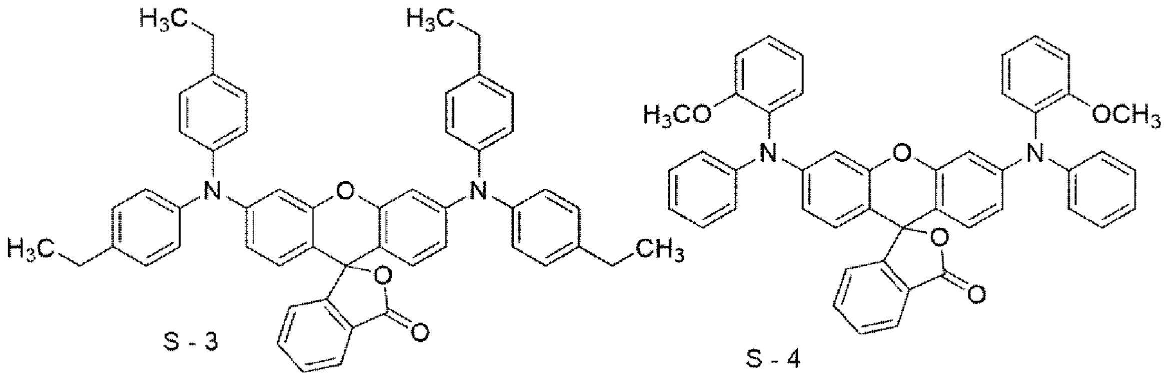

S - 3

S - 4

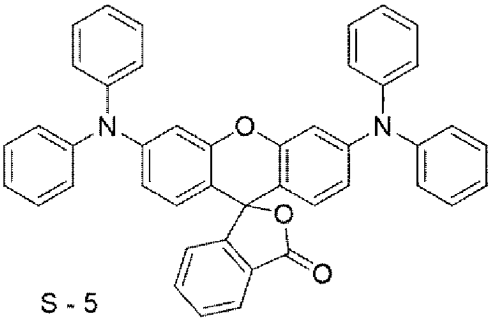

S - 5

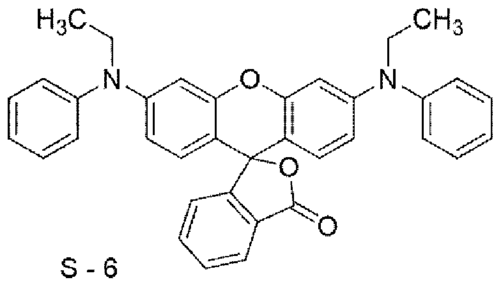

S - 6

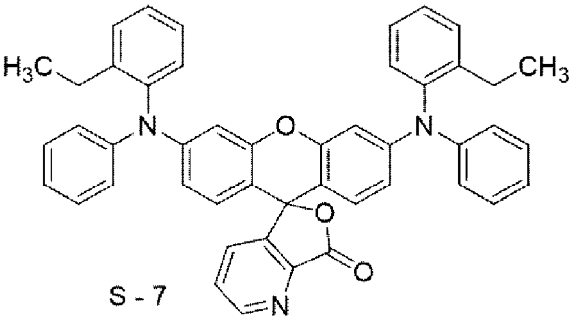

S - 7

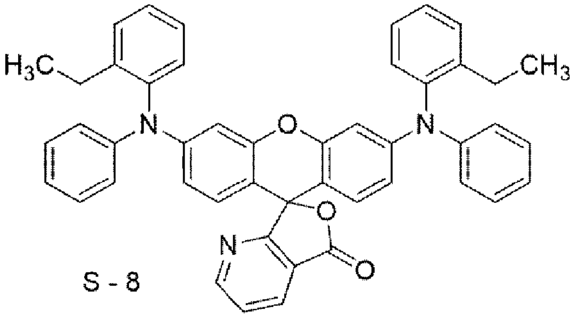

S - 8

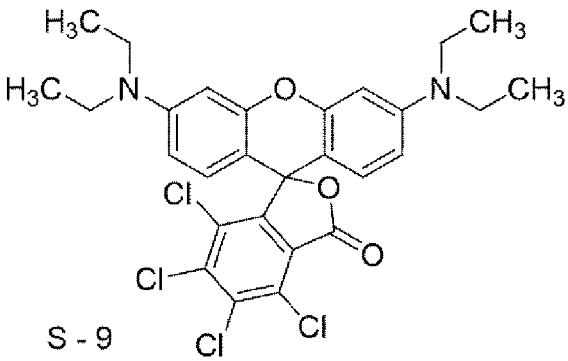

S - 9

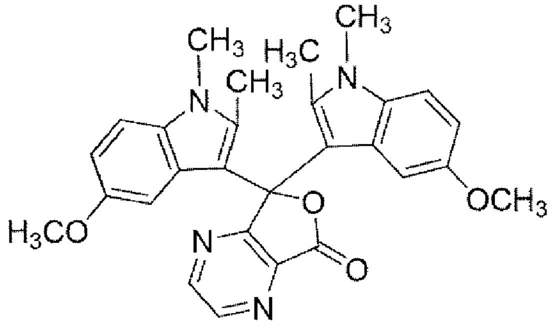

S - 10

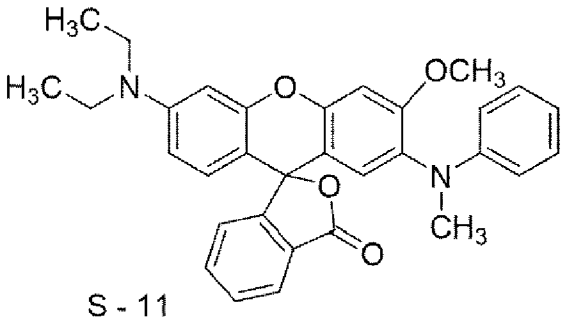

S - 11

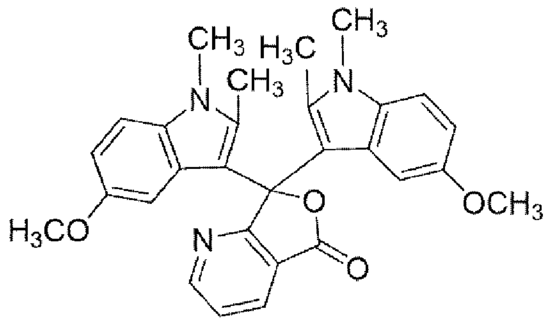

S - 12

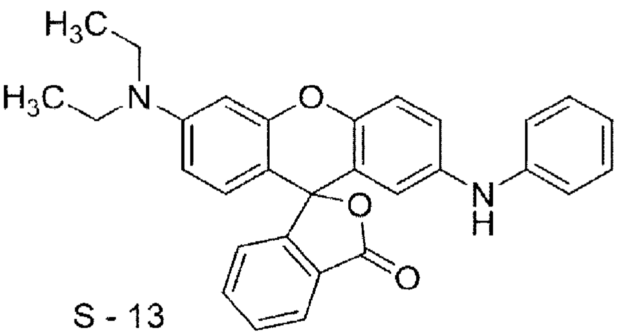

S - 13

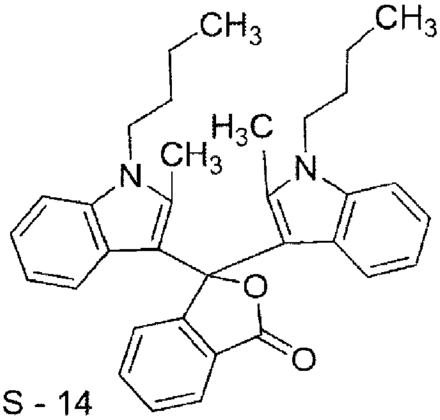

S - 14

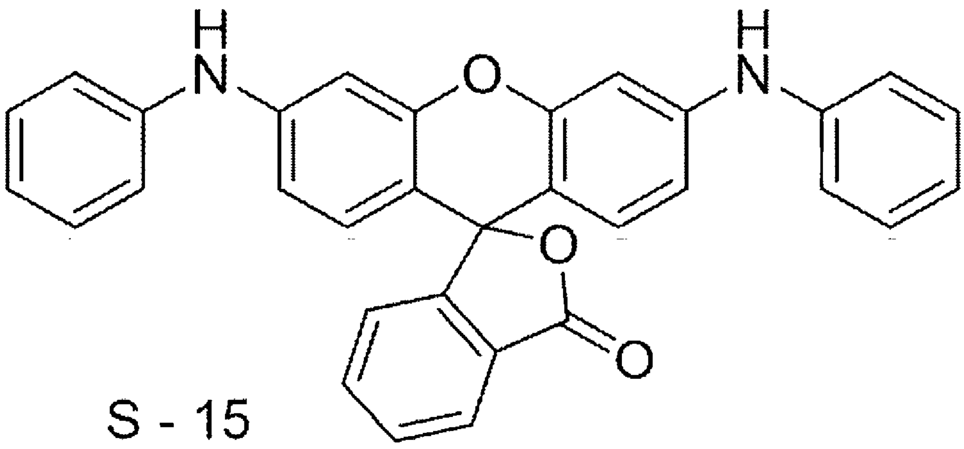

S - 15

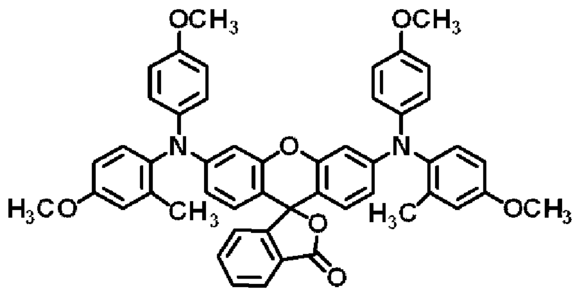

S - 16

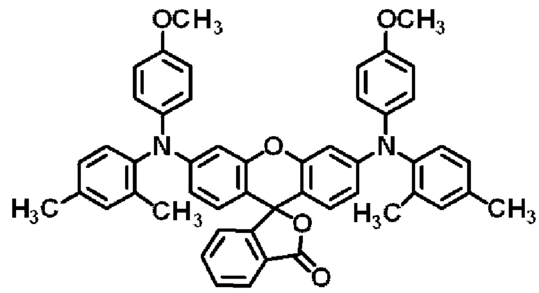

S - 17

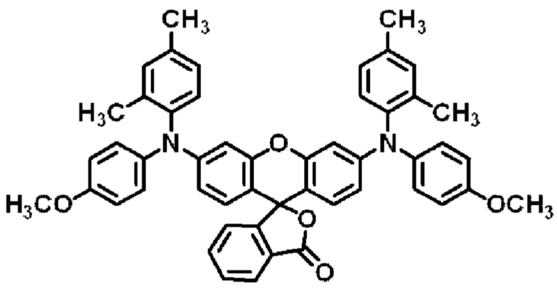

S - 18

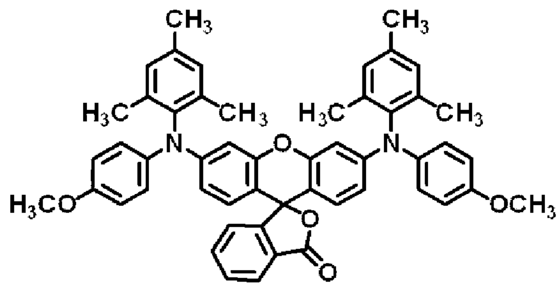

S - 19

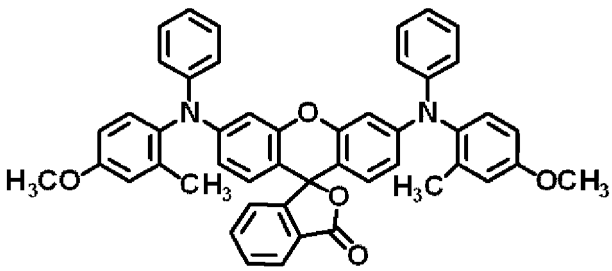

S - 20

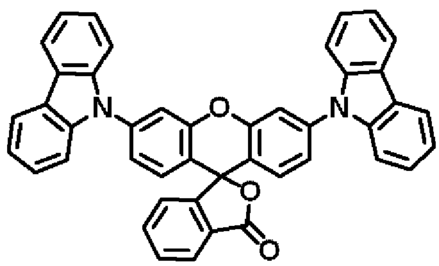

S - 21

As the acid color developing agent, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

Herein, the viewpoint of visibility and visibility of exposed portions, examples of suitably used a leuco colorant include the following compounds. The acid color developing agent comprises a compound represented by CL-5.

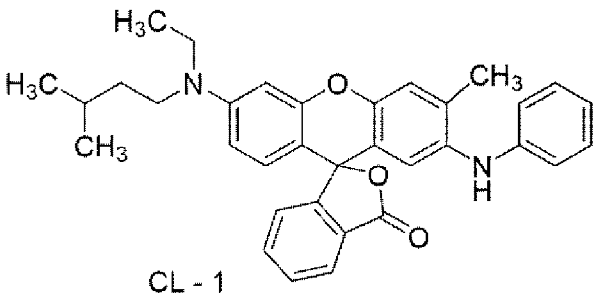

CL - 1

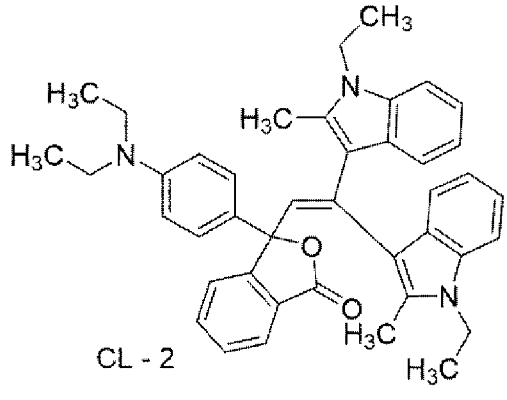

CL - 2

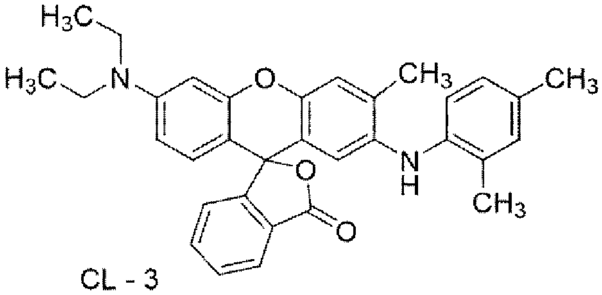

CL - 3

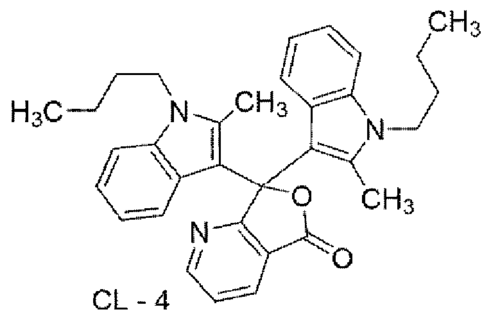

CL - 4

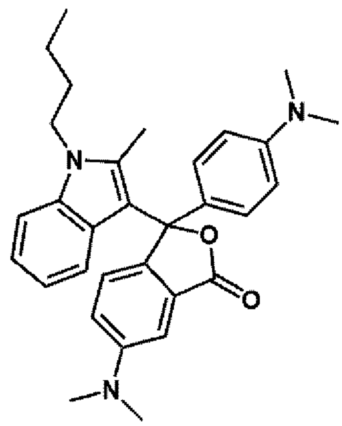

CL - 5

One kind of each of these color developing agents may be used alone. Alternatively, two or more kinds of components can be used in combination.

The content of the color developing agent with respect to the total mass of the image-recording layer is preferably 0.5% by mass to 10% by mass, and more preferably 1% by mass to 5% by mass.

[Infrared absorber]

It is preferable that the image-recording layer contain an infrared absorber.

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine dye, a squarylium colorant, a pyrylium salt, a nickel thiolate complex,

and an indolenine cyanine dye are preferable, and a cyanine dye or an indolenine cyanine dye is more preferable. Among these, a cyanine dye is particularly preferable.

The aforementioned infrared absorber is preferably a cationic polymethine colorant having an oxygen atom, a nitrogen atom, or a halogen atom at the meso-position. Preferred examples of the cationic polymethine colorant include a cyanine dye, a pyrylium colorant, a thiopyrylium colorant, an azulenium colorant, and the like. From the viewpoint of ease of availability, solubility in a solvent during an introduction reaction, and the like, a cyanine dye is preferable.

Specific examples of the cyanine dye include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" and" 0076" of JP2008-195018A are preferable.

In addition, as the aforementioned infrared absorber, a decomposable compound that decomposes due to exposure to infrared, which will be described later as a discoloring compound of the outermost layer, is also suitably used.

From the viewpoint of printing durability and visibility, the highest occupied molecular orbital (HOMO) of the infrared absorber is preferably -5.250 eV or less, more preferably -5.30 eV or less, even more preferably -5.80 eV or more and -5.35 eV or less, and particularly preferably -5.65 eV or more and -5.40 eV or less.

From the viewpoint of temporal stability, sensitivity improvement, and UV printing durability, the lowest unoccupied molecular orbital (LUMO) of the infrared absorber is preferably less than -3.70 eV, more preferably less than -3.80 eV, even more preferably -4.20 eV or more and less than -3.80 eV, and particularly preferably -4.00 eV or more and less than -3.80 eV.

One kind of infrared absorber may be used alone, or two or more kinds of infrared absorbers may be used in combination.

In addition, as the infrared absorber, a pigment and a dye may be used in combination.

The content of the infrared absorber with respect to the total mass of the image-recording layer is preferably 0.1% by mass to 10.0% by mass, and more preferably 0.5% by mass to 5.0% by mass.

[Electron-accepting polymerization initiator]

The image-recording layer preferably contains an electron-accepting polymerization initiator.

The electron-accepting polymerization initiator is a compound which accepts an electron by intermolecular electron migration in a case where electrons of an infrared absorber are excited by exposure to infrared, and generates a polymerization initiation species such as radicals.

The electron-accepting polymerization initiator is a compound that generates a polymerization initiation species such as a radical or a cation by either or both of light energy and heat energy, and can be appropriately selected from known thermal polymerization initiators, compounds having a bond that requires low bond dissociation energy, photopolymerization initiators, and the like.

The electron-accepting polymerization initiator is preferably a radical polymerization initiator and more preferably an onium salt compound.

In addition, as the electron-accepting polymerization initiator, an infrared-ray-sensitive polymerization initiator is preferable.

From the viewpoint of temporal stability, UV plate missing suppressiveness, sensitivity improvement, and UV printing durability, the electron-accepting polymerization initiator is preferably an iodonium salt compound or a compound having an alkyl halide group, and more preferably a compound having an alkyl halide group.

In addition, from the viewpoint of temporal stability, UV plate missing suppressiveness, GLV suitability, sensitivity improvement, and UV printing durability, the compound having an alkyl halide group is preferably a compound having a perhalogenoalkylsulfonyl group, more preferably a compound having a trihalogenomethylsulfonyl group, and particularly preferably a compound having a tribromomethylsulfonyl group.

Among the above electron-accepting polymerization initiators, from the viewpoint of curing properties, an oxime ester compound and an onium salt compound are preferable. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds will be shown below, but is not limited thereto.

As the iodonium salt compound, for example, a diaryliodonium salt compound is preferable. Particularly, a diphenyl iodonium salt compound substituted with an electron-donating group such as an alkyl group or an alkoxyl group is

more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=-hexafluorophosphate, and bis(4-t-butylphenyl)iodonium=hexafluorophosphate.

Examples of counteranions of the iodonium salt compound and the sulfonium salt compound include a sulfonate anion, a carboxylate anion, a tetrafluoroborate anion, a hexafluorophosphate anion, a p-toluene sulfonate anion, a tosylate anion, a sulfonamide anion, and a sulfonimide anion.

Among the above, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specific examples of the sulfonamide anion and the sulfonimide anion include those described in WO2019/013268A.

From the viewpoint of temporal visibility after exposure, developability, and UV printing durability of the lithographic printing plate to be obtained, the aforementioned electron-accepting polymerization initiator preferably includes a compound represented by Formula (II) or Formula (III), and particularly preferably includes a compound represented by Formula (II).

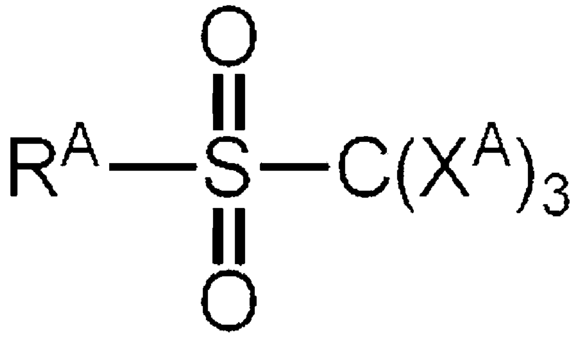

( II )

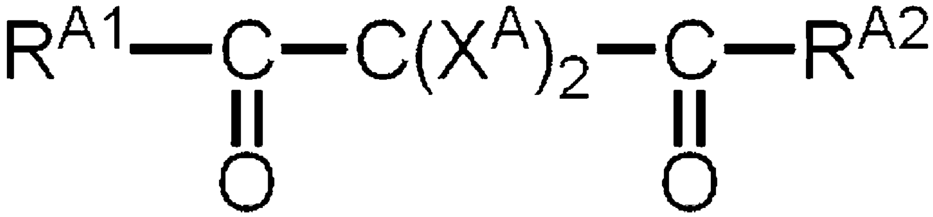

( III )

In Formula (II) and Formula (III), $X^A$ represents a halogen atom, and $R^A$, $R^{A1}$, and $R^{A2}$ each independently represent a monovalent hydrocarbon group having 1 to 20 carbon atoms.

$R^A$ in Formula (II) is preferably an aryl group.

Examples of $X^A$ in Formula (II) and Formula (III) include a fluorine atom, a chlorine atom, a bromine atom, and an iodine atom. Among these, a chlorine atom or a bromine atom is preferable because these have excellent sensitivity, and a bromine atom is particularly preferable.

$R^A$, $R^{A1}$, and $R^{A2}$ in Formula (II) and Formula (III) preferably each independently represent an aryl group. Particularly, from the viewpoint of excellent balance between sensitivity and storage stability, $R^A$, $R^{A1}$, and $R^{A2}$ more preferably each independently represent an aryl group substituted with an amide group.

The aforementioned electron-accepting polymerization initiator particularly preferably includes a compound represented by Formula (IV).

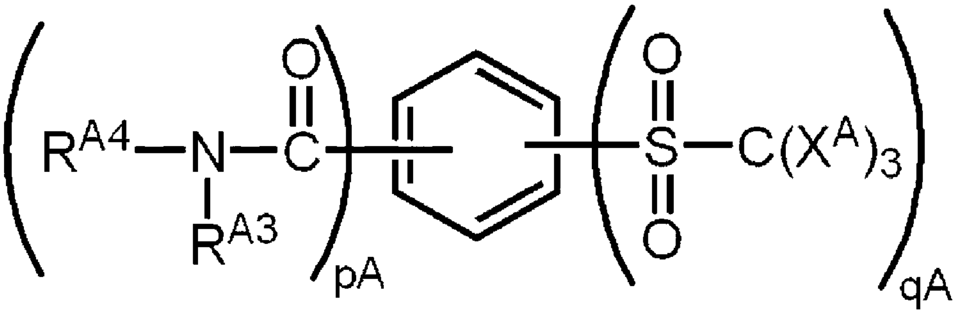

( IV )

In Formula (IV), $X^A$ represents a halogen atom, $R^{A3}$ and $R^{A4}$ each independently represent a hydrogen atom or a monovalent hydrocarbon group having 1 to 20 carbon atoms, and pA and qA each independently represent an integer of 1 to 5. Here, pA + qA = 2 to 6.

Specific examples of the electron-accepting polymerization initiator include compounds represented by the following formulas, however, is not limited thereto.

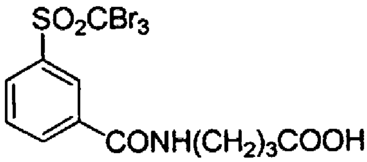
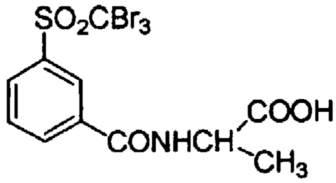
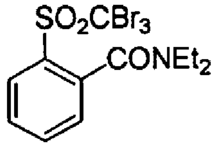

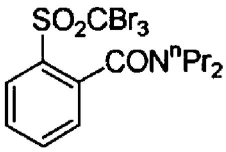
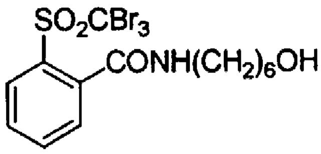
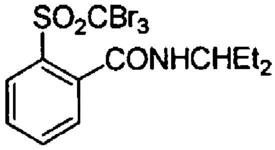

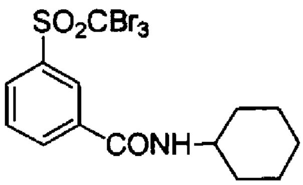
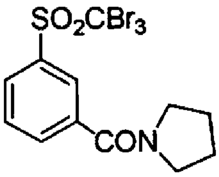
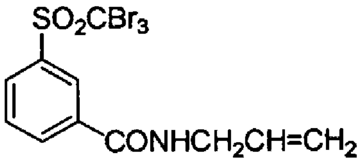

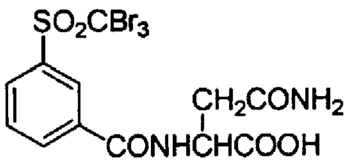
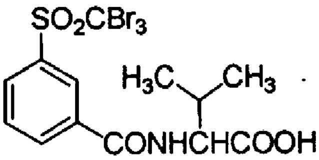
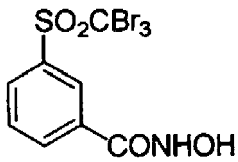

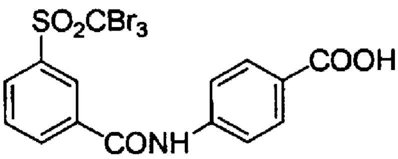
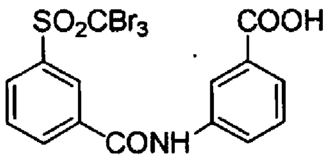
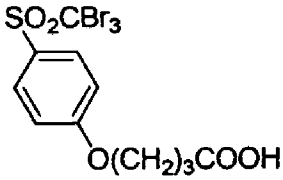

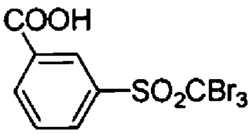
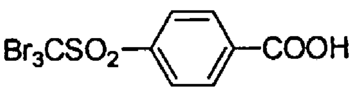
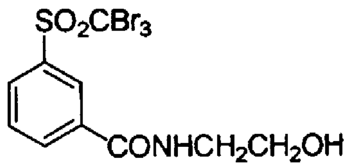

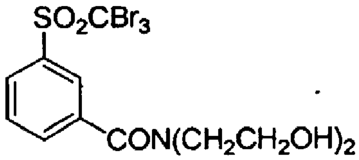 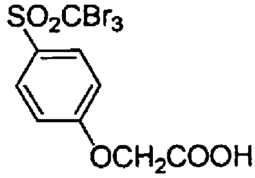 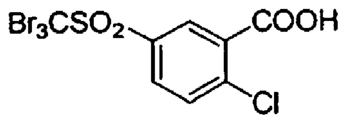

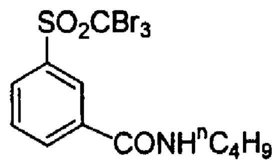 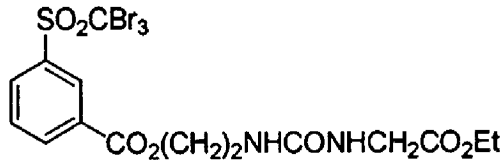

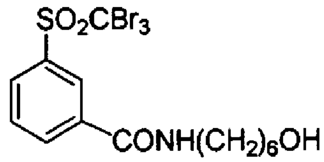 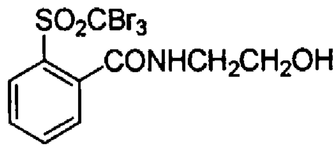

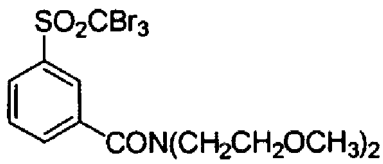 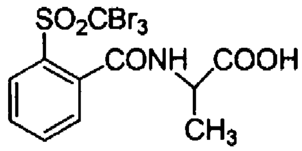

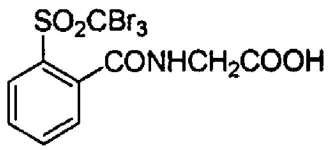 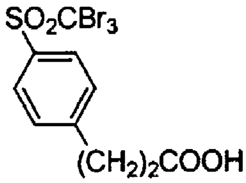 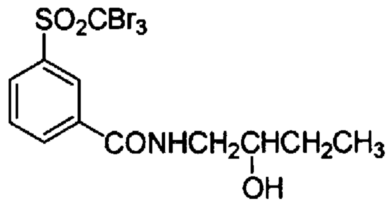

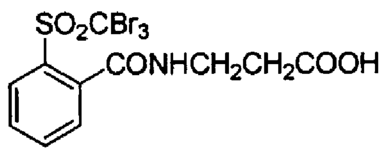 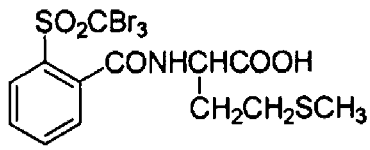

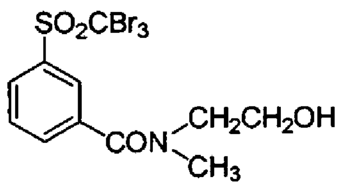 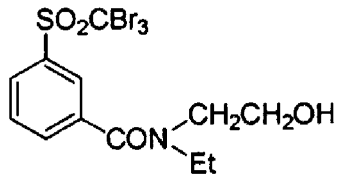 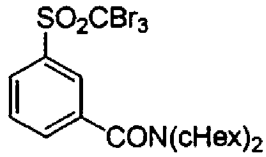

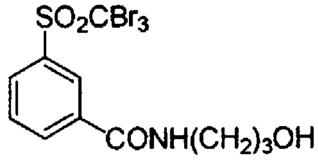 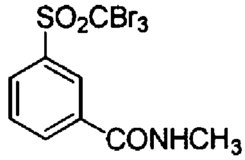 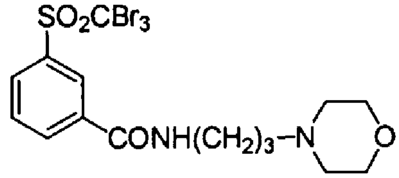

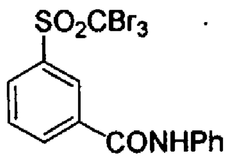
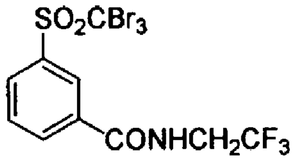
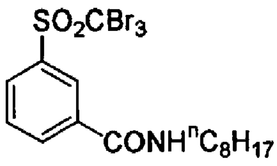

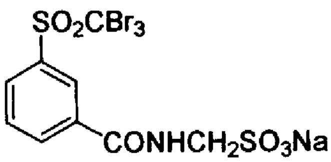
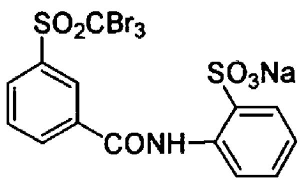
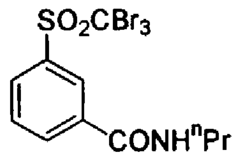

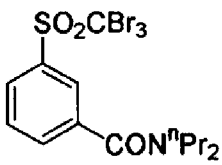
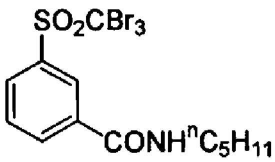
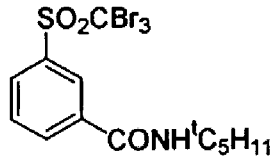

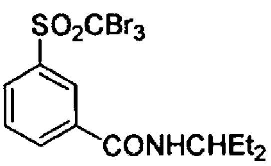
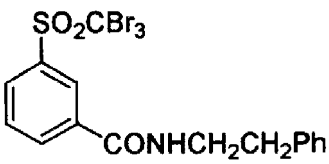
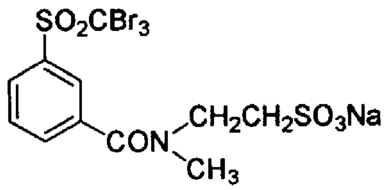

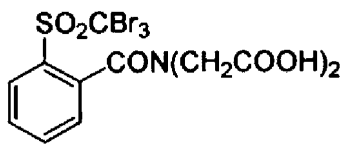
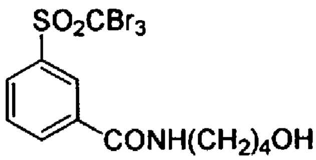

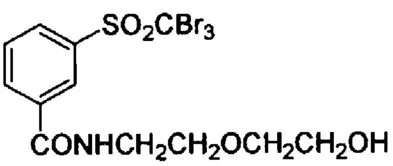
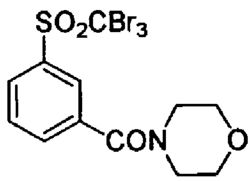
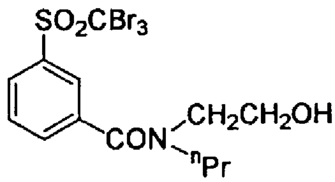

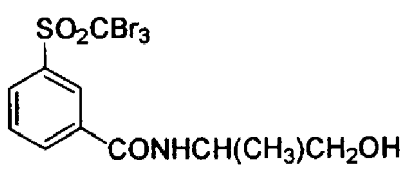
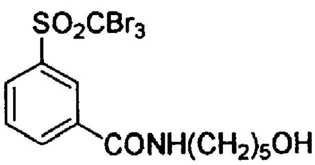

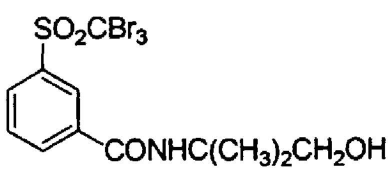
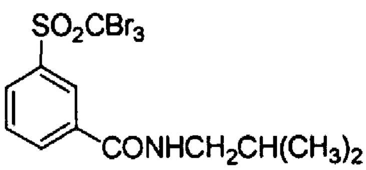

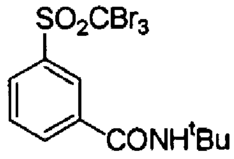
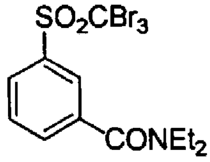
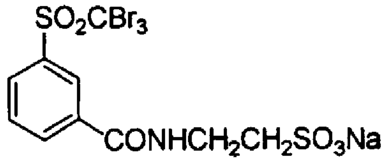

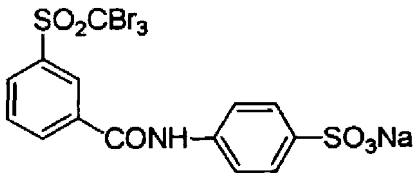
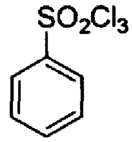
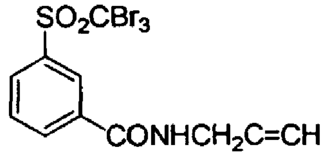

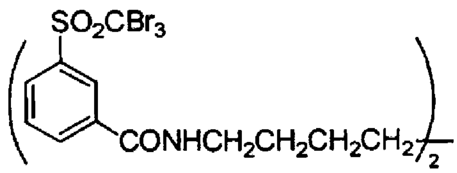
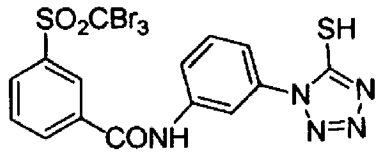

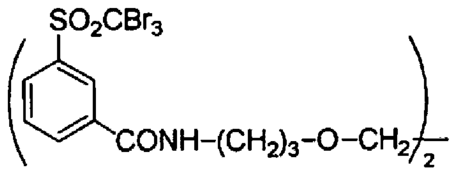
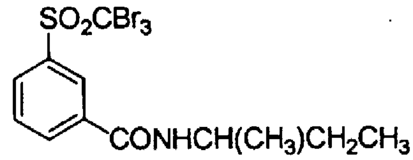

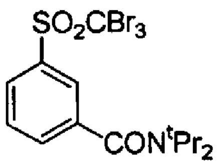
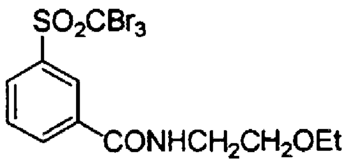
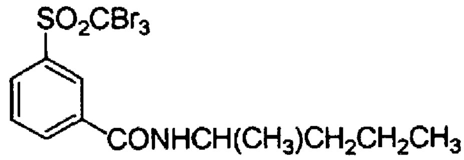

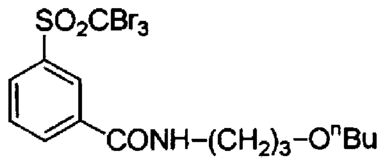
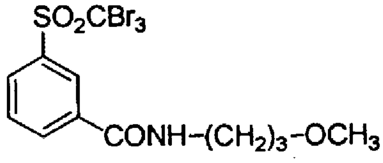

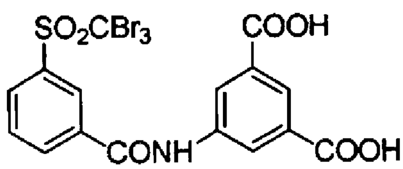
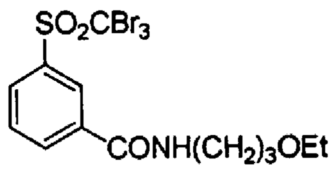

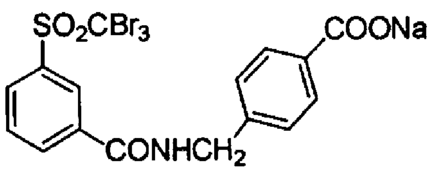
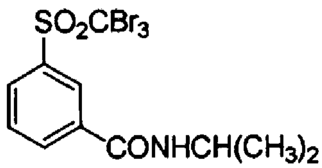

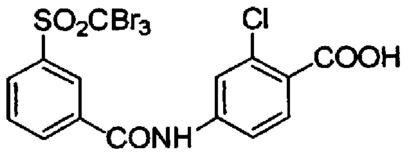
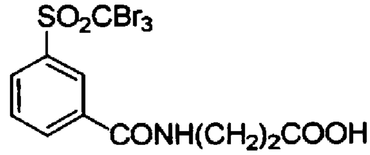

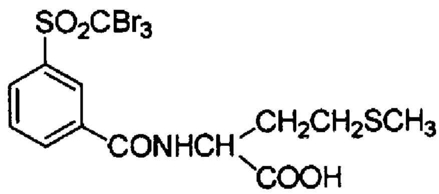
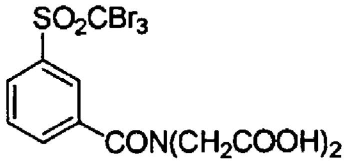

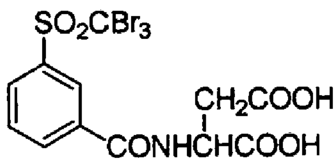
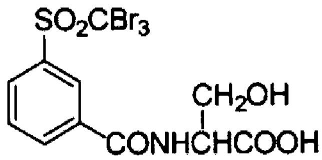
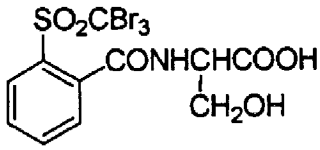

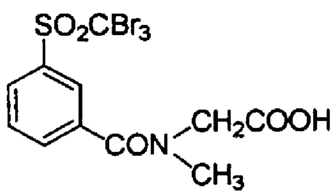
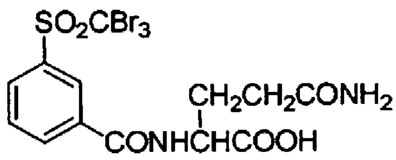
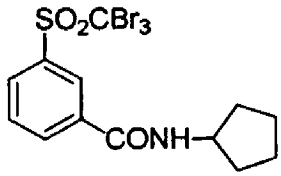

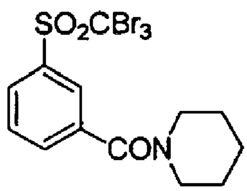
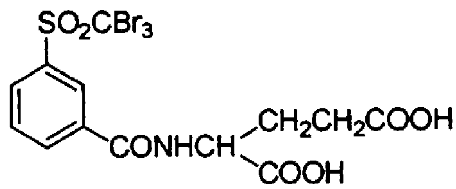

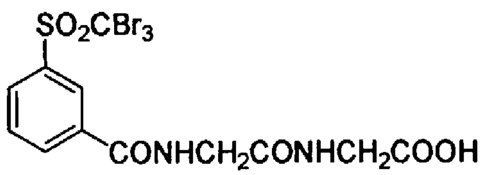
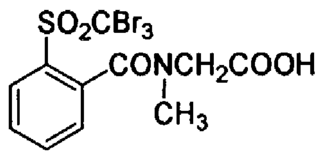

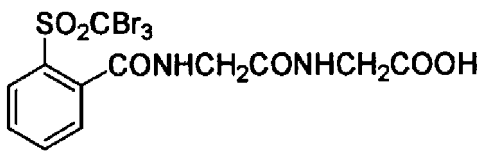
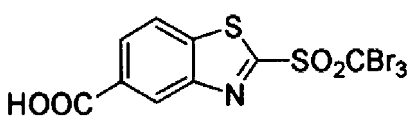

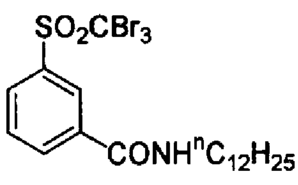
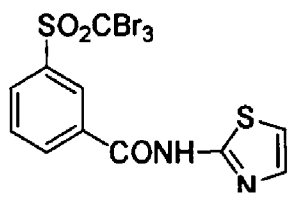
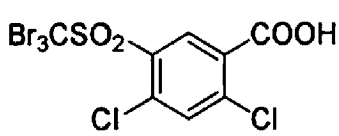

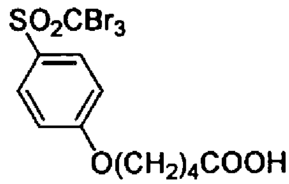

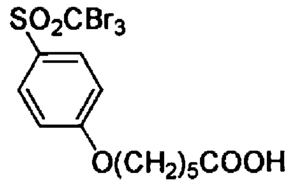

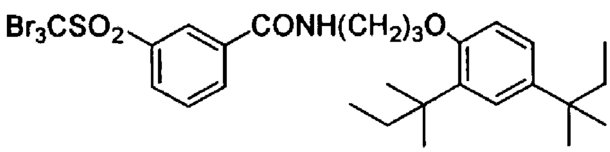

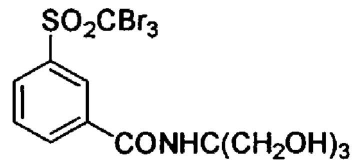

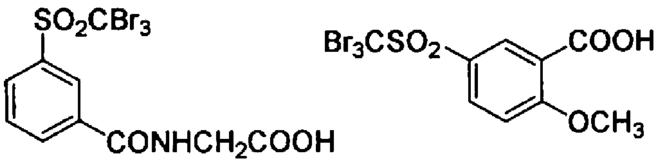

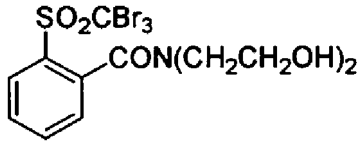

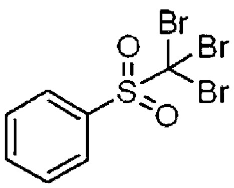

(IS-1)

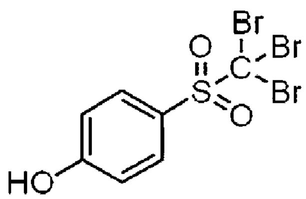

(IS-2)

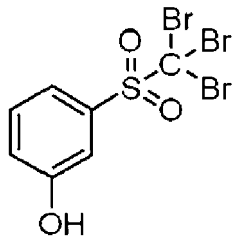

(IS-3)

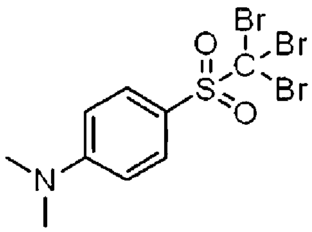

(IS-4)

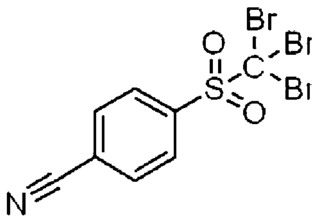

(IS-5)

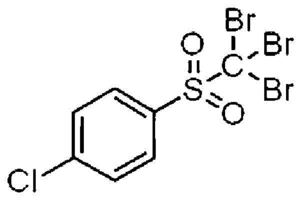

(IS-6)

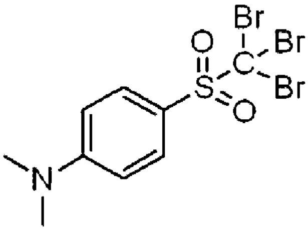

(IS-7)

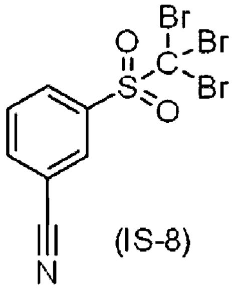

(IS-8)

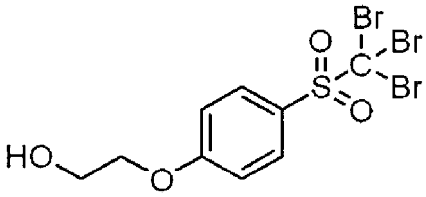

(IS-9)

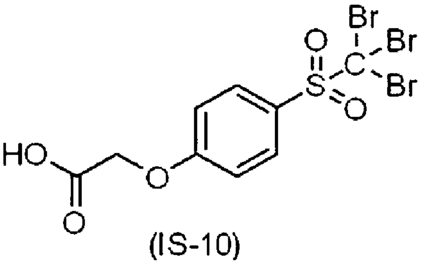

(IS-10)

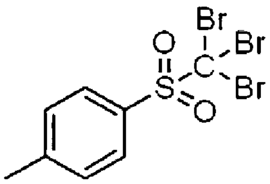

(IS-11)

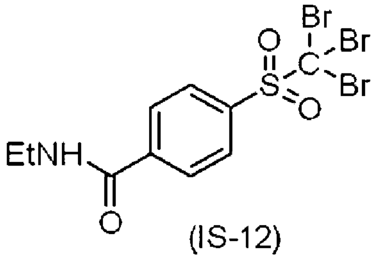

(IS-12)

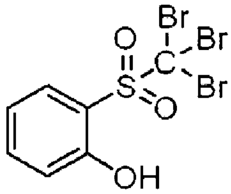

(IS-13)

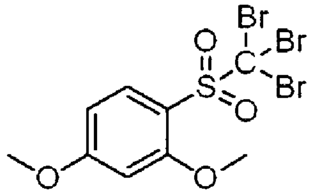

(IS-14)

From the viewpoint of temporal stability, UV plate missing suppressiveness, GLV suitability, and UV printing durability, the lowest unoccupied molecular orbital (LUMO) of the electron-accepting polymerization initiator is preferably more than -3.3 eV, and more preferably more than -3.2 eV.

From the viewpoint of improving sensitivity and making it difficult for plate missing to occur, the upper limit of LUMO is preferably -3.00 eV or less, and more preferably -3.02 eV or less.

One kind of electron-accepting polymerization initiator may be used alone, or two or more kinds of electron-accepting polymerization initiators may be used in combination.

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

[Electron-donating polymerization initiator (polymerization aid)]

It is preferable that the image-recording layer contain an electron-donating polymerization initiator (also called "polymerization aid") as a polymerization initiator.

The electron-donating polymerization initiator is a compound which donates one electron by intermolecular electron migration to an orbit of an infrared absorber that has lost one electron in a case where electrons of the infrared absorber are excited or perform intramolecular migration by exposure to infrared, and thus generates polymerization initiation species such as radicals.

The electron-donating polymerization initiator is preferably an electron-donating radical polymerization initiator.

From the viewpoint of printing durability, the image-recording layer preferably contains a borate compound.

From the viewpoint of printing durability and visibility, the borate compound is preferably a tetraaryl borate compound or a monoalkyl triaryl borate compound, and more preferably a tetraaryl borate compound.

From the viewpoint of UV plate missing suppressiveness, printing durability, and visibility, the borate compound is preferably a tetraaryl borate compound having one or more electron-donating groups, and more preferably a tetraaryl borate compound having one electron-donating group in each aryl group.

From the viewpoint of UV plate missing suppressiveness, printing durability, and visibility, the aforementioned electron-donating group is preferably an alkyl group or an alkoxy group, and more preferably an alkoxy group.

A countercation that the borate compound has is not particularly limited, but is preferably an alkali metal ion or a tetraalkyl ammonium ion and more preferably a sodium ion, a potassium ion, or a tetrabutylammonium ion.

The countercation that the borate compound has may also be a cationic polymethine colorant in the infrared absorber described in the present specification. For example, the aforementioned borate compound may be used as the countercation of the cyanine dye.

Specifically, preferred examples of the borate compound include sodium tetraphenyl borate.

Specifically, as the electron-donating polymerization initiator, for example, the B-1 to B-9 are preferable. It goes without saying that it is not limited thereto. In the following chemical formulas, Ph represents a phenyl group, and Bu represents a n-butyl group.

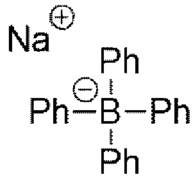

B - 1

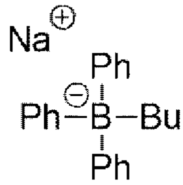

B - 2

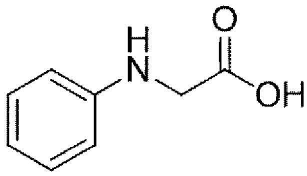

B - 3

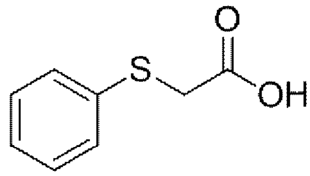

B - 4

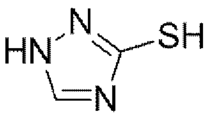

B - 5

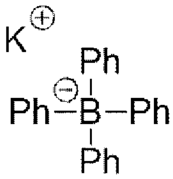

B - 6

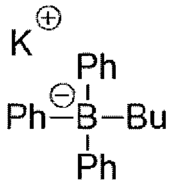

B - 7

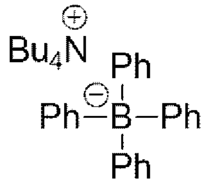

B - 8

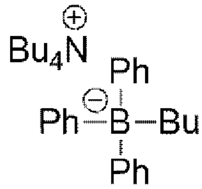

B - 9

From the viewpoint of improving sensitivity and making it difficult for plate missing to occur, the highest occupied molecular orbital (HOMO) of the electron-donating polymerization initiator is preferably -6.00 eV or more, more preferably -5.95 eV or more, even more preferably -5.93 eV or more, and particularly preferably more than -5.90 eV.

The upper limit of HOMO is preferably -5.00 eV or less, and more preferably -5.40 eV or less.

Only one kind of electron-donating polymerization initiator may be used alone, or more kinds of electron-donating polymerization initiators may be used in combination.

From the viewpoint of sensitivity and printing durability, the content of the electron-donating polymerization initiator with respect to the total mass of the image-recording layer is preferably 0.01% by mass to 30% by mass, more preferably 0.05% by mass to 25% by mass, and even more preferably 0.1% by mass to 20% by mass.

The polymerization initiator may be a compound in the form of a conjugate salt of an electron-donating polymerization initiator and an electron-accepting polymerization initiator, and preferably includes, as the electron-accepting polymerization initiator and the electron-donating polymerization initiator, a compound in the form of a salt composed of a cation having the structure of an electron-accepting polymerization initiator and an anion having the structure of an electron-donating polymerization initiator. Examples of the cation having the structure of an electron-accepting polymerization initiator include oniums in the onium compound described above. Examples of the cation having the structure of an electron-donating polymerization initiator include borate in the borate compound described above.

For example, the polymerization initiator is preferably a compound in the form of a conjugate salt of an anion in the electron-donating polymerization initiator and a cation in the electron-accepting polymerization initiator, more preferably a compound in the form of a conjugate salt of an onium cation and a borate anion, even more preferably a compound in the form of a conjugate salt of an iodonium cation or sulfonium cation and a borate anion, and particularly preferably a compound in the form of a conjugate salt of a diaryliodonium cation or a triarylsulfonium cation and a tetraarylborate anion.

Preferred aspects of the anion in the electron-donating polymerization initiator and the cation in the electron-accepting polymerization initiator are the same as the preferred aspects of the anion in the aforementioned electron-donating polymerization initiator and the cation in the aforementioned electron-accepting polymerization initiator.

In a case where the image-recording layer contains an anion as an electron-donating polymerization initiator and a cation as an electron-accepting polymerization initiator (that is, in a case where the image-recording layer contains a compound in the form of a conjugate salt described above), the image-recording layer is regarded as containing an electron-accepting polymerization initiator and an electron-donating polymerization initiator.

The compound in the form of a conjugate salt of an electron-donating polymerization initiator and an electron-accepting polymerization initiator may be used as an electron-donating polymerization initiator or an electron-accepting polymerization initiator.

The compound in the form of a conjugate salt of an electron-donating polymerization initiator and an electron-accepting polymerization initiator may be used in combination with the aforementioned electron-donating polymerization initiator or used in combination with the aforementioned electron-accepting polymerization initiator.

[Relationship between infrared absorber and electron-donating polymerization initiator]

In the image-recording layer, from the viewpoint of UV plate missing suppressiveness and printing durability, HOMO of the infrared absorber - HOMO of the electron-donating polymerization initiator is preferably 0.70 eV or less, more

preferably 0.60 eV or less, even more preferably 0.55 eV or less, particularly preferably 0.50 eV or less, and most preferably 0.50 eV to -0.10 eV.

The negative sign means that HOMO of the electron-donating polymerization initiator is higher than HOMO of the infrared absorber.

[Relationship between electron-accepting polymerization initiator and infrared absorber]

In the image-recording layer, from the viewpoint of sensitivity improvement and printing durability, LUMO of the electron-accepting polymerization initiator - LUMO of the infrared absorber is preferably 1.00 eV or less, more preferably 0.80 eV or less, even more preferably 0.70 eV or less, particularly preferably 0.70 eV to -0.10 eV, and most preferably 0.70 eV to 0.30 eV.

The negative sign means that LUMO of the infrared absorber is higher than LUMO of the electron-accepting polymerization initiator.

The highest occupied molecular orbital (HOMO) and the lowest unoccupied molecular orbital (LUMO) are calculated by the following methods.

First, free counterions in the compound as a calculation object are excluded from the calculation object. For example, for a cationic electron-accepting polymerization initiator and a cationic infrared absorber, counteranions are excluded from the calculation object, and for an anionic electron-donating polymerization initiator, countercations are excluded from the calculation object. "Free" mentioned herein means that the compound as an object and the counterions thereof are not covalently linked to each other.

The structural optimization is carried out by DFT (B3LYP/6-31G(d)) using quantum chemical calculation software Gaussian 09.

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above MO energy calculation is converted into Escaled (unit: eV) used as the values of HOMO and LUMO.

$$\text{Escaled} = 0.823168 \times 27.2114 \times \text{Ebare} - 1.07634$$

27.2114 is simply a coefficient for converting hartree into eV, and 0.823168 and - 1.07634 are adjustment coefficients. These are determined such that the calculated values of HOMO and LUMO of the compound as a calculation object match the measured values.

[Polymerizable compound]

The image-recording layer contains a polymerizable compound.

Herein, a polymerizable compound refers to a compound having a polymerizable group.

The polymerizable group is not particularly limited and may be a known polymerizable group. As the polymerizable group, an ethylenically unsaturated group is preferable. The polymerizable group may be a radically polymerizable group or a cationically polymerizable group. The polymerizable group is preferably a radically polymerizable group.

Examples of the radically polymerizable group include a (meth)acryloyl group, an allyl group, a vinylphenyl group, a vinyl group, and the like. From the viewpoint of reactivity, a (meth)acryloyl group is preferable.

The molecular weight of the polymerizable compound (weight-average molecular weight in a case where the polymerizable compound has molecular weight distribution) is preferably 50 or more and less than 2,500.

The polymerizable compound may be, for example, a radically polymerizable compound or a cationically polymerizable compound. As the polymerizable compound, an addition polymerizable compound having at least one ethylenically unsaturated bond (ethylenically unsaturated compound) is preferable.

The ethylenically unsaturated compound is preferably a compound having at least one ethylenically unsaturated bond on a terminal, and more preferably a compound having two or more ethylenically unsaturated bonds on a terminal. The chemical form of the polymerizable compound is, for example, a monomer, a prepolymer which is in other words a dimer, a trimer, or an oligomer, a mixture of these, or the like.

Particularly, from the viewpoint of UV printing durability, the aforementioned polymerizable compound preferably includes a polymerizable compound having functionalities of 3 or more, more preferably includes a polymerizable compound having functionalities of 7 or more, and even more preferably includes a polymerizable compound having functionalities of 10 or more. Particularly, from the viewpoint of UV printing durability of the lithographic printing plate to be obtained, the aforementioned polymerizable compound preferably includes an ethylenically unsaturated compound having functionalities of 3 or more (preferably having functionalities of 7 or more and more preferably having functionalities

of 10 or more), and more preferably includes a (meth)acrylate compound having functionalities of 3 or more (preferably having functionalities of 7 or more and more preferably having functionalities of 10 or more).

<<Oligomer>>

As the polymerizable compound to be incorporated into in the image-recording layer, a polymerizable compound which is an oligomer (hereinafter, also simply called "oligomer") is preferable.

Herein, an oligomer represents a polymerizable compound which has a molecular weight (weight-average molecular weight in a case where the compound has molecular weight distribution) of 600 or more and less than 10,000 and at least one polymerizable group.

From the viewpoint of excellent chemical resistance and excellent UV printing durability, the molecular weight of the oligomer is preferably 1,000 or more and 5,000 or less.

Furthermore, from the viewpoint of improving UV printing durability, the number of polymerizable groups in one molecule of the oligomer is preferably 2 or more, more preferably 3 or more, even more preferably 6 or more, and particularly preferably 10 or more.

The upper limit of the number of polymerizable groups in the oligomer is not particularly limited. The number of polymerizable groups is preferably 20 or less.

From the viewpoint of UV printing durability and on-press developability, an oligomer having 7 or more polymerizable groups and a molecular weight of 1,000 or more and less than 10,000 is preferable, and an oligomer having 7 or more and 20 or less polymerizable groups and a molecular weight of 1,000 or more and 5,000 or less is more preferable.

The oligomer may contain a polymer component which is likely to be generated in the process of manufacturing the oligomer.

From the viewpoint of UV printing durability, visibility, and on-press developability, the oligomer preferably has at least one kind of compound selected from the group consisting of a compound having a urethane bond, a compound having an ester bond, and a compound having an epoxy residue, and more preferably has a compound having a urethane bond.

Herein, an epoxy residue refers to a structure formed of an epoxy group. For example, the epoxy residue means a structure similar to a structure established by the reaction between an acid group (carboxylic acid group or the like) and an epoxy group.

As the compound having a urethane bond, which is an example of the oligomer, for example, a compound having at least a group represented by Formula (Ac-1) or Formula (Ac-2) is preferable, and a compound having at least a group represented by Formula (Ac-1) is more preferable.

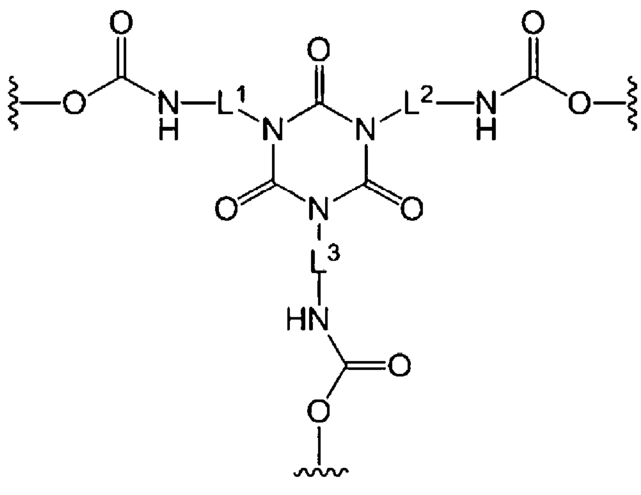

(Ac - 1)

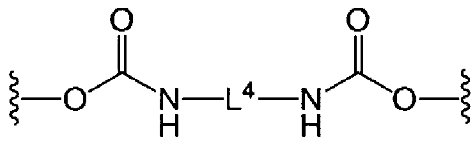

(Ac - 2)

In Formula (Ac-1) and Formula (Ac-2), $L^1$ to $L^4$ each independently represent a divalent hydrocarbon group having 2 to 20 carbon atoms, and the portion of the wavy line represents a bonding position with other structures.

$L^1$ to $L^4$ preferably each independently represent an alkylene group having 2 to 20 carbon atoms, more preferably each independently represent an alkylene group having 2 to 10 carbon atoms, and even more preferably each independently represent an alkylene group having 4 to 8 carbon atoms. The alkylene group may have a branched

structure or a ring structure. The alkylene group is preferably a linear alkylene group.

The portion of the wavy line in Formula (Ac-1) or Formula (Ac-2) is preferably each independently directly bonded to the portion of the wavy line in a group represented by Formula (Ae-1) or Formula (Ae-2).

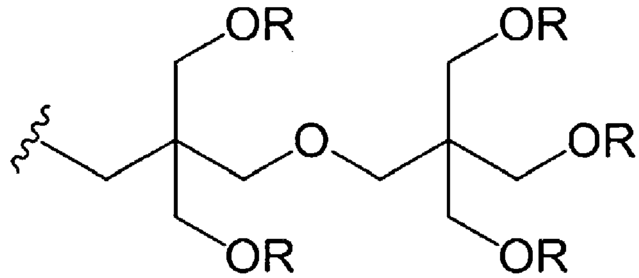

( Ae - 1 )

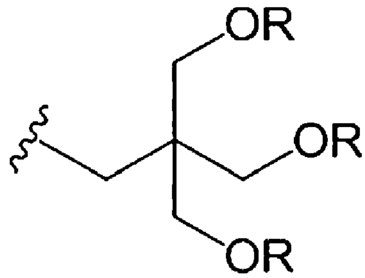

( Ae - 2 )

In Formula (Ae-1) and Formula (Ae-2), R each independently represent an acryloyloxy group or a methacryloyloxy group, and the portion of the wavy line represents a position bonded to the portion of the wavy line in Formula (Ac-1) and Formula (Ac-2).

As the compound having a urethane bond, a compound may also be used which is prepared by obtaining polyurethane by a reaction between a polyisocyanate compound and a polyol compound and introducing a polymerizable group into the polyurethane by a polymer reaction.

For example, the compound having a urethane bond may be obtained by reacting a polyol compound having an acid group with a polyisocyanate compound to obtain a polyurethane oligomer and reacting this polyurethane oligomer with a compound having an epoxy group and a polymerizable group.

The number of polymerizable groups in the compound having an ester bond, which is an example of oligomer, is preferably 3 or more, and more preferably 6 or more.

As the compound having an epoxy residue, which is an example of oligomer, a compound containing a hydroxy group is preferable.

The number of polymerizable groups in the compound having an epoxy residue is preferably 2 to 6, and more preferably 2 or 3.

The compound having an epoxy residue can be obtained, for example, by reacting a compound having an epoxy group with an acrylic acid.

Specific examples of oligomers will be shown below, but the oligomer is not limited thereto.

As the oligomer, commercially available products may also be used. Examples thereof include UA-510H, UA-306H, UA-306I, and UA-306T (manufactured by KYOEISHA CHEMICAL Co., LTD.), UV-1700B, UV-6300B, and UV7620EA (manufactured by NIHON GOSEI KAKO Co., Ltd.), U-15HA (manufactured by SHIN-NAKAMURA CHEMICAL Co., LTD.), EBECRYL450, EBECRYL657, EBECRYL885, EBECRYL800, EBECRYL3416, and EBECRYL860 (manufactured by DAICEL-ALLNEX LTD.), and the like. However, the oligomer is not limited to these.

From the viewpoint of improving chemical resistance and UV printing durability and further suppressing the residues of on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

<<Low-molecular-weight polymerizable compound>>

The polymerizable compound may further include a polymerizable compound other than the oligomer described above.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least a polymerizable compound selected from the group consisting of a polymerizable compound having three or more ethylenically unsaturated groups and a polymerizable compound having an isocyanuric ring structure.

Herein, a low-molecular-weight polymerizable compound refers to a polymerizable compound having a molecular weight (weight-average molecular weight in a case where the compound has molecular weight distribution) of 50 or

more and less than 600.

From the viewpoint of excellent chemical resistance, excellent UV printing durability, and excellently suppressing the residues of on-press development, the molecular weight of the low-molecular-weight polymerizable compound is preferably 100 or more and less than 600, more preferably 300 or more and less than 600, and even more preferably 400 or more and less than 600.

In a case where the polymerizable compound includes a low-molecular-weight polymerizable compound as the polymerizable compound other than an oligomer (total amount in a case where the polymerizable compound includes two or more kinds of low-molecular-weight polymerizable compounds), from the viewpoint of chemical resistance, UV printing durability, and suppressing the residues of on-press development, the ratio of the oligomer to the low-molecular-weight polymerizable compound (oligomer/low-molecular-weight polymerizable compound) is preferably 10/1 to 1/10, more preferably 10/1 to 3/7, and even more preferably 10/1 to 7/3, based on mass.

As the low-molecular-weight polymerizable compound, the polymerizable compounds described in paragraphs "0082" to "0086" of WO2019/013268A can also be suitably used.

From the viewpoint of speck-like color defect suppressiveness and on-press developability, the image-recording layer preferably contains a polymerizable compound having a molecular weight of 2,500 or less.

Suitable examples of the polymerizable compound having a molecular weight of 2,500 or less include an oligomer having a molecular weight of 2,500 or less among the aforementioned oligomers and the aforementioned low-molecular-weight polymerizable compound.

From the viewpoint of UV printing durability, speck-like color defect suppressiveness, and on-press developability, the polymerizable compound having a molecular weight of 2,500 or less preferably includes a polymerizable compound having functionalities of 7 or more, and more preferably includes a polymerizable compound having functionalities of 10 or more.

From the viewpoint of speck-like color defect suppressiveness and on-press developability, the content of the polymerizable compound having a molecular weight of 2,500 or less with respect to the total mass of the image-recording layer is preferably 60% by mass or less, more preferably 50% by mass or less, even more preferably 15% by mass to 50% by mass, and particularly preferably 25% by mass to 45% by mass.

From the viewpoint of speck-like color defect suppressiveness and on-press developability, the image-recording layer preferably contains, as a polymerizable compound, a polymer having a weight-average molecular weight of 10,000 or more.

As the polymer having a weight-average molecular weight of 10,000 or more, it is possible to use known polymers having a weight-average molecular weight of 10,000 or more having a polymerizable group, without particular limitation.

From the viewpoint of speck-like color defect suppressiveness and on-press developability, the content of the polymer having a weight-average molecular weight of 10,000 or more with respect to the total mass of the image-recording layer is preferably 5% by mass or more, and more preferably 10% by mass or more.

The content of the polymer having a weight-average molecular weight of 10,000 or more with respect to the total mass of the image-recording layer is preferably 45% by mass or less, and more preferably 35% by mass or less.

The polymer having a weight-average molecular weight of 10,000 or more preferably has an ethylenically unsaturated group. The polymer having a weight-average molecular weight of 10,000 or more is more preferably a polymer having a weight-average molecular weight of 10,000 or more and 150,000 or less, and has an ethylenically unsaturated bond valence of 3.0 mmol/g or more.

From the viewpoint of UV printing durability, the weight-average molecular weight (Mw) of the polymer having a weight-average molecular weight of 10,000 or more is preferably more and 15,000 and 150,000 or less, more preferably 20,000 or more and 150,000 or less, even more preferably 40,000 or more and 150,000 or less, and particularly preferably 70,000 or more and 150,000 or less.

From the viewpoint of developability, the weight-average molecular weight of the polymer having a weight-average molecular weight of 10,000 or more is preferably 130,000 or less.

From the viewpoint of UV printing durability, the ethylenically unsaturated bond valence (also called "C=C valence") of the polymer having a weight-average molecular weight of 10,000 or more is preferably 3.0 mmol/g or more, more preferably 5.0 mmol/g or more, even more preferably 4.5 mmol/g to 12.0 mmol/g, still more preferably 5.0 mmol/g to 10.0 mmol/g, and particularly preferably 5.5 mmol/g to 8.5 mmol/g.

The ethylenically unsaturated bond valence in the polymerizable compound can be determined by the following method.

First, for a predetermined amount (for example, 0.2 g) of sample compound, the structure of the compound is specified using, for example, pyrolysis GC/MS, FT-IR, NMR, TOF-SIMS, and the like, and the total amount (mmol) of ethylenically unsaturated groups is determined. The determined total amount (mmol) of ethylenically unsaturated groups is divided by the amount (g) of the sample compound, thereby calculating the ethylenically unsaturated bond valence of the compound.

The structure of the polymer having a weight-average molecular weight of 10,000 or more is not particularly

limited, and may be, for example, a graft polymer, a star-shaped polymer, a hyperbranched polymer, a dendrimer, or the like. Preferable examples of the polymer having a weight-average molecular weight of 10,000 or more include a polymer composed of a multimer (including an adduct) of a polyfunctional isocyanate compound and a compound having an ethylenicallyunsaturated group that seals the terminal isocyanate group of the multimer as will be described later.

From the viewpoint of developability and UV printing durability, the polymer having a weight-average molecular weight of 10,000 or more preferably has a hydrogen bonding group and more preferably has 3 or more hydrogen bonding groups.

The hydrogen bonding group may be a group capable of forming a hydrogen bond. The hydrogen bonding group may be either or both of a hydrogen bond donating group and a hydrogen bond accepting group.

Examples of the hydrogen bonding group include a hydroxy group, a carboxy group, an amino group, a carbonyl group, a sulfonyl group, a urethane group, a urea group, an imide group, an amide group, a sulfonamide group, and the like.

Particularly, from the viewpoint of UV printing durability, the hydrogen bonding group is preferably at least one kind of group selected from the group consisting of a urethane group, a urea group, an imide group, an amide group, and a sulfonamide group, more preferably at least one kind of group selected from the group consisting of a urethane group, a urea group, an imide group, and an amide group, even more preferably at least one kind of group selected from the group consisting of a urethane group, a urea group, and an imide group, and particularly preferably at least one kind of group selected from the group consisting of a urethane group and a urea group.

From the viewpoint of UV printing durability, the polymer having a weight-average molecular weight of 10,000 or more preferably has a polymerizable group.

The polymerizable group may be, for example, a cationically polymerizable group or a radically polymerizable group. From the viewpoint of reactivity, the polymerizable group is preferably a radically polymerizable group.

The polymerizable group is not particularly limited. From the viewpoint of reactivity, UV printing durability, and UV plate missing suppressiveness, the polymerizable group is preferably an ethylenically unsaturated group, more preferably at least one kind of group selected from the group consisting of a vinylphenyl group (styryl group), a vinyl ester group, a vinyl ether group, an allyl group, a (meth)acryloxy group, and a (meth)acrylamide group, even more preferably at least one kind of group selected from the group consisting of a vinylphenyl group (styryl group), a (meth)acryloxy group, and a (meth) acrylamide group, and particularly preferably a (meth)acryloxy group.

From the viewpoint of UV printing durability and UV plate missing suppressiveness, the polymer having a weight-average molecular weight of 10,000 or more preferably has a structure represented by Formula (Po-1) or Formula (Po-2) as the aforementioned polymerizable group, and more preferably has a structure represented by Formula (Po-1) as the polymerizable group.

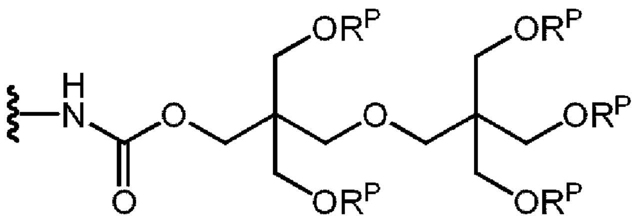

( Po - 1 )

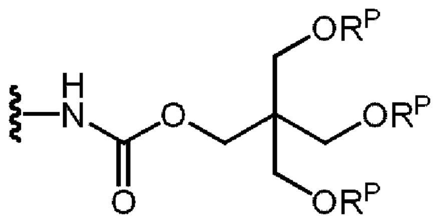

( Po - 2 )

In Formula (Po-1) and Formula (Po-2), $R^P$ each independently represents an acryloyl group or a methacryloyl group, and the portion of the wavy line represents a bonding position with other structures.

It is preferable that all $R^P$s in Formula (Po-1) or Formula (Po-2) be the same group.

Furthermore, it is preferable that all $R^P$s in Formula (Po-1) or Formula (Po-2) be an acryloyl group.

From the viewpoint of UV printing durability and UV plate missing suppressiveness, the polymer having a weight-average molecular weight of 10,000 or more is preferably a (meth)acrylate compound having a urethane group, that is, urethane (meth)acrylate.

Furthermore, from the viewpoint of UV printing durability and UV plate missing suppressiveness, the polymer having a weight-average molecular weight of 10,000 or more preferably has a structure established by multimerizing a polyfunctional isocyanate compound, and more preferably has a structure established by multimerizing a difunctional isocyanate compound.

From the viewpoint of UV printing durability and UV plate missing suppressiveness, the polymer having a weight-average molecular weight of 10,000 or more is preferably a polymer obtained by reacting a terminal hydroxy group (also called "hydroxyl group")-containing polyfunctional ethylenically unsaturated compound with a terminal of a multimer (including an adduct of a polyfunctional alcohol compound such as a trimethylolpropane adduct) prepared by multimerizing a polyfunctional isocyanate compound, more preferably a polymer obtained by reacting a hydroxy group-containing polyfunctional ethylenically unsaturated compound with a terminal of a multimer (including an adduct of a polyfunctional alcohol compound) prepared by multimerizing a difunctional isocyanate compound, and particularly preferably a polymer obtained by reacting a hydroxy group-containing polyfunctional ethylenically unsaturated compound with a terminal of a multimer (including an adduct of a polyfunctional alcohol compound) prepared by multimerizing hexamethylene diisocyanate.

As the polyfunctional isocyanate compound, known compounds can be used without particular limitation. This compound may be an aliphatic polyfunctional isocyanate compound or an aromatic polyfunctional isocyanate compound.

As the polyfunctional isocyanate compound, specifically, for example, 1,3-bis(isocyanatomethyl) cyclohexane, isophorone diisocyanate, trimethylene diisocyanate, tetramethylene diisocyanate, pentamethylene diisocyanate, hexamethylene diisocyanate, 1,3-cyclopentane diisocyanate, 9H-fluorene-2,7-diisocyanate, 9H-fluoren-9-on-2,7-diisocyanate, 4,4'-diphenylmethane diisocyanate, 1,3-phenylene diisocyanate, tolylene-2,4-diisocyanate, tolylene-2,6-diisocyanate, 1,3-bis(isocyanatomethyl) cyclohexane, 2,2-bis(4-isocyanatophenyl) hexafluoropropane, 1,5-diisocyanatonaphthalene, a dimer or trimer (isocyanurate bond) of these polyisocyanates, and the like are preferable. Furthermore, a biuret compound obtained by reacting the above polyisocyanate compound with a known amine compound may also be used.

Furthermore, the polyfunctional ethylenically unsaturated compound having a hydroxy group is preferably a hydroxy group-containing ethylenically unsaturated compound having functionalities of 3 or more, and more preferably a hydroxy group-containing ethylenically unsaturated compound having functionalities of 5 or more.

The aforementioned hydroxy group-containing polyfunctional ethylenically unsaturated compound is preferably a polyfunctional (meth)acrylate compound having a hydroxy group.

From the viewpoint of UV printing durability and suppressing UV plate missing suppressiveness, the polymer having a weight-average molecular weight of 10,000 or more preferably has at least one kind of structure selected from the group consisting of an adduct structure, a biuret structure, and an isocyanurate structure, more preferably has at least one kind of structure selected from the group consisting of a trimethylolpropane adduct structure, a biuret structure, and an isocyanurate structure, and particularly preferably has a trimethylolpropane adduct structure.

From the viewpoint of UV printing durability and UV plate missing suppressiveness, the polymer having a weight-average molecular weight of 10,000 or more preferably has a structure represented by any of Formula (A-1) to Formula (A-3), and more preferably has a structure represented by Formula (A-1).

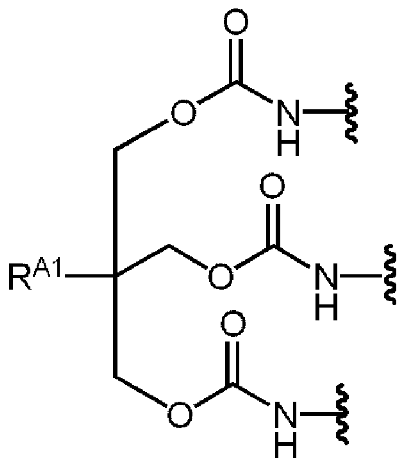

(A - 1)

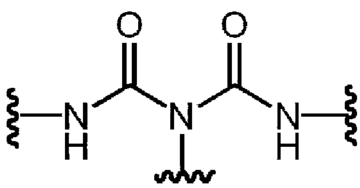

(A - 2)

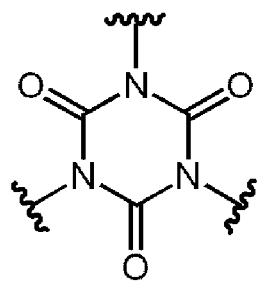

(A - 3)

In Formula (A-1), $R^{A1}$ represents a hydrogen atom or an alkyl group having 1 to 8 carbon atoms, and the portion of a wavy line represents a bonding position with other structures.

From the viewpoint of UV printing durability and UV plate missing suppressiveness, $R^{A1}$ in Formula (A-1) is preferably a hydrogen atom or an alkyl group having 1 to 4 carbon atoms, more preferably an alkyl group having 1 to 3 carbon atoms, even more preferably a methyl group or an ethyl group, and particularly preferably an ethyl group.

The polymer having a weight-average molecular weight of 10,000 or more preferably includes a resin represented by Formula (I).

$A^P$-$(B^P)_{np}\cdots$ Formula (I)

In Formula (I), $A^P$ represents an nP-valent organic group having a hydrogen bonding group, $B^P$ represents a

group having two or more polymerizable groups, and nP represents an integer of two or more.

The preferred aspect of the hydrogen bonding group in $A^P$ of Formula (I) is the same as the preferred aspect of the hydrogen bonding group described above.

$A^P$ in Formula (I) is preferably an organic group that does not have an ethylenically unsaturated bond.

Furthermore, $A^P$ in Formula (I) is preferably a group obtained by combining two or more kinds of structures selected from the group consisting of a mono- to nP-valent aliphatic hydrocarbon group, a mono- to nP-valent aromatic hydrocarbon group, a urethane bond, a urea bond, a biuret bond, and an allophanate bond, and more preferably a group obtained by combining two or more kinds of structures selected from the group consisting of a mono- to nP-valent aliphatic hydrocarbon group, a mono- to nP-valent aromatic hydrocarbon group, a urethane bond, a urea bond, and a biuret bond.

From the viewpoint of UV printing durability and UV plate missing suppressiveness, $A^P$ in Formula (I) is preferably a group obtained by removing a terminal isocyanate group from a multimer prepared by multimerization of a polyfunctional isocyanate compound (including an adduct of a polyfunctional alcohol compound such as trimethylolpropane adduct), more preferably a group obtained by removing a terminal isocyanate group from a multimer prepared by multimerization of a difunctional isocyanate compound (including an adduct of a polyfunctional alcohol compound), and particularly preferably a group obtained by removing a terminal isocyanate group from a multimer prepared by multimerization of hexamethylene diisocyanate (including an adduct of a polyfunctional alcohol compound).

Furthermore, from the viewpoint of UV printing durability and UV plate missing suppressiveness, the weight-average molecular weight (Mw) of $A^P$ in Formula (I) is preferably 10,000 or more and 145,000 or less, more preferably 30,000 or more and 140,000 or less, and particularly preferable 60,000 or more and 140,000 or less.

From the viewpoint of developability, the weight-average molecular weight of $A^P$ in Formula (I) is preferably 120,000 or less.

The preferred aspect of the polymerizable group in $B^P$ of Formula (I) is the same as the preferred aspect of the polymerizable group described above.

Among these, from the viewpoint of UV printing durability and UV plate missing suppressiveness, the polymerizable group in $B^P$ of Formula (I) preferably includes a (meth)acryloxy group. $B^P$ in Formula (I) is more preferably a group having 3 or more (meth)acryloxy groups, even more preferably a group having 5 or more (meth)acryloxy groups, and particularly preferably a group having 5 or more and 12 or less (meth)acryloxy groups.

Furthermore, from the viewpoint of UV printing durability and UV plate missing suppressiveness, $B^P$ in Formula (I) preferably each independently represents a structure represented by Formula (Po-1) or Formula (Po-2), and more preferably each independently represents a structure represented by Formula (Po-1).

It is preferable that all $B^P$s in Formula (I) be the same group.

From the viewpoint of UV printing durability and UV plate missing suppressiveness, the molecular weight of $B^P$ in Formula (I) is preferably 300 or more and 1,000 or less, and more preferably 400 or more and 800 or less.

In Formula (I), from the viewpoint of UV printing durability and UV plate missing suppressiveness, the value of weight-average molecular weight of $A^P$/(molecular weight of $B^P \times$ nP) is preferably 1 or less, more preferably 0.1 or more and 0.9 or less, and particularly preferably 0.2 or more and 0.8 or less.

The details of how to use the polymerizable compound, such as the structure of the compound, whether the compound is used alone or used in combination with other compounds, and the amount of the compound to be added, can be randomly set.

Particularly, from the viewpoint of UV printing durability, the image-recording layer preferably contains two or more kinds of polymerizable compounds.

The content of the polymerizable compound (total content of polymerizable compounds in a case where the image-recording layer contains two or more kinds of polymerizable compounds) with respect to the total mass of the image-recording layer is preferably 5% by mass to 75% by mass, more preferably 10% by mass to 70% by mass, and even more preferably 15% by mass to 60% by mass.

[Particles]

From the viewpoint of developability and UV printing durability, it is preferable that the image-recording layer contain particles. The particles may be inorganic particles or organic particles.

Particularly, the image-recording layer preferably contains organic particles as particles, and more preferably contains resin particles as particles.

Known inorganic particles can be used as inorganic particles, and metal oxide particles such as silica particles and titania particles can be suitably used.

<<Resin particles»

Examples of the resin particles include particles containing an addition polymerization-type resin (that is, addition

polymerization-type resin particles), particles containing a polyaddition-type resin (that is, polyaddition-type resin particles), particles containing a polycondensation-type resin (that is, polycondensation-type resin particles), and the like. Among these, addition polymerization-type resin particles or polyaddition-type resin particles are preferable.

From the viewpoint of enabling thermal fusion, the resin particles may also be particles containing a thermoplastic resin (that is, thermoplastic resin particles).

The resin particles may be in the form of microcapsules, a microgel (that is, crosslinked resin particles), or the like.

The resin particles are preferably selected from the group consisting of thermoplastic resin particles, thermal reactive resin particles, resin particles having a polymerizable group, microcapsules encapsulating a hydrophobic compound, and a microgel (crosslinked resin particles). Among these, resin particles having a polymerizable group are preferable.

In a particularly preferred embodiment, the resin particles have at least one ethylenically unsaturated group. The presence of such resin particles brings about effects of improving the printing durability of an exposed portion and improving the on-press developability of a non-exposed portion.

As the thermoplastic resin particles, the thermoplastic resin particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like are preferable.

Specific examples of resins constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures of these.

From the viewpoint of ink receptivity and UV printing durability, the thermoplastic resin particles preferably contain a resin that has a structural unit formed of an aromatic vinyl compound and a nitrile group-containing structural unit.

The aforementioned aromatic vinyl compound may have a structure composed of an aromatic ring and a vinyl group bonded thereto. Examples of the compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, for example, styrene is preferable.

From the viewpoint of ink receptivity, the content of the structural unit formed of an aromatic vinyl compound is preferably higher than the content of the nitrile group-containing structural unit that will be described later. The content of the structural unit formed of an aromatic vinyl compound with respect to the total mass of the thermoplastic resin is more preferably 15% by mass to 85% by mass, and even more preferably 30% by mass to 70% by mass.

The nitrile group-containing structural unit is preferably introduced using a monomer having a nitrile group.

Examples of the monomer having a nitrile group include an acrylonitrile compound. As the monomer having a nitrile group, for example, (meth)acrylonitrile is suitable.

As the nitrile group-containing structural unit, a structural unit formed of (meth)acrylonitrile is preferable.

From the viewpoint of ink receptivity, the content of the nitrile group-containing structural unit is preferably lower than the content of the aforementioned structural unit formed of an aromatic vinyl compound. The content of the nitrile group-containing structural unit with respect to the total mass of the resin is more preferably 55% by mass to 90% by mass, and even more preferably 60% by mass to 85% by mass.

In a case where the resin contained in the thermoplastic resin particles has the structural unit formed of an aromatic vinyl compound and the nitrile group-containing structural unit, the content ratio between the structural unit formed of an aromatic vinyl compound and the nitrile group-containing structural unit (structural unit formed of aromatic vinyl compound: nitrile group-containing structural unit) is preferably 5:5 to 9:1, and more preferably 6:4 to 8:2, based on mass.

From the viewpoint of UV printing durability and chemical resistance, the resin contained in the thermoplastic resin particles preferably further has a structural unit formed of a N-vinyl heterocyclic compound.

Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

The content of the structural unit formed of a N-vinyl heterocyclic compound with respect to the total mass of the thermoplastic resin is preferably 5% by mass to 50% by mass, and more preferably 10% by mass to 40% by mass.

The resin contained in the thermoplastic resin particles may contain an acidic group-containing structural unit. From the viewpoint of on-press developability and ink receptivity, it is preferable that the resin do not contain an acidic group-containing structural unit.

Specifically, in the thermoplastic resin, the content of the acidic group-containing structural unit is preferably 20% by mass or less, more preferably 10% by mass or less, and even more preferably 5% by mass or less. The lower limit of the content is not particularly limited, and may be 0% by mass.

The acid value of the thermoplastic resin is preferably 160 mg KOH/g or less, more preferably 80 mg KOH/g or less, and even more preferably 40 mg KOH/g or less. The lower limit of the acid value is not particularly limited, and may be 0 mg KOH/g.

In Herein, the acid value is determined by the measurement method based on JIS K0070: 1992.

From the viewpoint of ink receptivity, the resin contained in the thermoplastic resin particles may contain a hydrophobic group-containing structural unit.

Examples of the hydrophobic group include an alkyl group, an aryl group, an aralkyl group, and the like.

As the hydrophobic group-containing structural unit, a structural unit formed of an alkyl (meth)acrylate compound, an aryl (meth)acrylate compound, or an aralkyl (meth)acrylate compound is preferable, and a structural unit formed of an alkyl (meth)acrylate compound is more preferable.

In the resin contained in the thermoplastic resin particles, the content of the hydrophobic group-containing structural unit with respect to the total mass of the resin is preferably 5% by mass to 50% by mass, and more preferably 10% by mass to 30% by mass.

From the viewpoint of UV printing durability and on-press developability, the thermoplastic resin contained in the thermoplastic resin particles preferably has a hydrophilic group.

The hydrophilic group is not particularly limited as long as it has a hydrophilic structure, and examples thereof include an acid group such as a carboxy group, a hydroxy group, an amino group, a nitrile group, a polyalkylene oxide structure, and the like.

From the viewpoint of UV printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

From the viewpoint of on-press developability, among the above hydrophilic groups, groups having a polypropylene oxide structure as a polyalkylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

From the viewpoint of on-press developability, as the aforementioned hydrophilic group, a group represented by Formula Z, which will be described later, is preferable.

Among the hydrophilic groups that the thermoplastic resin has, a group represented by Formula PO is preferable.

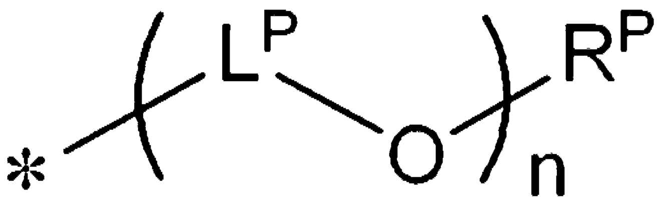

Formula PO

In Formula PO, $L^P$ each independently represent an alkylene group, $R^P$ represents a hydrogen atom or an alkyl group, n represents an integer of 1 to 100, and * represents a bonding position with other structures.

In Formula PO, $L^P$ preferably each independently represent an ethylene group, a 1-methylethylene group, or a 2-methylethylene group, and more preferably each independently represent an ethylene group.

In Formula PO, $R^P$ is preferably a hydrogen atom or an alkyl group having 1 to 18 carbon atoms, more preferably a hydrogen atom or an alkyl group having 1 to 10 carbon atoms, even more preferably a hydrogen atom or an alkyl group having 1 to 4 carbon atoms, and particularly preferably a hydrogen atom or a methyl group.

In Formula PO, n is preferably an integer of 1 to 10, and more preferably an integer of 1 to 4.

The content of the hydrophilic group-containing structural unit with respect to the total mass of the resin is preferably 5% by mass to 60% by mass, and more preferably 10% by mass to 30% by mass.

The resin contained in the thermoplastic resin particles may further contain other structural units. The resin can contain, as those other structural units, structural units other than the structural units described above without particular limitations. Examples thereof include structural units formed of an acrylamide compound, a vinyl ether compound, and the like.

In the resin contained in the thermoplastic resin particles, the content of other structural units with respect to the

total mass of the resin is preferably 5% by mass to 50% by mass, and more preferably 10% by mass to 30% by mass.

Examples of the thermal reactive resin particles include resin particles having a thermal reactive group. The thermal reactive resin particles form a hydrophobic region through crosslinking by a thermal reaction and the accompanying change in functional groups.

The thermal reactive group in the resin particles having a thermal reactive group may be a functional group that causes any reaction as long as chemical bonds are formed. The thermal reactive group is preferably a polymerizable group. Preferred examples of the polymerizable group include an ethylenically unsaturated group that causes a radical polymerization reaction (for example, an acryloyl group, a methacryloyl group, a vinyl group, an allyl groups, and the like), a cationically polymerizable group (for example, a vinyl group, a vinyloxy group, an epoxy group, an oxetanyl group, and the like), an isocyanato group or a blocked isocyanato group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

The resin having a thermal reactive group may be an addition polymerization-type resin, a polyaddition-type resin, or a polycondensation-type resin or may be a thermoplastic resin.

As the microcapsules, for example, microcapsules are preferable which encapsulate at least some of the constituent components (preferably a hydrophobic compound) of the image-recording layer as described in JP2001-277740A and JP2001-277742A. In a preferred aspect of the image-recording layer containing microcapsules as resin particles, the image-recording layer is composed of microcapsules that encapsulate a hydrophobic component (that is, a hydrophobic compound) among the constituent components of the image-recording layer and a hydrophilic component (that is, a hydrophilic compound) that is on the outside of the microcapsules.

The microgel (crosslinked resin particles) can contain some of the constituent components of the image-recording layer, in at least one of the surface or the interior of the microgel. From the viewpoint of sensitivity of the lithographic printing plate precursor to be obtained and printing durability of the lithographic printing plate to be obtained, reactive microgel having a polymerizable group on the surface thereof is particularly preferable.

In order to obtain microcapsules containing a constituent component of the image-recording layer, known synthesis methods can be used.

The microgel (crosslinked resin particles) can contain some of the constituent components of the image-recording layer, in at least one of the surface or the interior of the microgel. From the viewpoint of sensitivity of the lithographic printing plate precursor to be obtained and printing durability of the lithographic printing plate to be obtained, reactive microgel having a polymerizable group on the surface thereof is particularly preferable.

In order to obtain microgel containing a constituent component of the image-recording layer, known synthesis methods can be used.

As the resin particles, from the viewpoint of printing durability, antifouling properties, and storage stability of the lithographic printing plate to be obtained, polyaddition-type resin particles are preferable which are obtained by a reaction between a polyvalent isocyanate compound that is an adduct of a polyhydric phenol compound having two or more hydroxy groups in a molecule and isophorone diisocyanate and a compound having active hydrogen.

As the polyhydric phenol compound, a compound having a plurality of benzene rings having a phenolic hydroxyl group is preferable.

As the compound having active hydrogen, a polyol compound or a polyamine compound is preferable, a polyol compound is more preferable, and at least one kind of compound selected from the group consisting of propylene glycol, glycerin, and trimethylolpropane is even more preferable. As the aforementioned active hydrogen compound, water can also be used. **In** a case where water is used, the amine generated by the reaction between an isocyanato group and water can form a urea bond to form particles.

Preferred examples of the resin particles obtained by the reaction between a polyvalent isocyanate compound that is an adduct of a polyhydric phenol compound having two or more hydroxy groups in a molecule and isophorone diisocyanate and a compound having active hydrogen include the resin particles described in paragraphs "0230" to "0234" of WO2018043259A.

As the resin particles, from the viewpoint of printing durability and solvent resistance of the lithographic printing plate to be obtained, addition polymerization-type resin particles are preferable which have a hydrophobic main chain and include both i) structural unit having a nitrile group directly bonded to the hydrophobic main chain and ii) structural unit having a pendant group including a hydrophilic polyalkylene oxide segment. Specifically, the particles described in paragraph "0156" of JP2019-64269A are preferable.

<<Group represented by Formula Z>>

It is preferable that the resin particles have a group represented by Formula Z as a hydrophilic group.

*-Q-W-Y Formula Z

**In** formula Z, Q represents a divalent linking group, W represents a divalent group having a hydrophilic structure or a divalent group having a hydrophobic structure, and Y represents a monovalent group having a hydrophilic structure or a monovalent group having a hydrophilic structure, either W or Y has a hydrophilic structure, and * represents a bonding site with another structure.

Furthermore, it is preferable that any of the hydrophilic structures included in Formula Z include a polyalkylene oxide structure.

Q in Formula Z is preferably a divalent linking group having 1 to 20 carbon atoms, and more preferably a divalent linking group having 1 to 10 carbon atoms.

Furthermore, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a group having a polyalkylene oxide structure, and more preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$ each independently represent a linear, branched, or cyclic alkylene group having 6 to 120 carbon atoms, a haloalkylene group having 6 to 120 carbon atoms, an arylene group having 6 to 120 carbon atoms, an alkarylene group having 6 to 120 carbon atoms (divalent group formed by removing one hydrogen atom from an alkylaryl group), or an aralkylene group having 6 to 120 carbon atoms.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal. Particularly, the monovalent group having a hydrophilic structure is preferably a group having a polyalkylene oxide structure, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group having 6 to 120 carbon atoms (alkylaryl group), an aralkyl group having 6 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoint of printing durability, receptivity, and on-press developability, in the resin particles having a group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal.

The group represented by Formula Z may function as a dispersible group for improving the dispersibility of the resin particles.

From the viewpoint of printing durability and on-press developability, the resin particles preferably have a polymerizable group (preferably an ethylenically unsaturated group). Particularly, the resin particles more preferably include resin particles having a polymerizable group on the surface thereof. Using the resin particles having a polymerizable group makes it easy to suppress plate missing (preferably UV plate missing) and improves printing durability (preferably UV printing durability) as well.

From the viewpoint of printing durability, it is preferable that the resin particles be resin particles having a hydrophilic group and a polymerizable group.

The polymerizable group may be a cationically polymerizable group or a radically polymerizable group. From the viewpoint of reactivity, the polymerizable group is preferably a radically polymerizable group.

The aforementioned polymerizable group is not particularly limited as long as it is a polymerizable group. From the viewpoint of reactivity, an ethylenically unsaturated group is preferable, a vinylphenyl group (styryl group), a (meth)acryloxy group, or a (meth)acrylamide group is more preferable, and a (meth)acryloxy group is particularly preferable.

**In** addition, it is preferable that the resin constituting the resin particles having a polymerizable group have a polymerizable group-containing structural unit.

The polymerizable group may be introduced into the surface of the resin particles by a polymer reaction.

Furthermore, from the viewpoint of printing durability, receptivity, on-press developability, and suppression of the occurrence of development residues during on-press development, the resin particles preferably contain a polyaddition-type resin having a urea bond, more preferably contain a polyaddition-type resin having a structure obtained by reacting at least an isocyanate compound represented by Formula (Iso) with water, and particularly preferably contain a polyaddition-type resin that has a structure obtained by reacting at least an isocyanate compound represented by Formula (Iso) with water and has a polyethylene oxide structure and a polypropylene oxide structure as polyoxyalkylene structures. Furthermore, the particles containing the polyaddition-type resin having a urea bond are preferably microgel.

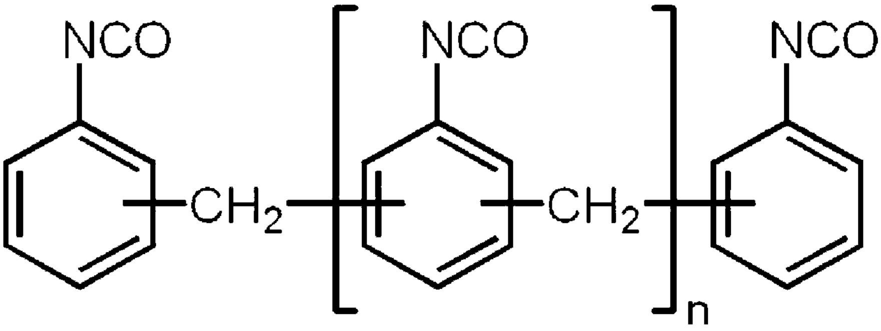

( Iso )

In Formula (Iso), n represents an integer of 0 to 10.

An example of the reaction between the isocyanate compound represented by Formula (Iso) and water is the reaction shown below. In the following example, a 4,4-isomer in which n = 0 is used.

As shown below, in a case where the isocyanate compound represented by Formula (Iso) is reacted with water, the isocyanate group is partially hydrolyzed by water and generates an amino group. The generated amino group reacts with the isocyanate group and generates a urea bond, and a dimer is consequently formed. Furthermore, the following reaction is repeated to form a polyaddition-type resin having a urea bond.

In the following reaction, by adding a compound (compound having active hydrogen) such as an alcohol compound or an amine compound reactive with an isocyanate group, it is possible to introduce the structure of an alcohol compound, an amine compound, or the like to the polyaddition-type resin having a urea bond.

Preferred examples of the compound having active hydrogen include the aforementioned compound having active hydrogen.

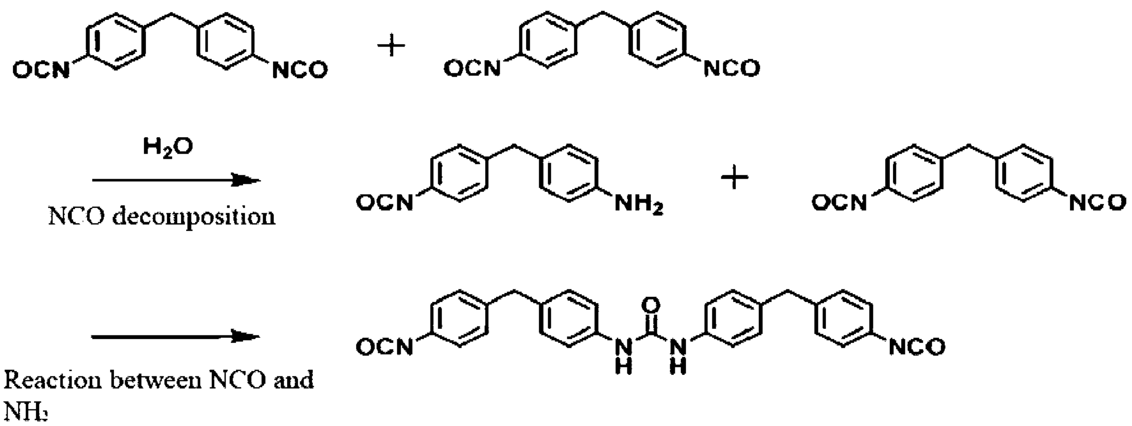


The polyaddition-type resin having a urea bond preferably has an ethylenically unsaturated group, and more preferably has a group represented by Formula (PETA).

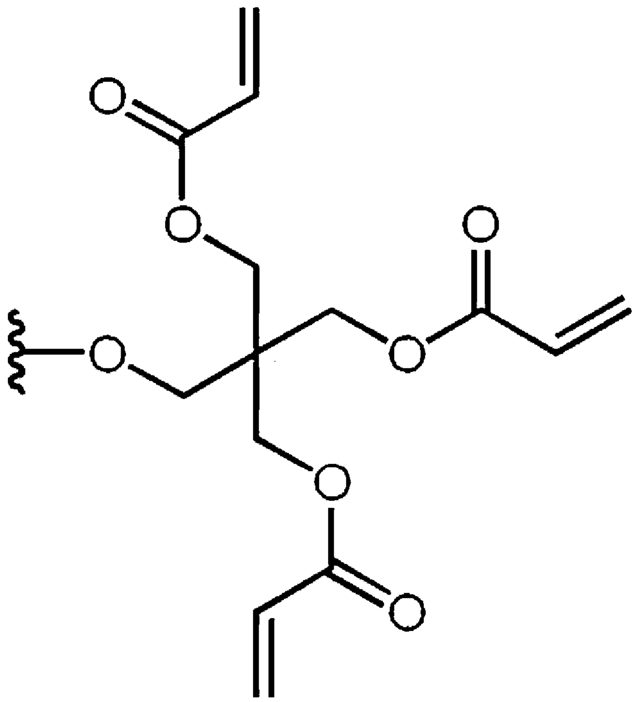

( PETA )

In Formula (PETA), the portion of the wavy line represents a bonding position with other structures.

<<Synthesis of resin particles>>

The synthesis method of the resin particles is not particularly limited, and may be a method that makes it possible to synthesize particles with various resins described above. Examples of the synthesis method of the resin particles include known synthesis methods of resin particles, such as an emulsion polymerization method, a suspension polymerization method, a dispersion polymerization method, a soap-free polymerization method, and a microemulsion polymerization method.

In addition, for the synthesis of the resin particles, a known microcapsule synthesis method, a known microgel (crosslinked resin particle) synthesis method, and the like may be used.

<<Average particle diameter of particles >>

The average particle diameter of the particles is preferably 0.01 μm to 3.0 μm, more preferably 0.03 μm to 2.0 μm, and even more preferably 0.10 μm to 1.0 μm. In a case where the average particle diameter is in this range, excellent resolution and temporal stability are obtained.

The average particle diameter of the particles is measured using a light scattering method or by capturing an electron micrograph of the particles, measuring the particle diameter of a total of 5,000 particles in the photograph, and calculating the average thereof. For nonspherical particles, the equivalent circular diameter of the particles in a photograph is adopted.

Note that unless otherwise specified, the average particle diameter of the particles means a volume average particle diameter.

As the particles (preferably resin particles), only one kind of particles may be used, or two or more kinds of particles may be used in combination.

From the viewpoint of developability and printing durability, the content of the particles (preferably resin particles) with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.

[Other components]

The image-recording layer may contain other components in addition to the components described above.

Examples of those other components include a binder polymer, a surfactant, a chain transfer agent, a low-molecular-weight hydrophilic compound, an oil sensitizing agent, other additives, and the like.

Examples of those other components include a colorant, a bakeout agent, a polymerization inhibitor, a higher fatty acid derivative, a plasticizer, inorganic particles, and a low-molecular-weight hydrophilic compound disclosed in paragraphs "0181" to "0190" of JP2009-255434A, and the like.

Examples of other compounds also include a hydrophilic precursor (fine particles capable of converting the image-recording layer into a hydrophobic image-recording layer in a case where heat is applied thereto), a low-molecular-weight hydrophilic compound, an oil sensitizing agent (for example, a phosphonium compound, a nitrogen-containing low-molecular-weight compound, or an ammonium group-containing polymer), and a chain transfer agent disclosed in paragraphs "0191" to "0217" of JP2012-187907A.

-Binder polymer-

As necessary, the image-recording layer may contain a binder polymer.

The binder polymer refers to a polymer other than resin particles, that is, a polymer that is not in the form of particles.

**In** addition, the binder polymer excludes an ammonium salt-containing polymer in an oil sensitizing agent and a polymer used as a surfactant.

As the binder polymer, known binder polymers (for example, a (meth) acrylic resin, a polyvinyl acetal resin, a polyurethane resin, and the like) used for the image-recording layer of a lithographic printing plate precursor can be suitably used.

As an example, a binder polymer that is used for an on-press development type lithographic printing plate precursor (hereinafter, also called binder polymer for on-press development) will be specifically described.

As the binder polymer for on-press development, a binder polymer having an alkylene oxide chain is preferable. The binder polymer having an alkylene oxide chain may have a poly(alkylene oxide) moiety in a main chain or side chain. **In** addition, the binder polymer may be a graft polymer having poly(alkylene oxide) in a side chain or a block copolymer of a block composed of a poly(alkylene oxide)-containing repeating unit and a block composed of an (alkylene oxide)-free repeating unit.

As a binder polymer having a poly(alkylene oxide) moiety in the main chain, a polyurethane resin is preferable.

**In** a case where the binder polymer has a poly(alkylene oxide) moiety in the side chain, examples of polymers as the main chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

**In** addition, as the binder polymer, for example, a polymer compound is also preferable which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound).

As the star-shaped polymer compound, for example, the compounds described in JP2012-148555A can be preferably used.

Examples of the star-shaped polymer compound include the compound described in JP2008-195018A that has a polymerizable group such as an ethylenically unsaturated bond for improving the film hardness of an image area in a main chain or side chain and preferably in a side chain. The polymerizable group of the star-shaped polymer compound forms crosslinks between the molecules of the star-shaped polymer compound, which facilitates curing.

As the polymerizable group, an ethylenically unsaturated group such as a (meth)acryloyl group, a vinyl group, an allyl group, or a vinyl phenyl group (styryl group), an epoxy group, or the like is preferable, a (meth)acryloyl group, a vinyl group, or a vinyl phenyl group (styryl group) is more preferable from the viewpoint of polymerization reactivity, and a (meth) acryloyl group is particularly preferable. These groups can be introduced into the polymer by a polymer reaction or copolymerization. Specifically, for example, it is possible to use a reaction between a polymer having a carboxy group in a side chain and glycidyl methacrylate or a reaction between a polymer having an epoxy group and an ethylenically unsaturated group-containing carboxylic acid such as methacrylic acid.

The molecular weight of the binder polymer that is a polystyrene-equivalent weight-average molecular weight (Mw) determined by GPC is preferably 2,000 or more, more preferably 5,000 or more, and even more preferably 10,000 to 300,000.

As the binder polymer, as necessary, a hydrophilic polymer such as polyacrylic acid or polyvinyl alcohol described in JP2008-195018A can be used in combination. In addition, a lipophilic polymer and a hydrophilic polymer can be used in combination.

One kind of binder polymer may be used alone, or two or more kinds of binder polymers may be used in combination.

The content of the binder polymer to be incorporated into the image-recording layer can be randomly set. The content of the binder polymer with respect to the total mass of the image-recording layer is preferably 1% by mass to 90%

by mass, and more preferably 5% by mass to 80% by mass.

[Formation of image-recording layer]

The image-recording layer in the lithographic printing plate precursor can be formed, for example, by preparing a coating liquid by dispersing or dissolving the necessary components described above in a known solvent, coating a support with the coating liquid by a known method such as bar coating, and drying the coating liquid, as described in paragraphs "0142" and "0143" of JP2008-195018A. The coating amount (solid content) of the image-recording layer after coating and drying varies with uses, but is preferably 0.3 $g/m^2$ to 3.0 $g/m^2$. In a case where the coating amount is in this range, excellent sensitivity and excellent film characteristics of the image-recording layer are obtained.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. One kind of solvent may be used alone, or two or more kinds of the solvents may be used in combination. The concentration of solid contents in the coating liquid is preferably 1% by mass to 50% by mass.

The coating amount (solid content) of the image-recording layer after coating and drying varies with uses. However, from the viewpoint of obtaining excellent sensitivity and excellent film characteristics of the image-recording layer, the coating amount is preferably 0.3 $g/m^2$ to 3.0 $g/m^2$.

The film thickness of the image-recording layer in the lithographic printing plate precursor is preferably 0.1 μm to 3.0 μm, and more preferably 0.3 μm to 2.0 μm.

Herein, the film thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

<Outermost layer>

The lithographic printing plate precursor according to the present invention may have an outermost layer (also called "overcoat layer" in some cases) on the image-recording layer.

The outermost layer may have a function of suppressing the reaction inhibiting image formation by blocking oxygen, a function of preventing the damage of the image-recording layer, and a function of preventing ablation during exposure to high-illuminance lasers.

It is preferable that the on-press development type lithographic printing plate precursor according to the present invention have a support, an image-recording layer, and an outermost layer in this order.

**In** the on-press development type lithographic printing plate precursor, the outermost layer is the outermost layer on the side of the image-recording layer that is on the support.

The outermost layer preferably contains a water-soluble polymer, and more preferably contains a water-soluble polymer and a hydrophobic polymer.

Furthermore, the outermost layer preferably contains a discoloring compound.

The outermost layer may contain other components such as an oil sensitizing agent and an infrared absorber.

-Discoloring compound-

The outermost layer preferably contains a discoloring compound.

Herein, "discoloring compound" refers to a compound which undergoes change in absorption in the visible light region (wavelength: 400 nm or more and less than 750 nm) due to the exposure to infrared. That is, "discoloring" means that the absorption in the visible light region (wavelength: 400 nm or more and less than 750 nm) changes due to the exposure to infrared.

Specifically, examples of the discoloring compound include (1) compound that absorbs more light in the visible light region due to the exposure to infrared than before the exposure to infrared, (2) compound that is made capable of absorbing light in the visible light region due to the exposure to infrared, and (3) compound that is made incapable of absorbing light in the visible light region due to the exposure to infrared.

The infrared is a ray having a wavelength of 750 nm to 1 mm, and preferably a ray having a wavelength of 750 nm

to 1,400 nm.

The discoloring compound preferably includes a compound that develops color due to the exposure to infrared.

Furthermore, the discoloring compound preferably includes a decomposable compound that decomposes due to the exposure to infrared, and particularly preferably includes a decomposable compound that decomposes by either or both of heat and electron migration due to the exposure to infrared.

More specifically, the discoloring compound is preferably a compound that decomposes due to the exposure to infrared (more preferably, decomposes by either or both of heat or electron migration due to the exposure to infrared) and absorbs more light in the visible light region than before the exposure to infrared or is made capable of absorbing light of shorter wavelengths and thus capable of absorbing light in the visible light region.

"Decomposes by electron migration" mentioned herein means that electrons excited to the lowest unoccupied molecular orbital (LUMO) from the highest occupied molecular orbital (HOMO) of the discoloring compound by exposure to infrared move to electron accepting groups (groups having potential close to LUMO) in a molecule by means of intramolecular electron migration and thus result in decomposition.

Hereinafter, as an example of the discoloring compound, a decomposable compound will be described.

There are no limitations on the decomposable compound as long as it absorbs at least a part of light in the infrared wavelength region (wavelength region of 750 nm to 1 mm, preferably a wavelength region of 750 nm to 1,400 nm) and decomposes. The decomposable compound is preferably a compound having maximum absorption wavelength in a wavelength region of 750 nm to 1,400 nm.

More specifically, the decomposable compound is preferably a compound that decomposes due to the exposure to infrared and generates a compound having maximum absorption wavelength in a wavelength region of 500 nm to 600 nm.

From the viewpoint of improving visibility of exposed portions, the decomposable compound is preferably a cyanine dye having a group that decomposes by exposure to infrared (specifically, $R^1$ in Formula 1-1 to Formula 1-7).

From the viewpoint of improving visibility of exposed portions, the decomposable compound is more preferably a compound represented by Formula 1-1.

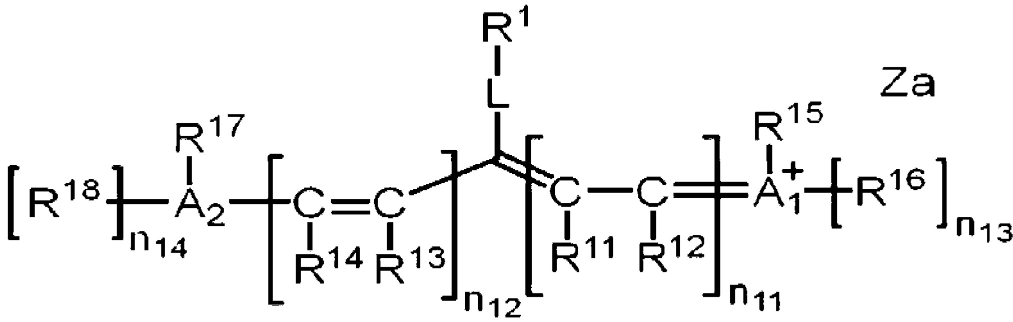

Formula 1-1

In Formula 1-1, $R^1$ represents a group that is represented by any of Formula 2-1 to Formula 4-1, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R_{11}$ to $R_{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, the sum of $n_{11}$ and $n_{12}$ is 2 or more, $n_{13}$ and $n_{14}$ each independently represent 0 or 1, L represents an oxygen atom, a sulfur atom, or $-NR^{10}-$, $R^{10}$ represents a hydrogen atom, an alkyl group, or an aryl group, and Za represents a counterion that neutralizes charge.

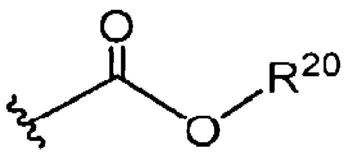

Formula 2-1

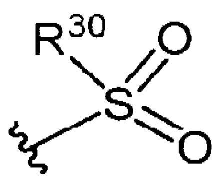

Formula 3-1

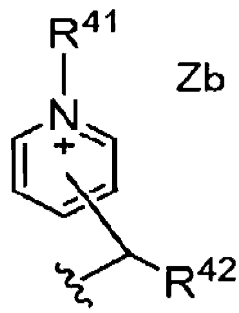

, Formula 4-1

In Formula 2-1 to Formula 4-1, $R^{20}$, $R^{30}$, $R^{41}$, and $R^{42}$ each independently represent an alkyl group or an aryl group, Zb represents a counterion that neutralizes charge, a wavy line represents a bonding site with a group represented by L in Formula 1-1.

In a case where the compound represented by Formula 1-1 is exposed to infrared, the $R^1$-L bond is cleaved, L turns into =O, =S, or $=NR^{10}$, and the compound is discolored.

In Formula 1-1, $R^1$ represents a group represented by any of Formula 2-1 to Formula 4-1.

Hereinafter, each of the group represented by Formula 2-1, the group represented by Formula 3-1, and the group represented by Formula 4-1 will be described.

In Formula 2-1, $R^{20}$ represents an alkyl group or an aryl group, and the portion of the wavy line represents a bonding site with the group represented by L in Formula 1-1.

As the alkyl group represented by $R^{20}$, an alkyl group having 1 to 30 carbon atoms is preferable, an alkyl group having 1 to 15 carbon atoms is more preferable, and an alkyl group having 1 to 10 carbon atoms is even more preferable.

The alkyl group may be linear or branched, or may have a ring structure.

The aryl group represented by $R^{20}$ is preferably an aryl group having 6 to 30 carbon atoms, more preferably an aryl group having 6 to 20 carbon atoms, and even more preferably an aryl group having 6 to 12 carbon atoms.

From the viewpoint of visibility, $R^{20}$ is preferably an alkyl group.

From the viewpoint of decomposition properties and visibility, the alkyl group represented by $R^{20}$ is preferably a secondary alkyl group or a tertiary alkyl group, and preferably a tertiary alkyl group.

Furthermore, from the viewpoint of decomposition properties and visibility, the alkyl group represented by $R^{20}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Specific examples of the group represented by Formula 2-1 will be shown below. However, it is not limited thereto. In the following structural formulas, • represents a bonding site with the group represented by L in Formula 1-1.

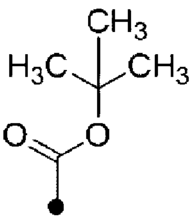
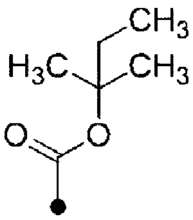
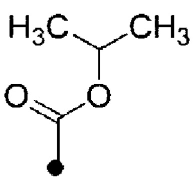
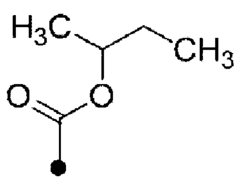
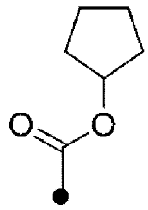

In Formula 3-1, $R^{30}$ represents an alkyl group or an aryl group, and the portion of the wavy line represents a bonding site with the group represented by L in Formula 1-1.

The alkyl group and aryl group represented by $R^{30}$ are the same as the alkyl group and aryl group represented by $R^{20}$ in Formula 2-1, and the preferred aspects thereof are also the same.

From the viewpoint of decomposition properties and visibility, the alkyl group represented by $R^{30}$ is preferably a secondary alkyl group or a tertiary alkyl group, and preferably a tertiary alkyl group.

Furthermore, from the viewpoint of decomposition properties and visibility, the alkyl group represented by $R^{30}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

In addition, from the viewpoint of decomposition properties and visibility, the alkyl group represented by $R^{30}$ is preferably a substituted alkyl group, more preferably a fluoro-substituted alkyl group, even more preferably a perfluoroalkyl group, and particularly preferably a trifluoromethyl group.

From the viewpoint of decomposition properties and visibility, the aryl group represented by $R^{30}$ is preferably a substituted aryl group. Examples of the substituent include an alkyl group (preferably an alkyl group having 1 to 4 carbon atoms), an alkoxy group (preferably an alkoxy group having 1 to 4 carbon atoms), and the like.

Specific examples of the group represented by Formula 3-1 will be shown below. However, it is not limited thereto. In the following structural formulas, • represents a bonding site with the group represented by L in Formula 1-1.

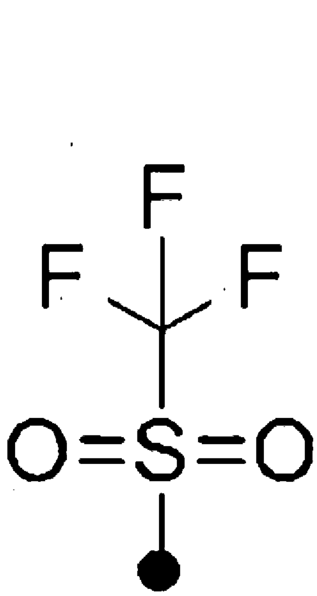

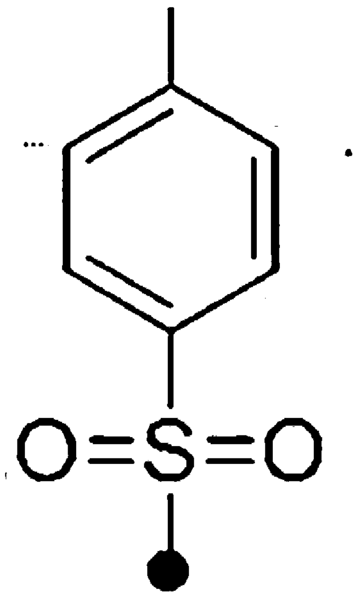

In Formula 4-1, $R^{41}$ and $R^{42}$ each independently represent an alkyl group or an aryl group, Zb represents a counterion that neutralizes charge, and the portion of the wavy line represents a bonding site with the group represented by L in Formula 1-1.

The alkyl group and aryl group represented by $R^{41}$ or $R^{42}$ are the same as the alkyl group and aryl group represented by $R^{20}$ in Formula 2, and preferred aspects thereof are also the same.

From the viewpoint of decomposition properties and visibility, $R^{41}$ is preferably an alkyl group.

From the viewpoint of decomposition properties and visibility, $R^{42}$ is preferably an alkyl group.

From the viewpoint of decomposition properties and visibility, the alkyl group represented by $R^{41}$ is preferably an alkyl group having 1 to 8 carbon atoms, more preferably an alkyl group having 1 to 4 carbon atoms, and particularly preferably a methyl group.

From the viewpoint of decomposition properties and visibility, the alkyl group represented by $R^{42}$ is preferably a secondary alkyl group or a tertiary alkyl group, and preferably a tertiary alkyl group.

Furthermore, from the viewpoint of decomposition properties and visibility, the alkyl group represented by $R^{42}$ is preferably an alkyl group having 1 to 8 carbon atoms, more preferably a branched alkyl group having 3 to 10 carbon atoms, even more preferably a branched alkyl group having 3 to 6 carbon atoms, particularly preferably an isopropyl group or a tert-butyl group, and most preferably a tert-butyl group.

Zb in Formula 4-1 may be a counterion that neutralizes charge, and may be included in Za in Formula 1-1 in the entirety of the compound.

Zb is preferably a sulfonate ion, a carboxylate ion, a tetrafluoroborate ion, a hexafluorophosphate ion, a p-toluenesulfonate ion, or a perchlorate ion, and more preferably a tetrafluoroborate ion.

Specific examples of the group represented by Formula 4-1 will be shown below. However, it is not limited thereto. In the following structural formulas, • represents a bonding site with the group represented by L in Formula 1-1.

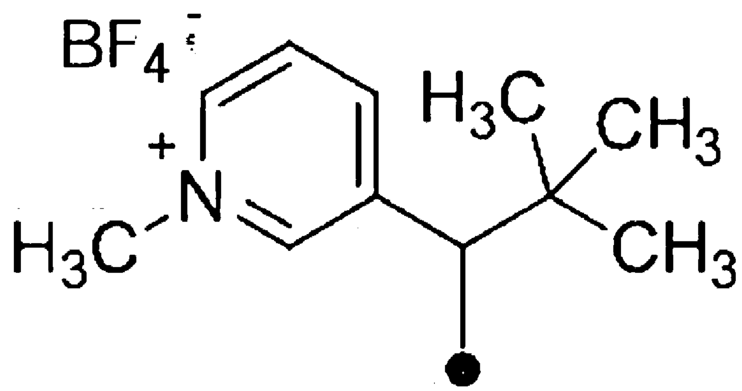

L in Formula 1-1 is preferably an oxygen atom or $-NR^{10}-$, and particularly preferably an oxygen atom.

Furthermore, $R^{10}$ in $-NR^{10}-$ is preferably an alkyl group. The alkyl group represented by $R^{10}$ is preferably an alkyl

group having 1 to 10 carbon atoms. The alkyl group represented by $R^{10}$ may be linear or branched, or may have a ring structure.

Among the alkyl groups, a methyl group or a cyclohexyl group is preferable.

In a case where $R^{10}$ in $-NR^{10}-$ represents an aryl group, the aryl group is preferably an aryl group having 6 to 30 carbon atoms, more preferably an aryl group having 6 to 20 carbon atoms, and even more preferably an aryl group having 6 to 12 carbon atoms. These aryl groups may have a substituent.

In Formula 1-1, $R^{11}$ to $R^{18}$ preferably each independently represent a hydrogen atom, $-R^a$, $-OR^b$, $-SR^c$, or $-NR^dR^e$.

The hydrocarbon group represented by $R^a$ to $R^e$ is preferably a hydrocarbon group having 1 to 30 carbon atoms, more preferably a hydrocarbon group having 1 to 15 carbon atoms, and even more preferably a hydrocarbon group having 1 to 10 carbon atoms.

The hydrocarbon group may be linear or branched or may have a ring structure.

As the hydrocarbon group, an alkyl group is particularly preferable.

The aforementioned alkyl group is preferably an alkyl group having 1 to 30 carbon atoms, more preferably an alkyl group having 1 to 15 carbon atoms, and even more preferably an alkyl group having 1 to 10 carbon atoms.

The alkyl group may be linear or branched, or may have a ring structure.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is preferable.

The above alkyl group may have a substituent.

Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, groups obtained by combining these, and the like.

$R^{11}$ to $R^{14}$ in Formula 1-1 preferably each independently represent a hydrogen atom or $-R^a$ (that is, a hydrocarbon group), more preferably each independently represent a hydrogen atom or an alkyl group, and even more preferably each independently represent a hydrogen atom except in the cases described below.

Particularly, each of $R^{11}$ and $R^{13}$ bonded to the carbon atom that is bonded to the carbon atom to which L is bonded is preferably an alkyl group. It is more preferable that $R^{11}$ and $R^{13}$ be linked to each other to form a ring. The ring to be formed in this way may be a monocyclic or polycyclic ring. Specifically, examples of the ring to be formed include a monocyclic ring such as a cyclopentene ring, a cyclopentadiene ring, a cyclohexene ring, or a cyclohexadiene ring, and a polycyclic ring such as an indene ring or an indole ring.

Furthermore, it is preferable that $R^{12}$ bonded to the carbon atom to which $A_1^+$ is bonded be linked to $R^{15}$ or $R^{16}$ (preferably $R^{16}$) to form a ring, and $R^{14}$ bonded to the carbon atom to which $A_2$ is bonded be linked to $R^{17}$ or $R^{18}$ (preferably $R^{18}$) to form a ring.

In Formula 1-1, $n_{13}$ is preferably 1, and $R^{16}$ is preferably $-R^a$ (that is, a hydrocarbon group).

Furthermore, it is preferable that $R^{16}$ be linked to $R^{12}$ bonded to the carbon atom to which $A_1^+$ is bonded, so as to form a ring. As the ring to be formed, an indolium ring, a pyrylium ring, a thiopyrylium ring, a benzoxazoline ring, or a benzimidazoline ring is preferable, and an indolium ring is more preferable from the viewpoint of improving visibility of exposed portions. These rings may further have a substituent.

In Formula 1-1, $n_{14}$ is preferably 1, and $R^{18}$ is preferably $-R^a$ (that is, a hydrocarbon group).

Furthermore, it is preferable that $R^{18}$ be linked to $R^{14}$ bonded to the carbon atom to which $A_2$ is bonded, so as to form a ring. As the ring to be formed, an indole ring, a pyran ring, a thiopyran ring, a benzoxazole ring, or a benzimidazole ring is preferable, and an indole ring is more preferable from the viewpoint of improving visibility of exposed portions. These rings may further have a substituent.

It is preferable that $R^{16}$ and $R^{18}$ in Formula 1-1 be the same group. In a case where $R^{16}$ and $R^{18}$ each form a ring, it is preferable that the formed rings have the same structure except for $A_1^+$ and $A_2$.

It is preferable that $R^{15}$ and $R^{17}$ in Formula 1-1 be the same group. Furthermore, $R^{15}$ and $R^{17}$ are preferably $-R^a$ (that is, a hydrocarbon group), more preferably an alkyl group, and even more preferably a substituted alkyl group.

From the viewpoint of improving water solubility, $R^{15}$ and $R^{17}$ in the compound represented by Formula 1-1 are preferably a substituted alkyl group.

Examples of the substituted alkyl group represented by $R^{15}$ or $R^{17}$ include a group represented by any of Formula (a1) to Formula (a4).

$$-W\left(R^{W0}-O\right)_{n_{W1}}R^{W1} \quad (a1)$$

$$-R^{W2}-CO_2M \quad (a2)$$

$$-R^{W3}-PO_3M_2 \quad (a3)$$

$$-R^{W4}-SO_3M \quad (a4)$$

In Formula (a1) to Formula (a4), $R^{W0}$ represents an alkylene group having 2 to 6 carbon atoms, W represents a single bond or an oxygen atom, and $n_{W1}$ represents an integer of 1 to 45, $R^{W1}$ represents an alkyl group having 1 to 12 carbon atoms or -C(=O)-$R^{W5}$, $R^{W5}$ represents an alkyl group having 1 to 12 carbon atoms, $R^{W2}$ to $R^{W4}$ each independently represent a single bond or an alkylene group having 1 to 12 carbon atoms, and M represents a hydrogen atom, a sodium atom, a potassium atom, or an onium group.

Specific examples of the alkylene group represented by $R^{W0}$ in Formula (a1) include an ethylene group, a n-propylene group, an isopropylene group, a n-butylene group, an isobutylene group, a n-pentylene group, an isopentylene group, a n-hexyl group, an isohexyl group, and the like. Among these, an ethylene group, a n-propylene group, an isopropylene group, or a n-butylene group is preferable, and a n-propylene group is particularly preferable.

$n_{W1}$ is preferably 1 to 10, more preferably 1 to 5, and particularly preferably 1 to 3.

Specific examples of the alkyl group represented by $R^{W1}$ include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a n-octyl group, a n-dodecyl group, and the like. Among these, a methyl group, an ethyl group, a n-propyl group, an isopropyl group, a n-butyl group, or a tert-butyl group is preferable, a methyl group or an ethyl group is more preferable, and a methyl group is particularly preferable.

The alkyl group represented by $R^{W5}$ is the same as the alkyl group represented by $R^{W1}$. Preferred aspects of the alkyl group represented by $R^{W5}$ are the same as preferred aspects of the alkyl group represented by $R^{W1}$.

Specific examples of the group represented by Formula (a1) will be shown below. However, it is not limited thereto. In the following structural formulas, Me represents a methyl group, Et represents an ethyl group, and * represents a bonding site.

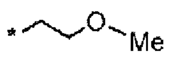 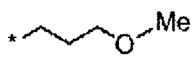 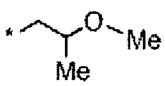 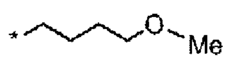 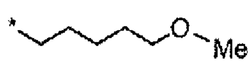

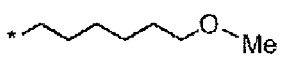 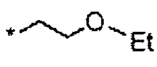 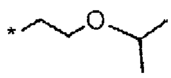 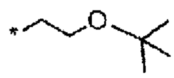

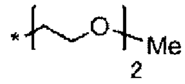 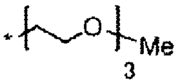 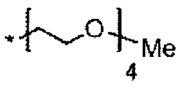 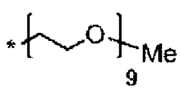 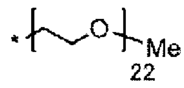

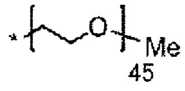 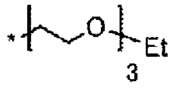 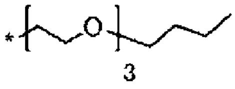 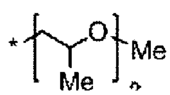 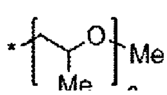

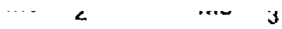

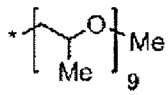

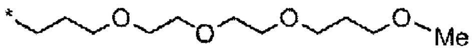

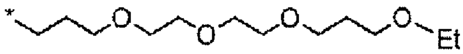

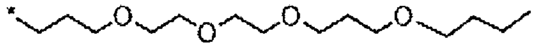

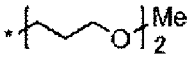

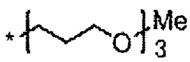

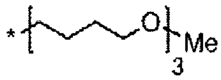

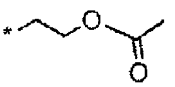

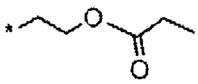

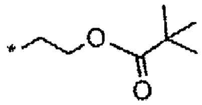

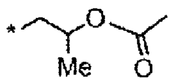

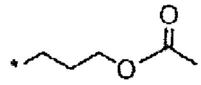

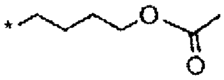

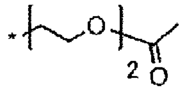

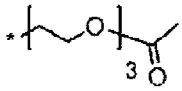

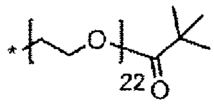

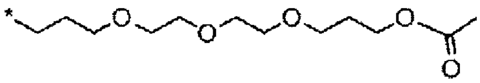

Specific examples of the alkylene group represented by $R^{W2}$ to $R^{W4}$ in Formula (a2) to Formula (a4) include a methylene group, an ethylene group, a n-propylene group, an isopropylene group, a n-butylene group, an isobutylene group, a n-pentylene group, an isopentylene group, a n-hexyl group, an isohexyl group, a n-octylene group, a n-dodecylene group, and the like. Among these, an ethylene group, a n-propylene group, an isopropylene group, or a n-butylene group is preferable, and an ethylene group or a n-propylene group is particularly preferable.

In Formula (a3), two Ms may be the same as or different from each other.

Examples of the onium group represented by M in Formula (a2) to Formula (a4) include an ammonium group, an iodonium group, a phosphonium group, a sulfonium group, and the like.

All of $CO_2M$ in Formula (a2), $PO_3M_2$ in Formula (a2), and $SO_3M$ in Formula (a4) may have an anion structure from which M is dissociated. The countercation of the anion structure may be $A_1^+$ or a cation that can be contained in $R^1$-L in Formula 1-1.

Among the groups represented by Formula (a1) to Formula (a4), the group represented by Formula (a1), Formula (a2), or Formula (a4) is preferable.

$n_{11}$ and $n_{12}$ in Formula 1-1 are preferably the same as each other, and preferably both represent an integer of 1 to 5, more preferably both represent an integer of 1 to 3, even more preferably both represent 1 or 2, and particularly preferably both represent 2.

$A_1$ and $A_2$ in Formula 1-1 each independently represent an oxygen atom, a sulfur atom, or a nitrogen atom. Among these, a nitrogen atom is preferable.

$A_1$ and $A_2$ in Formula 1-1 are preferably the same atoms.

Za in Formula 1-1 represents a counterion that neutralizes charge.

In a case where all of $R^{11}$ to $R^{18}$ and $R^1$-L are groups having a neutral charge, Za is a monovalent counteranion. Here, $R^{11}$ to $R^{18}$ and $R^1$-L may have an anion structure or a cation structure. For example, in a case where two or more among $R^{11}$ to $R^{18}$ and $R^1$-L have an anion structure, Za can also be a countercation.

In a case where the cyanine dye represented by Formula 1-1 has such a structure that the overall charge of the compound is neutral except for Za, Za is unnecessary.

In a case where Za is a counteranion, examples thereof include a sulfonate ion, a carboxylate ion, a tetrafluoroborate ion, a hexafluorophosphate ion, a p-toluenesulfonate ion, a perchlorate ion, and the like. Among these, a tetrafluoroborate ion is preferable.

In a case where Za is a countercation, examples thereof include an alkali metal ion, an alkaline earth metal ion, an ammonium ion, a pyridinium ion, a sulfonium ion, and the like. Among these, a sodium ion, a potassium ion, an ammonium ion, a pyridinium ion, or a sulfonium ion is preferable, and a sodium ion, a potassium ion, or an ammonium ion is more preferable.

From the viewpoint of improving visibility of exposed portions, the decomposable compound is more preferably a compound represented by Formula 1-2 (that is, a cyanine dye).

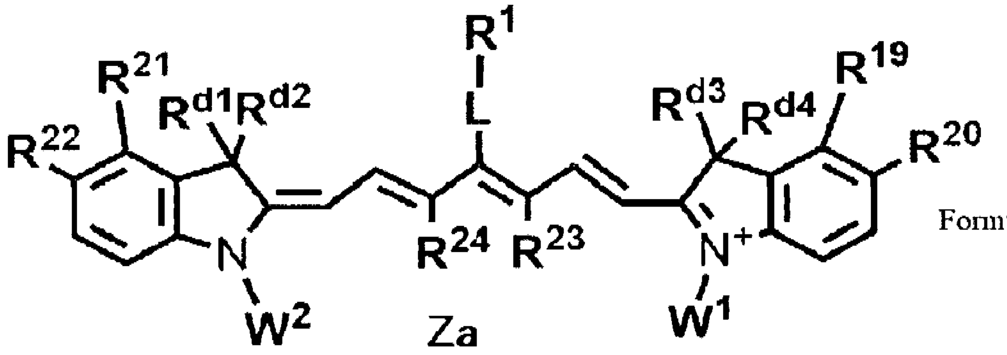

Formula 1-2

In Formula 1-2, $R^1$ represents a group that is represented by any of Formula 2-1 to Formula 4-1, $R^{19}$ to $R^{22}$ each independently represent a hydrogen atom, a halogen atom, $-R^a$, $-OR^b$, -CN, $-SR^c$, or $-NR^dR^e$, $R^{23}$ and $R^{24}$ each independently represent a hydrogen atom or $-R^a$, $R^a$ to $R^e$ each independently represent a hydrocarbon group, $R^{19}$ and $R^{20}$, $R^{21}$ and $R^{22}$, or $R^{23}$ and $R^{24}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge.

$R^1$ in Formula 1-2 has the same definition as $R^1$ in Formula 1-1, and preferred aspects thereof are also the same.

In Formula 1-2, $R^{19}$ to $R^{22}$ preferably each independently represent a hydrogen atom, a halogen atom, $-R^a$, $-OR^b$, or -CN.

More specifically, $R^{19}$ and $R^{21}$ are preferably a hydrogen atom or $-R^a$.

Furthermore, $R^{20}$ and $R^{22}$ are preferably a hydrogen atom, $-R^a$, $-OR^b$, or -CN.

$-R^a$ represented by $R^{19}$ to $R^{22}$ is preferably an alkyl group or an alkenyl group.

In a case where all of $R^{19}$ to $R^{22}$ are $-R^a$, it is preferable that $R^{19}$ and $R^{20}$ and $R^{21}$ and $R^{22}$ be linked to each other to form a monocyclic or polycyclic ring.

Examples of the ring formed of $R^{19}$ and $R^{20}$ or $R^{21}$ and $R^{22}$ linked to each other include a benzene ring, a naphthalene ring, and the like.

$R^{23}$ and $R^{24}$ in Formula 1-2 are preferably linked to each other to form a monocyclic or polycyclic ring.

The ring formed of $R^{23}$ and $R^{24}$ linked to each other may be a monocyclic or polycyclic ring. Specifically, examples of the ring to be formed include a monocyclic ring such as a cyclopentene ring, a cyclopentadiene ring, a cyclohexene ring, or a cyclohexadiene ring, and a polycyclic ring such as an indene ring.

$R^{d1}$ to $R^{d4}$ in Formula 1-2 are preferably an unsubstituted alkyl group. Furthermore, all of $R^{d1}$ to $R^{d4}$ are preferably the same group.

Examples of the unsubstituted alkyl group include unsubstituted alkyl groups having 1 to 4 carbon atoms. Among these, a methyl group is preferable.

From the viewpoint of improving water solubility of the compound represented by Formula 1-2, $W^1$ and $W^2$ in Formula 1-2 preferably each independently represent a substituted alkyl group.

Examples of the substituted alkyl group represented by $W^1$ and $W^2$ include a group represented by any of Formula (a1) to Formula (a4) in Formula 1-1, and preferred aspects thereof are also the same.

From the viewpoint of on-press developability, $W^1$ and $W^2$ preferably each independently represent an alkyl group having a substituent. The alkyl group preferably has at least $-(OCH_2CH_2)-$, a sulfo group, a salt of a sulfo group, a carboxy group, or a salt of a carboxy group, as the substituent.

Za represents a counterion that neutralizes charge in the molecule.

In a case where all of $R^{19}$ to $R^{22}$, $R^{23}$ and $R^{24}$, $R^{d1}$ to $R^{d4}$, $W^1$, $W^2$, and $R^1$-L are groups having a neutral charge, Za is a monovalent counteranion. Here, $R^{19}$ to $R^{22}$, $R^{23}$ and $R^{24}$, $R^{d1}$ to $R^{d4}$, $W^1$, $W^2$, and $R^1$-L may have an anion structure or a cation structure. For example, in a case where two or more among $R^{19}$ to $R^{22}$, $R^{23}$ and $R^{24}$, $R^{d1}$ to $R^{d4}$, $W^1$, $W^2$, and $R^1$-L have an anion structure, Za can be a countercation.

In a case where the compound represented by Formula 1-2 has such a structure that the overall charge of the compound is neutral except for Za, Za is unnecessary.

Examples of the case where Za is a counteranion are the same as such examples of Za in Formula 1-1, and preferred aspects thereof are also the same. Furthermore, examples of the case where Za is a countercation are the same as such examples of Za in Formula 1-1, and preferred aspects thereof are also the same.

From the viewpoint of decomposition properties and visibility, the cyanine dye as a decomposable compound is

even more preferably a compound represented by any of Formula 1-3 to Formula 1-7.

Particularly, from the viewpoint of decomposition properties and visibility, the cyanine dye is preferably a compound represented by any of Formula 1-3, Formula 1-5, and Formula 1-6.

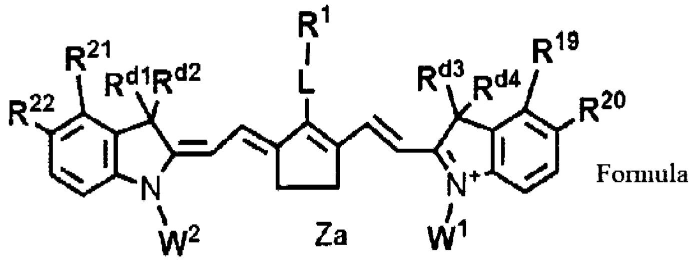

Formula 1-3

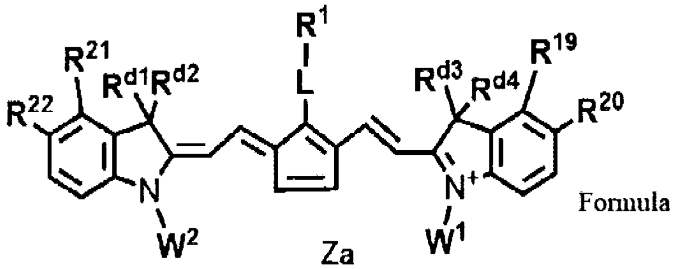

Formula 1-4

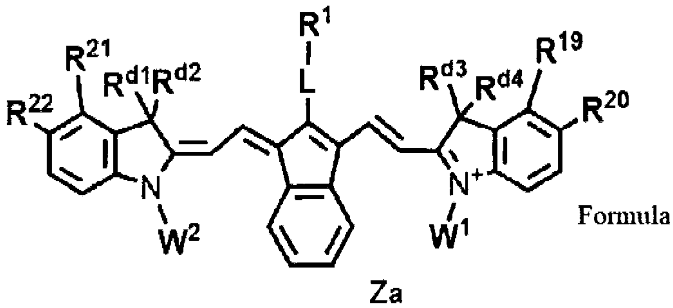

Formula 1-5

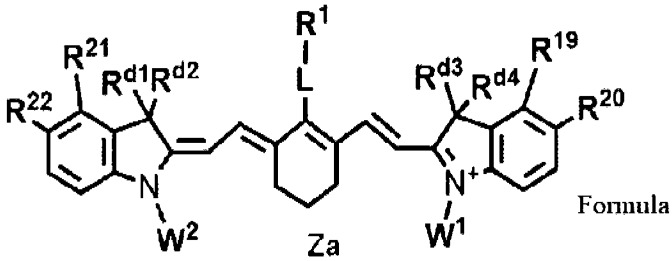

Formula 1-6

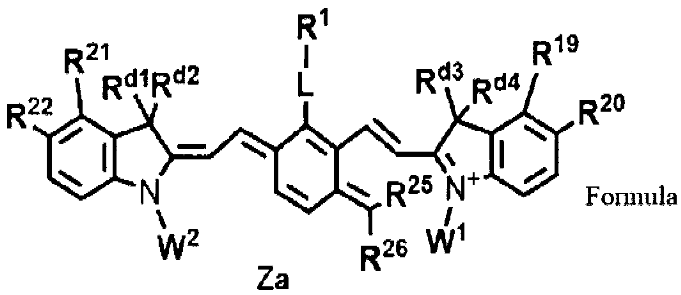

Formula 1-7

In Formula 1-3 to Formula 1-7, $R^1$ represents a group that is represented by any of Formula 2-1 to Formula 4-1, $R^{19}$ to $R^{22}$ each independently represent a hydrogen atom, a halogen atom, $-R^a$, $-OR^b$, -CN, $-SR^c$, or $-NR^dR^e$, $R^{25}$ and $R^{26}$ each independently represent a hydrogen atom, a halogen atom, or $-R^a$, $R^a$ to $R^e$ each independently represent a

hydrocarbon group, $R^{19}$ and $R^{20}$, $R^{21}$ and $R^{22}$, or $R^{25}$ and $R^{26}$ may be linked to each other to form a monocyclic or polycyclic ring, L represents an oxygen atom, a sulfur atom, or $-NR^{10}-$, $R^{10}$ represents a hydrogen atom, an alkyl group, or an aryl group, $R^{d1}$ to $R^{d4}$, $W^1$, and $W^2$ each independently represent an alkyl group which may have a substituent, and Za represents a counterion that neutralizes charge.

$R^1$, $R^{19}$ to $R^{22}$, $R^{d1}$ to $R^{d4}$, $W^1$, $W^2$, and L in Formula 1-3 to Formula 1-7 have the same definitions as $R^1$, $R^{19}$ to $R^{22}$, $R^{d1}$ to $R^{d4}$, $W^1$, $W^2$, and L in Formula 1-2, and preferred aspects thereof are also the same.

$R^{25}$ and $R^{26}$ in Formula 1-7 preferably each independently represent a hydrogen atom or an alkyl group, more preferably each independently represent an alkyl group, and particularly preferably each independently represent a methyl group.

Specific examples of the cyanine dye as a decomposable compound will be shown below. However, it is not limited thereto.

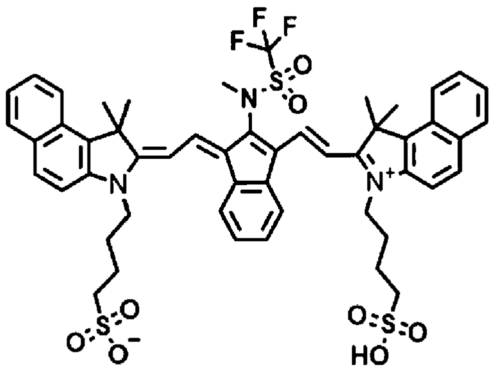
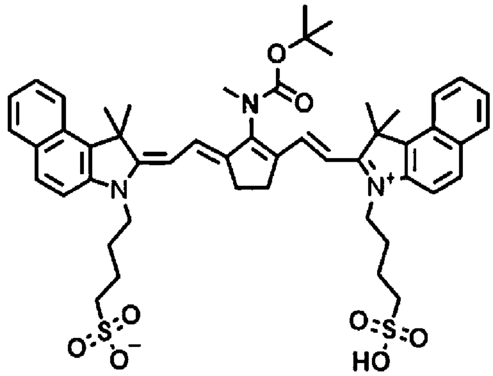

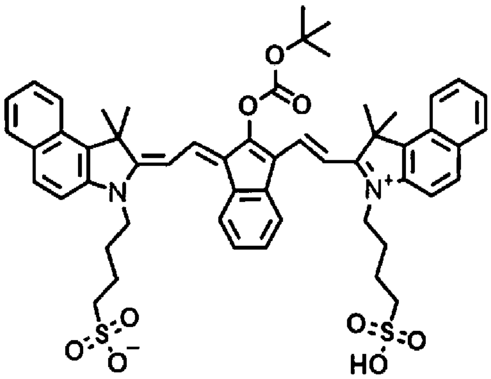
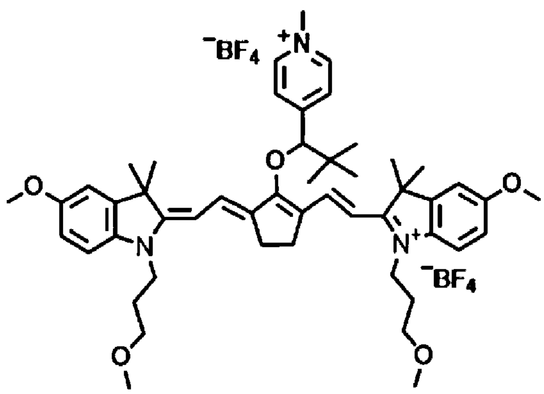

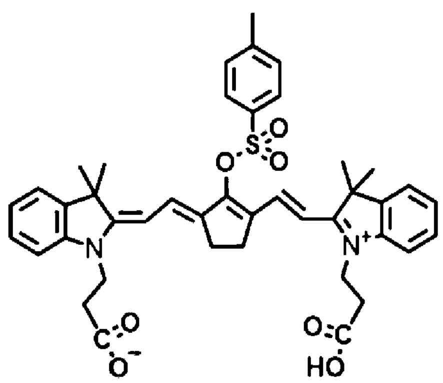
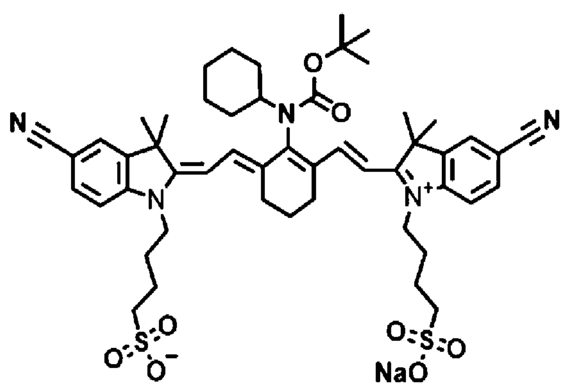

Furthermore, as the cyanine dye which is a decomposable compound, the infrared absorbing compound described in WO2019/219560A can be suitably used.

The discoloring compound preferably includes an acid color developing agent.

As the acid color developing agent, it is possible to use the compounds described above as acid color developing agents in the image-recording layer, and preferred aspects thereof are also the same.

One kind of discoloring compound may be used alone, or two or more kinds of components may be combined and used as the discoloring compound.

As the discoloring compound, the aforementioned decomposable compound and the aforementioned acid generator that may be used in combination.

From the viewpoint of visibility, the content of the discoloring compound in the outermost layer with respect to the total mass of the outermost layer is preferably 0.10% by mass to 50% by mass, more preferably 0.50% by mass to 30% by mass, and even more preferably 1.0% by mass to 20% by mass.

From the viewpoint of visibility, $M^X/M^Y$ which is a ratio of a content $M^X$ of the discoloring compound in the outermost layer to a content $M^Y$ of the infrared absorber in the image-recording layer is preferably 0.1 or more, more preferably 0.2 or more, and particularly preferably 0.3 or more and 3.0 or less.

-Water-soluble polymer-

From the viewpoint of development removability (more preferably on-press developability), the outermost layer preferably contains a water-soluble polymer.

Herein, a water-soluble polymer refers to a polymer that dissolves 1 g or more in 100 g of pure water at 70°C and is not precipitated even though a solution of 1 g of the polymer in 100 g of pure water at 70°C is cooled to 25°C.

Examples of the water-soluble polymer used in the outermost layer include polyvinyl alcohol, modified polyvinyl alcohol, polyvinylpyrrolidone, a water-soluble cellulose derivative, polyethylene glycol, poly(meth)acrylonitrile, and the like.

As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A.

Preferred examples of the water-soluble polymer include polyvinyl alcohol. Particularly, the water-soluble polymer preferably includes polyvinyl alcohol having a saponification degree of 50% or more is more preferable.

The saponification degree is preferably 60% or higher, more preferably 70% or higher, and even more preferably 85% or higher. The upper limit thereof of the saponification degree is not particularly limited, and may be 100% or less.

The saponification degree is measured according to the method described in JIS K 6726: 1994.

Preferred examples of the water-soluble polymer also include polyvinylpyrrolidone. As the water-soluble polymer, it is also preferable to use polyvinyl alcohol and polyvinylpyrrolidone in combination.

One kind of water-soluble polymer may be used alone, or two or more kinds of water-soluble polymers may be used in combination.

In a case where the outermost layer contains a water-soluble polymer, the content of the water-soluble polymer with respect to the total mass of the outermost layer is preferably 1% by mass to 99% by mass, more preferably 3% by mass to 97% by mass, and even more preferably 5% by mass to 95% by mass.

-Oil sensitizing agent-

The outermost layer preferably contains an oil sensitizing agent.

Examples of the oil sensitizing agent include a phosphonium compound, a nitrogen-containing low-molecular-weight compound, an ammonium group-containing polymer, and the like.

As the oil sensitizing agent, it is preferable to use a phosphonium compound, a nitrogen-containing low-molecular-weight compound, and an ammonium group-containing polymer in combination, and it is more preferable to use a phosphonium compound, quaternary ammonium salts, and an ammonium group-containing polymer in combination.

Examples of the phosphonium compound include the phosphonium compounds described in JP2006-297907A and JP2007-50660A. Specific examples thereof include tetrabutylphosphonium iodide, butyltriphenylphosphonium bromide, tetraphenylphosphonium bromide, 1,4-bis(triphenylphosphonio)butane=di(hexafluorophosphate), 1,7-bis(triphenylphosphonio)heptane=sulfate, 1,9-bis(triphenylphosphonio)nonane=naphthalene-2,7-disulfonate, and the like.

Examples of the nitrogen-containing low-molecular-weight compound include amine salts and quaternary ammonium salts. In addition, examples thereof also include imidazolinium salts, benzimidazolinium salts, pyridinium salts, and quinolinium salts. Among these, quaternary ammonium salts and pyridinium salts are preferable. Specific examples thereof include tetramethylammonium=hexafluorophosphate, tetrabutylammonium=hexafluorophosphate, dodecyltrimethylammonium=p-toluenesulfonate, benzyltriethylammonium=hexafluorophosphate, benzyldimethyloctylammonium=hexafluorophosphate, benzyldimethyldodecylammonium=hexafluorophosphate, compounds described in paragraphs "0021" to "0037" of JP2008-284858A and paragraphs "0030" to "0057" of JP2009-90645A, and the like.

The ammonium group-containing polymer may have an ammonium group in the structure. As such a polymer, a polymer is preferable in which the content of (meth)acrylate having an ammonium group in a side chain as a copolymerization component is 5 mol% to 80 mol%. Specific examples thereof include the polymers described in paragraphs "0089" to "0105" of JP2009-208458A.

The reduced specific viscosity (unit: ml/g) of an ammonium salt-containing polymer determined according to the measurement method described in JP2009-208458A is preferably in a range of 5 to 120, more preferably in a range of 10 to 110, and particularly preferably in a range of 15 to 100. **In** a case where the reduced specific viscosity is converted into a weight-average molecular weight (Mw), the weight-average molecular weight is preferably 10,000 to 1,500,000, more preferably 17,000 to 140,000, and particularly preferably 20,000 to 130,000.

Specific examples of the ammonium group-containing polymer will be shown below.

(1) 2-(Trimethylammonio)ethylmethacrylate=p-toluenesulfonate/3,6-dioxaheptylmethacrylate copolymer (molar ratio: 10/90, Mw: 45,000)
(2) 2-(Trimethylammonio)ethylmethacrylate=hexafluorophosphate/3,6-dioxaheptylmethacrylate copolymer (molar ratio: 20/80, Mw: 60,000)
(3) 2-(Ethyldimethylammonio)ethylmethacrylate=p-toluenesulfonate/hexylmethacrylate copolymer (molar ratio: 30/70, Mw: 45,000)
(4) 2-(Trimethylammonio)ethylmethacrylate=hexafluorophosphate/2-ethylhexylmethacrylate copolymer (molar ratio: 20/80, Mw: 60,000)
(5) 2-(Trimethylammonio)ethylmethacrylate=methylsulfate/hexylmethacrylate copolymer (molar ratio: 40/60, Mw: 70,000)
(6) 2-(Butyldimethylammonio)ethylmethacrylate=hexafluorophosphate/3,6-dioxaheptylmethacrylate copolymer (molar ratio: 25/75, Mw: 65,000)
(7) 2-(Butyldimethylammonio)ethylacrylate=hexafluorophosphate/3,6-dioxaheptylmethacrylate copolymer (molar ratio: 20/80, Mw: 65,000)
(8) 2-(Butyldimethylammonio)ethylmethacrylate=13-ethyl-5,8,11-trioxa-1-heptadecanesulfonate/3,6-dioxaheptylmethacrylate copolymer (molar ratio: 20/80, Mw: 75,000)
(9) 2-(Butyldimethylammonio)ethylmethacrylate=hexafluorophosphate/3,6-dioxaheptylmethacrylate/2-hydroxy-3-methacryloyloxypropylmethacrylate copolymer (molar ratio: 15/80/5, Mw: 65,000)

One kind of oil sensitizing agent may be used alone, or two or more kinds of oil sensitizing agents may be used by being mixed together.

The content of the oil sensitizing agent with respect to the total mass of the outermost layer is preferably 0.01% by mass to 30.0% by mass, more preferably 0.1% by mass to 15.0% by mass, and even more preferably 1% by mass to 10% by mass.

-Other components-

The outermost layer may contain other components such as a hydrophobic polymer, an acid generator, and an infrared absorber, in addition to the discoloring compound and water-soluble polymer described above.

Hereinafter, those other components will be described.

<<Hydrophobic polymer>>

The outermost layer preferably contains a hydrophobic polymer.

The hydrophobic polymer refers to a polymer that dissolves less than 1 g or does not dissolve in 100 g of pure water at 70°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these polymers, and the like.

The hydrophobic polymer preferably includes a polyvinylidene chloride resin.

Furthermore, the hydrophobic polymer preferably includes a styrene-acrylic copolymer.

**In** addition, from the viewpoint of on-press developability, the hydrophobic polymer is preferably hydrophobic polymer particles.

One kind of hydrophobic polymer may be used alone, or two or more kinds of hydrophobic polymers may be used in combination.

**In** a case where the outermost layer contains a hydrophobic polymer, the content of the hydrophobic polymer with respect to the total mass of the outermost layer is preferably 1% by mass to 80% by mass, and more preferably 5% by mass

to 50% by mass.

<<Acid generator>>

The outermost layer preferably contains an acid generator as a discoloring compound.
"Acid generator" is a compound that generates an acid by light or heat. Specifically, the acid generator refers to a compound that generates an acid by being decomposed by exposure to infrared.
The acid to be generated is preferably a strong acid having a pKa of 2 or less, such as sulfonic acid or hydrochloric acid. The acid generated from the acid generator enables the acid color developing agent to discolor.
Specifically, as the acid generator, from the viewpoint of sensitivity and stability, an onium salt compound is preferable.
Specific examples of onium salts suitable as the acid generator include the compounds described in paragraphs "0121" to "0124" of WO2016/047392A.
Particularly, sulfonate, carboxylate, $BPh_4^-$, $BF_4^-$, $PF_6^-$, $ClO_4^-$ of triarylsulfonium or diaryliodonium, and the like are preferable. Ph represents a phenyl group.
One kind of acid generator may be used alone, or two or more kinds of acid generators may be used in combination.
In a case where the outermost layer contains an acid generator, the content of the acid generator with respect to the total mass of the outermost layer is preferably 0.5% by mass to 30% by mass, and more preferably 1% by mass to 20% by mass.
The outermost layer may contain known additives such as an oil sensitizing agent, an inorganic lamellar compound, and a surfactant, in addition to the components described above.
The outermost layer is formed by coating by a known method and drying.
The coating amount of the outermost layer (solid content) is preferably 0.01 $g/m^2$ to 10 $g/m^2$, more preferably 0.02 $g/m^2$ to 3 $g/m^2$, and particularly preferably 0.1 $g/m^2$ to 2.0 $g/m^2$.
The film thickness of the outermost layer is preferably 0.1 $\mu$m to 5.0 $\mu$m, and more preferably 0.3 $\mu$m to 4.0 $\mu$m.
The film thickness of the outermost layer is preferably 0.1 times to 5.0 times the film thickness of the image-recording layer that will be described later, and more preferably 0.2 times to 3.0 times the film thickness of the image-recording layer that will be described later.
The outermost layer may contain known additives such as a plasticizer for imparting flexibility, a surfactant for improving coating properties, and inorganic particles for controlling surface sliding properties.

<Support>

The lithographic printing plate precursor according to the present invention preferably has a support.
The support to be used can be appropriately selected from known supports for a lithographic printing plate precursor.
As the support, a support having a hydrophilic surface (hereinafter, also called "hydrophilic support") is preferable.
As the support, an aluminum plate is preferable which has been roughened using a known method and has undergone an anodization treatment. That is, the support preferably has an aluminum plate and an anodic oxide film of aluminum disposed on the aluminum plate.
The aforementioned support preferably has an aluminum plate and an anodic oxide film of aluminum disposed on the aluminum plate, the anodic oxide film is preferably at a position closer to a side of the image-recording layer than the aluminum plate and preferably has micropores extending in a depth direction from the surface of the anodic oxide film on the side of the image-recording layer, and the average diameter of the micropores within the surface of the anodic oxide film is preferably more than 10 nm and 100 nm or less.
Furthermore, the micropores are preferably each composed of a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position, an average diameter of the large diameter portion within the surface of the anodic oxide film is preferably 15 nm to 100 nm, and an average diameter of the small diameter portion at the communicate position is preferably 13 nm or less.
Fig. 1 is a schematic cross-sectional view of an embodiment of an aluminum support 12a.
The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned such that the anodic oxide film 20a is closer to the image-recording layer side than the aluminum plate 18. That is, it is preferable that the lithographic printing plate precursor have at least an anodic oxide

film, an image-recording layer, and a water-soluble resin layer in this order on an aluminum plate.

-Anodic oxide film-

Hereinafter, preferred aspects of the anodic oxide film 20a will be described.
The anodic oxide film 20a is a film prepared on a surface of the aluminum plate 18 by an anodization treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18) along the thickness direction (toward the aluminum plate 18).
The average diameter (average opening diameter) of the micropores 22a within the surface of the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 nm to 40 nm. The internal diameter of the pores may be larger or smaller than the pore diameter within the surface layer.
In a case where the average diameter is more than 10 nm, printing durability and image visibility are excellent. Furthermore, in a case where the average diameter is 100 nm or less, printing durability is excellent.
The average diameter of the micropores 22a is a value determined by observing the surface of the anodic oxide film 20a with a field emission scanning electron microscope (FE-SEM) at 150,000X magnification (N = 4), measuring the size (diameter) of 50 micropores existing in a range of 400 nm $\times$ 600 $nm^2$ in the obtained 4 images, and calculating the arithmetic mean thereof.
In a case where the shape of the micropores 22a is not circular, the equivalent circular diameter is used. "Equivalent circular diameter" is a diameter determined on an assumption that the opening portion is in the form of a circle having the same projected area as the projected area of the opening portion.
The shape of the micropores 22a is not particularly limited. In Fig. 1, the micropores 22a have a substantially straight tubular shape (substantially cylindrical shape). However, the micropores 22a may have a conical shape that tapers along the depth direction (thickness direction). The shape of the bottom portion of the micropores 22a is not particularly limited, and may be a curved (convex) or planar surface shape.
In the support (1), the micropores may be each composed of a large diameter portion that extends to a position at a certain depth from the surface of the anodic oxide film and a small diameter portion that is in communication with a bottom portion of the large diameter portion and extends to a position at a certain depth from the communicate position.
For example, as shown in Fig. 2, an aspect may be adopted in which an aluminum support 12b includes an aluminum plate 18 and an anodic oxide film 20b having micropores 22b each composed of a large diameter portion 24 and a small diameter portion 26.
For example, the micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communicate position to a position at a depth of 20 nm to 2,000 nm. Specifically, for example, it is possible to use the aspect described in paragraphs "0107" to "0114" of JP2019-162855A.

-Manufacturing method of support-

As a manufacturing method of the support, for example, a manufacturing method is preferable in which the following steps are sequentially performed.

- ·Roughening treatment step: step of performing roughening treatment on aluminum plate
- ·Anodization treatment step: step of subjecting aluminum plate having undergone roughening treatment to anodization
- ·Pore widening treatment step: step of bringing aluminum plate having anodic oxide film obtained by anodization treatment step into contact with aqueous acid solution or aqueous alkali solution such that diameter of micropores in anodic oxide film increases

Hereinafter, the procedure of each step will be specifically described.

<<Roughening treatment step>>

The roughening treatment step is a step of performing a roughening treatment including an electrochemical roughening treatment on the surface of the aluminum plate. This step is preferably performed before the anodization treatment step which will be described later. However, in a case where the surface of the aluminum plate already has a

preferable shape, the roughening treatment step may not be performed. This step can be carried out by the method described in paragraphs "0086" to "0101" of JP2019-162855A.

<<Anodization treatment step>>

The procedure of the anodization treatment step is not particularly limited as long as the aforementioned micropores can be obtained. Examples thereof include known methods.

In the anodization treatment step, an aqueous solution of sulfuric acid, phosphoric acid, oxalic acid, or the like can be used as an electrolytic cell. For example, the concentration of sulfuric acid is 100 g/L to 300 g/L.

The conditions of the anodization treatment are appropriately set depending on the electrolytic solution used. For example, the liquid temperature is 5°C to 70°C (preferably 10°C to 60°C), the current density is 0.5 A/dm$^2$ to 60 A/dm$^2$ (preferably 1 A/dm$^2$ to 60 A/dm$^2$), the voltage is 1 V to 100 V (preferably 5 V to 50 V), the electrolysis time is 1 second to 100 seconds (preferably 5 seconds to 60 seconds), and the film amount is 0.1 g/m$^2$ to 5 g/m$^2$ (preferably 0.2 g/m$^2$ to 3 g/m$^2$).

<<Pore widening treatment>>

The pore widening treatment is a treatment of enlarging the diameter of micropores (pore diameter) present in the anodic oxide film formed by the aforementioned anodization treatment step (pore diameter enlarging treatment).

The pore widening treatment can be carried out by bringing the aluminum plate obtained by the anodization treatment step into contact with an aqueous acid solution or an aqueous alkali solution. The contact method is not particularly limited, and examples thereof include a dipping method and a spraying method.

As necessary, the support may have a backcoat layer on the side opposite to the image-recording layer, the backcoat layer containing the organic polymer compound described in JP1993-45885A (JP-H5-45885A) or the alkoxy compound of silicon described in JP1994-35174A (JP-H6-35174A).

<Undercoat layer>

The lithographic printing plate precursor according to the present invention preferably has an undercoat layer (also called interlayer in some cases) between the image-recording layer and the support. The undercoat layer enhances the adhesion between the support and the image-recording layer in an exposed portion, and enables the image-recording layer to be easily peeled from the support in a non-exposed portion. Therefore, the undercoat layer contributes to the improvement of developability without deteriorating printing durability. Furthermore, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent group that can be adsorbed onto the surface of the support and hydrophilic groups. **In** order to improve adhesiveness to the image-recording layer, polymers having adsorbent groups and hydrophilic groups plus crosslinking groups are preferable. The compounds that are used in the undercoat layer may be low-molecular-weight compounds or polymers. As necessary, as the compounds that are used in the undercoat layer, two or more kinds of compounds may be used by being mixed together.

**In** a case where the compound used in the undercoat layer is a polymer, a copolymer of a monomer having an adsorbent group, a monomer having a hydrophilic group, and a monomer having a crosslinking group is preferable.

As the adsorbent group that can be adsorbed onto the surface of the support, a phenolic hydroxyl group, a carboxy group, $-PO_3H_2$, $-OPO_3H_2$, $-CONHSO_2-$, $-SO_2NHSO_2-$, and - $COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinking groups described in JP2005-125749A and JP2006-188038A

are more preferable.

The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more, and more preferably 10,000 to 300,000.

-Hydrophilic compound-

From the viewpoint of developability, it is preferable that the undercoat layer contain a hydrophilic compound.

The hydrophilic compound is not particularly limited, and known hydrophilic compounds used for the undercoat layer can be used.

Preferred examples of the hydrophilic compound include phosphonic acids having an amino group such as carboxymethyl cellulose and dextrin, an organic phosphonic acid, an organic phosphoric acid, an organic phosphinic acid, amino acids, a hydrochloride of an amine having a hydroxy group, and the like.

In addition, examples of preferable hydrophilic compounds include a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, ethylenediaminetetraacetic acid (EDTA) or a salt thereof, hydroxyethyl ethylenediaminetriacetic acid or a salt thereof, dihydroxyethyl ethylenediaminediacetic acid or a salt thereof, hydroxyethyl iminodiacetic acid or a salt thereof, and the like).

From the viewpoint of scratch and contamination suppressiveness, it is preferable that the hydrophilic compound include hydroxycarboxylic acid or a salt thereof.

Furthermore, from the viewpoint of scratch and contamination suppressiveness, it is preferable that the hydrophilic compound, which is preferably hydroxycarboxylic acid or a salt thereof, be contained in a layer on the aluminum support. The layer on the aluminum support is preferably a layer on the side where the image-recording layer is formed or a layer in contact with the aluminum support.

Preferred examples of the layer on the aluminum support include a layer in contact with the aluminum support, such as the undercoat layer or the image-recording layer. Furthermore, a layer other than the layer in contact with the aluminum support, for example, the protective layer or the image-recording layer may contain a hydrophilic compound and preferably contains hydroxycarboxylic acid or a salt thereof.

In the lithographic printing plate precursor, from the viewpoint of scratch and contamination suppressiveness, it is preferable that the image-recording layer contain hydroxycarboxylic acid or a salt thereof.

Moreover, regarding the lithographic printing plate precursor, for example, an aspect is also preferable in which the surface of the aluminum support on the image-recording layer side is treated with a composition (for example, an aqueous solution or the like) containing at least hydroxycarboxylic acid or a salt thereof. In a case where the above aspect is adopted, at least some of the hydroxycarboxylic acid or a salt thereof used for treatment can be detected in a state of being contained in the layer on the image-recording layer side (for example, the image-recording layer or the undercoat layer) that is in contact with the aluminum support.

In a case where the layer on the side of the image-recording layer that is in contact with the aluminum support, such as the undercoat layer, contains hydroxycarboxylic acid or a salt thereof, the surface of the aluminum support on the image-recording layer side can be hydrophilized, and it is easy for the surface of the aluminum support on the image-recording layer side to have a water contact angle of 110° or less measured by an airborne water droplet method, which result in excellent scratch and contamination suppressiveness.

"Hydroxycarboxylic acid" is the generic term for organic compounds having one or more carboxy groups and one or more hydroxy groups in one molecule. These compounds are also called hydroxy acid, oxy acid, oxycarboxylic acid, or alcoholic acid (see Iwanami Dictionary of Physics and Chemistry, 5th Edition, published by Iwanami Shoten, Publishers. (1998)).

The hydroxycarboxylic acid or a salt thereof is preferably represented by Formula (HC).

$$R^{HC}(OH)_{mhc}(COOM^{HC})_{nhc} \qquad \text{Formula (HC)}$$

In Formula (HC), $R^{HC}$ represents an (mhc + nhc)-valent organic group, $M^{HC}$ each independently represent a hydrogen atom, an alkali metal, or an onium, and mhc and nhc each independently represent an integer of 1 or more. In a case where n is 2 or more, Ms may be the same as or different from each other.

Examples of the (mhc + nhc)-valent organic group represented by $R^{HC}$ in Formula (HC) include an (mhc + nhc)-valent hydrocarbon group and the like. The hydrocarbon group may have a substituent and/or a linking group.

Examples of the hydrocarbon group include an (mhc + nhc)-valent group derived from aliphatic hydrocarbon, such as an alkylene group, an alkanetriyl group, an alkanetetrayl group, an alkanepentayl group, an alkenylene group, an alkenetriyl group, an alkenetetrayl group, and alkenepentayl group, an alkynylene group, an alkynetriyl group, alkynetetrayl group, or an alkynepentayl group, an (mhc + nhc)-valent group derived from aromatic hydrocarbon, such as an arylene group, an arenetriyl group, an arenetetrayl group, or an arenepentayl group, and the like. Examples of the substituent include an alkyl group, an alkenyl group, an alkynyl group, an aralkyl group, an aryl group, and the like. Specific examples of the substituent include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, eicosyl group, isopropyl group, isobutyl group, s-butyl group, t-butyl group, isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group, a phenoxycarbonylphenyl group, and the like. Furthermore, the linking group is composed of at least one atom selected from the group consisting of a hydrogen atom, a carbon atom, an oxygen atom, a nitrogen atom, a sulfur atom, and a halogen atom, and the number of atoms is preferably 1 to 50. Specific examples thereof include an alkylene group, a substituted alkylene group, an arylene group, a substituted arylene group, and the like. The linking group may have a structure in which a plurality of these divalent groups is linked through any of an amide bond, an ether bond, a urethane bond, a urea bond, and an ester bond.

Examples of the alkali metal represented by $M^{HC}$ include lithium, sodium, potassium, and the like. Among these, sodium is particularly preferable. Examples of the onium include ammonium, phosphonium, sulfonium, and the like. Among these, ammonium is particularly preferable.

From the viewpoint of scratch and contamination suppressiveness, $M^{HC}$ is preferably an alkali metal or an onium, and more preferably an alkali metal.

The sum of mhc and nhc is preferably 3 or more, more preferably 3 to 8, and even more preferably 4 to 6.

The molecular weight of the hydroxycarboxylic acid or a salt thereof is preferably 600 or less, more preferably 500 or less, and particularly preferably 300 or less. The molecular weight is preferably 76 or more.

Specifically, examples of the hydroxycarboxylic acid constituting the hydroxycarboxylic acid or a salt of the hydroxycarboxylic acid include gluconic acid, glycolic acid, lactic acid, tartronic acid, hydroxybutyrate (such as 2-hydroxybutyrate, 3-hydroxybutyrate, or $\gamma$-hydroxybutyrate), malic acid, tartaric acid, citramalic acid, citric acid, isocitric acid, leucine acid, mevalonic acid, pantoic acid, ricinoleic acid, ricineraidic acid, cerebronic acid, quinic acid, shikimic acid, a monohydroxybenzoic acid derivative (such as salicylic acid, creosotic acid (homosalicylic acid, hydroxy(methyl) benzoate), vanillic acid, or syringic acid), a dihydroxybenzoic acid derivative (such as pyrocatechuic acid, resorcylic acid, protocatechuic acid, gentisic acid, or orsellinic acid), a trihydroxybenzoic acid derivative (such as gallic acid), a phenyl acetate derivative (such as mandelic acid, benzilic acid, or atrolactic acid), a hydrocinnamic acid derivative (such as melilotic acid, phloretic acid, coumaric acid, umbellic acid, caffeic acid, ferulic acid, sinapic acid, cerebronic acid, or carminic acid), and the like.

Among these, as the aforementioned hydroxycarboxylic acid or a hydroxycarboxylic acid constituting a salt of the hydroxycarboxylic acid, from the viewpoint of scratch and contamination suppressiveness, a compound having two or more hydroxy groups is preferable, a compound having 3 or more hydroxy groups is more preferable, a compound having 5 or more hydroxy groups is even more preferable, and a compound having 5 to 8 hydroxy groups is particularly preferable.

Furthermore, as a hydroxycarboxylic acid having one carboxy group and two or more hydroxy groups, gluconic acid or shikimic acid is preferable.

As hydroxycarboxylic acid having two or more carboxy groups and one hydroxy group, citric acid or malic acid is preferable.

As hydroxycarboxylic acid having two or more carboxy groups and two or more hydroxy groups, tartaric acid is preferable.

Among these, gluconic acid is particularly preferable as the aforementioned hydroxycarboxylic acid.

One kind of hydrophilic compound may be used alone, or two or more kinds of hydrophilic compounds may be used in combination.

**In** a case where the undercoat layer contains a hydrophilic compound, which is preferably hydroxycarboxylic acid or a salt thereof, the content of the hydrophilic compound, which is preferably hydroxycarboxylic acid or a salt thereof, with respect to the total mass of the undercoat layer is preferably 0.01% by mass to 50% by mass, more preferably 0.1% by mass to 40% by mass, and particularly preferably 1.0% by mass to 30% by mass.

**In** order to prevent contamination over time, the undercoat layer may contain a chelating agent, a secondary or tertiary amine, a polymerization inhibitor, and the like, in addition to the following compounds for an undercoat layer.

The undercoat layer is formed by known coating methods.

The coating amount (solid content) of the undercoat layer is preferably 0.1 $mg/m^2$ to 300 $mg/m^2$, and more preferably 5 $mg/m^2$ to 200 $mg/m^2$.

The lithographic printing plate precursor according to the present invention may have other layers in addition to those described above.

Known layers can be adopted as those other layers without particular limitations. For example, as necessary, a backcoat layer may be provided on a surface of the support that is opposite to the image-recording layer side.

<Method of preparing lithographic printing plate and lithographic printing method>

The method of preparing a lithographic printing plate by using the lithographic printing plate precursor of the present invention is not particularly limited, but preferably includes a step of exposing the lithographic printing plate precursor according to the present invention in the shape of an image (exposure step) and a step of removing the image-recording layer having undergone exposure in a non-image area by supplying at least one material selected from the group consisting of a printing ink and dampening water on a printer (on-press development step).

The lithographic printing method using the lithographic printing plate precursor of the present invention preferably includes a step of exposing the lithographic printing plate precursor in the shape of an image (exposure step), a step of removing the image-recording layer in a non-image area by supplying at least one material selected from the group consisting of a printing ink and dampening water on a printer such that a lithographic printing plate is prepared (on-press development step), and a step of performing printing by using the obtained lithographic printing plate (hereinafter, also called "printing step").

<Exposure step>

The method of preparing a lithographic printing plate by using the lithographic printing plate precursor of the present invention preferably includes an exposure step of exposing the lithographic printing plate precursor in the shape of an image such that an exposed portion and a non-exposed portion are formed. The lithographic printing plate precursor according to the present invention is preferably exposed to a laser through a transparent original picture having a linear image, a halftone dot image, or the like or exposed in the shape of an image by laser light scanning according to digital data or the like.

The wavelength of a light source to be used is preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any one of an in-plane drum method, an external surface drum method, a flat head method, or the like.

The image exposure can be carried out by a common method using a platesetter or the like. In the case of on-press development, image exposure may be carried out on a printer after the lithographic printing plate precursor is mounted on the printer.

<On-press development step>

The method of preparing a lithographic printing plate by using the lithographic printing plate precursor of the present invention preferably includes an on-press development step of removing the image-recording layer in a non-image area by supplying at least one selected from the group consisting of printing ink and dampening water on a printer.

Hereinafter, the on-press development method will be described.

[On-press development method]

In the on-press development method, the lithographic printing plate precursor having undergone image exposure is preferably supplied with an oil-based ink and an aqueous component on a printer, such that the image-recording layer in a non-image area is removed and a lithographic printing plate is prepared.

That is, in a case where the lithographic printing plate precursor is subjected to image exposure and then directly mounted on a printer without being subjected to any development treatment, or in a case where the lithographic printing plate precursor is mounted on a printer, then subjected to image exposure on the printer, and then supplied with an oil-based ink and an aqueous component for printing, at the initial stage in the middle of printing, in a non-image area, a non-cured image-recording layer is removed by either or both of the supplied oil-based ink and the aqueous component by means of dissolution or dispersion, and the hydrophilic surface is exposed in the non-image area. On the other hand, in an exposed portion, the image-recording layer cured by exposure forms an oil-based ink-receiving portion having a lipophilic

surface. What is supplied first to the surface of the plate may be any of the oil-based ink or the aqueous component. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

As the laser used for performing image exposure on the lithographic printing plate precursor using the lithographic printing plate precursor of the present invention, a light source having a wavelength of 750 nm to 1,400 nm is preferably used. As the light source having a wavelength of 750 nm to 1,400 nm, the light sources described above are preferably used.

<Printing step>

The lithographic printing method using the lithographic printing plate precursor of the present invention includes a printing step of printing a recording medium by supplying a printing ink to a lithographic printing plate.

The printing ink is not particularly limited, and various known inks can be used as desired. In addition, preferable examples of the printing ink include oil-based ink or ultraviolet-curable ink (UV ink).

In the printing step, as necessary, dampening water may be supplied.

Furthermore, the printing step may be successively carried out after the on-press development step or the development step using a developer, without stopping the printer.

The recording medium is not particularly limited, and known recording media can be used as desired.

In the method of preparing a lithographic printing plate and the lithographic printing method using the lithographic printing plate precursor of the present invention, as necessary, the entire surface of the lithographic printing plate precursor may be heated as necessary before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

Examples

Hereinafter, the present invention will be specifically described based on examples, but the present invention is not limited thereto. In the present examples, unless otherwise specified, "%" and "part" mean "% by mass" and "part by mass" respectively. Unless otherwise described, the molecular weight of a polymer compound is a weight-average molecular weight (Mw), and the ratio of repeating structural units of a polymer compound is expressed as molar percentage. The weight-average molecular weight (Mw) is a polystyrene-equivalent molecular weight measured by gel permeation chromatography (GPC).

(Examples 1 to 27 and Comparative Examples 1 to 12)

<Preparation of supports A and B>

<<Treatment (A)>>

(A-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 $g/m^2$.

(A-b) Desmutting treatment using aqueous acidic solution (first desmutting treatment)

Next, a desmutting treatment was performed using an aqueous acidic solution. In the desmutting treatment, a 150 g/L aqueous sulfuric acid solution was used as the aqueous acidic solution. The liquid temperature was 30°C. The

desmutting treatment was performed for 3 seconds by spraying the aqueous acidic solution onto the aluminum plate. Then, a rinsing treatment was performed.

(A-c) Electrochemical roughening treatment

Next, an electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1: 1, and the current density was 75 $A/dm^2$ in terms of the peak current value of the alternating current waveform. In addition, the quantity of electricity was 450 $C/dm^2$ which was the total quantity of electricity used for the aluminum plate to have an anodic reaction, and the electrolysis treatment was performed 4 times by conducting electricity of 112.5 $C/dm^2$ for 4 seconds at each treatment session. A carbon electrode was used as the counter electrode of the aluminum plate. Then, a rinsing treatment was performed.

(A-d) Alkaline etching treatment

An aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 $g/m^2$. Then, a rinsing treatment was performed.

(A-e) Desmutting treatment using aqueous acidic solution

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 30°C.

(A-f) First-stage anodization treatment

By using the anodization device for direct current electrolysis having the structure shown in Fig. 3, a one-stage anodization treatment was performed. The anodization treatment was performed under the conditions described in the column of "First anodization treatment" shown in Table 1, thereby forming an anodic oxide film having a predetermined film amount.

(A-g) Pore widening treatment

The aluminum plate having undergone the above anodization treatment was immersed in an aqueous solution of caustic soda at a temperature of 40°C and having a caustic soda concentration of 5% by mass and an aluminum ion concentration of 0.5% by mass under the time conditions shown in Table 1, thereby performing a pore widening treatment. Then, rinsing was performed by means of spraying.

(A-h) Second-stage anodization treatment

By using the anodization device for direct current electrolysis having the structure shown in Fig. 3, a second-stage anodization treatment was performed. The anodization treatment was performed under the conditions described in the column of "Second anodization treatment" shown in Table 1, thereby forming an anodic oxide film having a predetermined film amount. As shown in Table 1, in the surface treatment B, the second-stage anodization treatment was not performed.

[Table 1]

| Support | Surface treatment | First anodization treatment | | | | | | | Pore widening treatment | | |
|---|---|---|---|---|---|---|---|---|---|---|---|
| | | Liquid type | Liquid component | Component concentration (g/L) | Temperature (°C) | Current density (Å/dm$^2$) | Time (s) | Film amount (g/m$^2$) | Liquid component | Temperature (°C) | **Time** (s) |
| Support A | A | Phosphoric acid | $H_3PO_4$ | 15 | 35 | 4.5 | 12 | 1.0 | NaOH5%/Al 0.5% | 40 | 3 |
| Support B | B | Sulfuric acid | $H_2SO_4$/Al | 170/5 | 50 | 30 | 18 | 2.4 | NaOH5%/Al 0.5% | 40 | 3 |

| Support | Surface treatment | Second anodization treatment | | | | | | |
|---|---|---|---|---|---|---|---|---|
| | | Liquid type | Liquid component | Component concentration (g/L) | Temperature (°C) | Current density (Å/dm$^2$) | **Time** (s) | Film amount (g/m$^2$) |
| Support A | A | | $H_2SO_4$/Al | 170/5 | 50 | 15 | 10.5 | 1.4 |
| Support B | B | - | - | - | - | - | - | - |

<Preparation of support C>

<<Treatment (C)>>

-Alkaline etching treatment-

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 g/m$^2$.

-Desmutting treatment using aqueous acidic solution (first desmutting treatment)-

Next, a desmutting treatment was performed using an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Electrochemical roughening treatment-

Next, an electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/dm$^2$ in terms of the peak current value of the alternating current waveform. In addition, the quantity of electricity was 450 C/dm$^2$ which was the total quantity of electricity used for the aluminum plate to have an anodic reaction, and the electrolysis treatment was performed 4 times by conducting electricity of 112.5 C/dm$^2$ for 4 seconds at each treatment session. A carbon electrode was used as the counter electrode of the aluminum plate. Then, a rinsing treatment was performed.

-Desmutting treatment using aqueous acidic solution-

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 30°C.

-Anodization treatment-

By using the anodization device for direct current electrolysis, an anodization treatment was performed in a sulfuric acid solution.

<Method of forming undercoat layer>

The obtained support was coated with a coating liquid (1) for an undercoat layer having the following composition

such that the dry coating amount of 20 mg/m2 was obtained, and the support was dried in an oven at 100°C for 30 seconds, thereby forming an undercoat layer.

-Composition of coating liquid (1) for undercoat layer-

- ·Compound for undercoat layer (P-1, 11% aqueous solution): 0.10502 parts
- ·CHELEST 3EAF (chelating agent manufactured by CHELEST CORPORATION, sodium ethylenediaminetetraacetate): 0.0147 parts by mass
- ·CHELEST 400 (chelating agent manufactured by CHELEST CORPORATION): 0.0658 parts by mass
- ·Surfactant (EMALEX 710, manufactured by NIHON EMULSION Co., Ltd.): 0.00159 parts
- ·Preservative (BIOHOPE L, manufactured by K·I Chemical Industry Co., LTD.): 0.00149 parts
- ·Water: 2.87190 parts

(P-1)

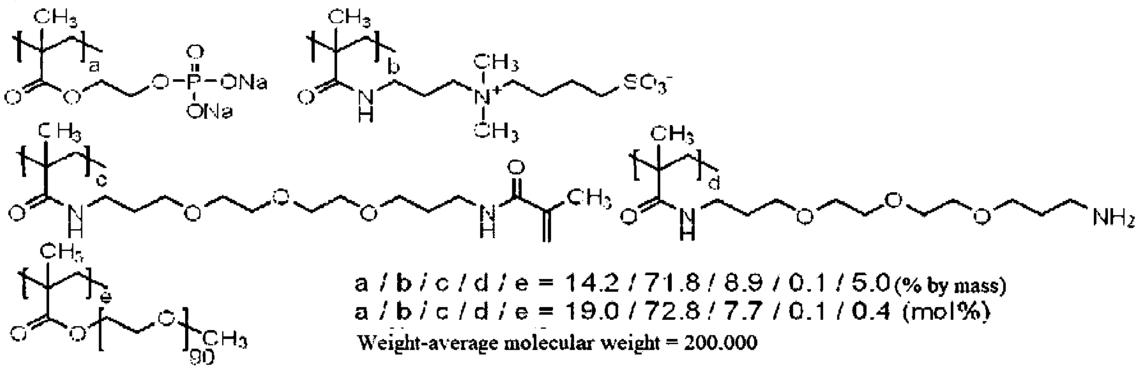

a / b / c / d / e = 14.2 / 71.8 / 8.9 / 0.1 / 5.0 (% by mass)
a / b / c / d / e = 19.0 / 72.8 / 7.7 / 0.1 / 0.4 (mol%)
Weight-average molecular weight = 200.000

<Formation of image-recording layer>

The undercoat layer was bar-coated with any of the coating liquids 1 to 3 for an image-recording layer described in Table 3, followed by drying in an oven at 120°C for 40 seconds, thereby forming an image-recording layer having a dry coating amount of 1.0 g/m2.

<Composition of coating liquid 1 for image-recording layer>

- ·Infrared absorber IR-1: 0.02000 parts
- ·Acid color developing agents C-1 to C-13 described in Table 3: 0.02500 parts
- ·Electron-accepting polymerization initiator Int-1: 0.11000 parts
- ·Electron-donating polymerization initiator: sodium tetraphenyl borate (TPB): 0.02500 parts
- ·Polymerizable compounds M-1 to M-3 or MP-1 described in Table 3: 0.27500 parts
- ·Anionic surfactant A-1: 0.00600 parts
- ·Fluorine-based surfactant W-1: 0.00416 parts
- ·2-Butanone: 4.3602 parts
- ·1-Methoxy-2-propanol: 4.4852 parts
- ·Methanol: 2.2838 parts
- ·Microgel liquid 1: 2.3256 parts

<Synthesis method of microgel liquid 1>

-Preparation of polyvalent isocyanate compound-

Bismuth tris(2-ethylhexanoate) (NEOSTAN U-600, manufactured by NITTO KASEI CO., LTD., 0.043 parts) was added to an ethyl acetate (25.31 g) suspension solution of 17.78 parts (80 molar equivalents) of isophorone diisocyanate and 7.35 parts (20 molar equivalents) of polyhydric phenol compound (1), and the obtained solution was stirred. The

reaction temperature was set to 50°C at a point in time when heat release subsided, and the solution was stirred for 3 hours, thereby obtaining an ethyl acetate solution of the polyvalent isocyanate compound (1) (50% by mass).

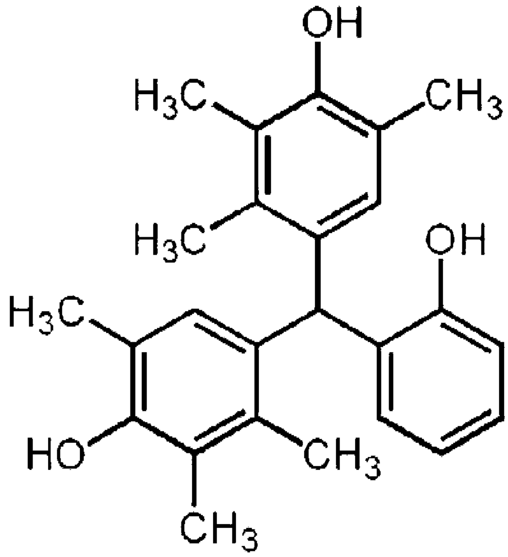

Polyhydric phenol compound (1)

-Preparation of microgel-

The following oil-phase components and water-phase components were mixed together and emulsified at 12,000 rpm for 10 minutes by using a homogenizer. The obtained emulsion was stirred at 45°C for 4 hours, a 10% by mass aqueous solution of 5.20 g of 1,8-diazabicyclo[5.4.0]undec-7-ene-octylate (U-CAT SA102, manufactured by San-Apro Ltd.) was added thereto, and the solution was stirred at room temperature for 30 minutes and left to stand at 45°C for 24 hours. Distilled water was added thereto such that the concentration of solid contents was adjusted to 20% by mass, thereby obtaining an aqueous dispersion of the microgel (1). The average particle diameter thereof measured by a light scattering method was 0.28 μm.

~Oil-phase component~

(Component 1) ethyl acetate: 12.0 parts
(Component 2) an adduct obtained by addition of trimethylolpropane (6 molar equivalents), xylene diisocyanate (18 molar equivalents), and polyoxyethylene having one methylated terminal (1 molar equivalent, the number of repeating oxyethylene units: 90) (50% by mass ethyl acetate solution, manufactured by Mitsui Chemicals, Inc.): 3.76 parts
(Component 3) polyvalent isocyanate compound (1) (as 50% by mass ethyl acetate solution): 15.0 parts
(Component 4) 65% by mass ethyl acetate solution of dipentaerythritol pentaacrylate (SR-399, manufactured by Sartomer Company Inc.): 11.54 parts
(Component 5) 10% ethyl acetate solution of sulfonate type surfactant (PIONIN A-41-C, manufactured by TAKEMOTO OIL & FAT Co., Ltd.): 4.42 parts

~Water-phase component~

Distilled water: 46.87 parts

<Composition of coating liquid 2 for image-recording layer>

Electron-accepting polymerization initiator Int-3: 0.041 parts
Infrared absorber IR-4: 0.027 parts

Infrared absorber IR-5: 0.015 parts
Polymerizable compound M-1: 0.100 parts
Polymerizable compound M-4: 0.096 parts
Polymerizable compound M-5: 0.096 parts
Polymer particles: 0.300 parts
Acid color developing agent C-4 or C-13: 0.041 parts
Hydroxypropyl cellulose: 0.030 parts
n-Propanol: 5.168 parts
2-Butanone: 6.460 parts
1-Methoxy-2-propanol: 1.615 parts
Methanol: 2.907 parts

<Composition of coating liquid 3 for image-recording layer>

·Electron-accepting polymerization initiator Int-2: 0.060 parts by weight
·Infrared absorber IR-3: 0.026 parts by weight
·Electron-donating polymerization initiator TPB: 0.050 parts by weight
·Polymerizable compound M-6: 0.250 parts by weight
·Polymerizable compound M-7: 0.250 parts by weight
·Acid color developing agent C-6: 0.030 parts by mass
·Binder polymer (S-LEC BL-10 manufactured by SEKISUI CHEMICAL CO., LTD., polyvinyl butyral): 0.150 parts by weight
·1-Methoxy-2-propanol: 4.988 parts
·2-Butanone: 9.262 parts

Each component used in the image-recording layer will be shown below.

[Infrared absorber]

IR-1 and IR-3 to IR-5: Compounds having the following structures

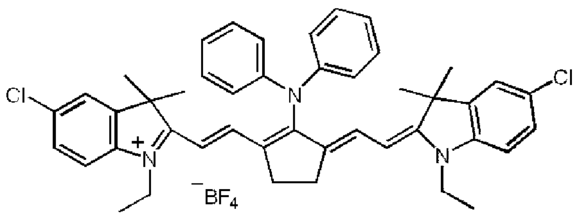

IR - 1

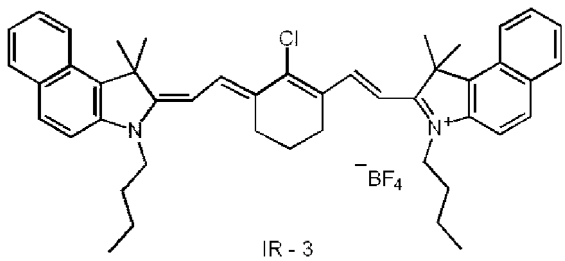

IR - 3

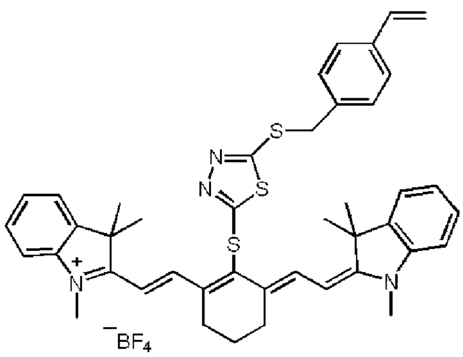

IR - 4

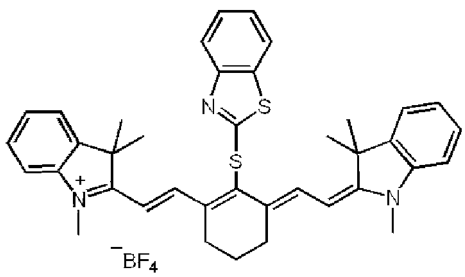

IR - 5

[Electron-accepting polymerization initiator]

Int-1 to Int-3: compounds having the following structures
Int-3 is a salt formed of 0.5 molar equivalents of each of the following two cations and 1 molar equivalent of the following one anion.

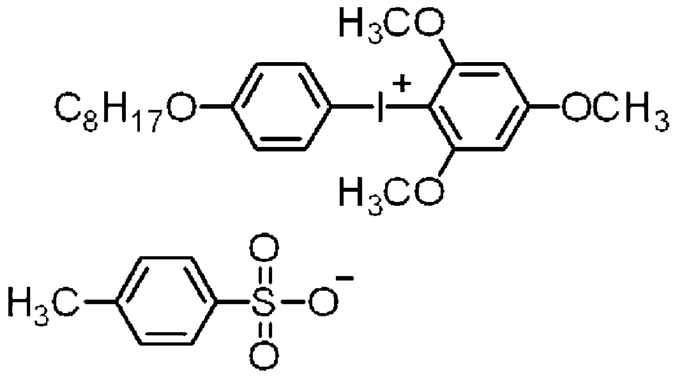

Int - 1

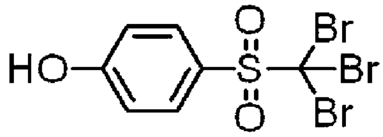

Int - 2

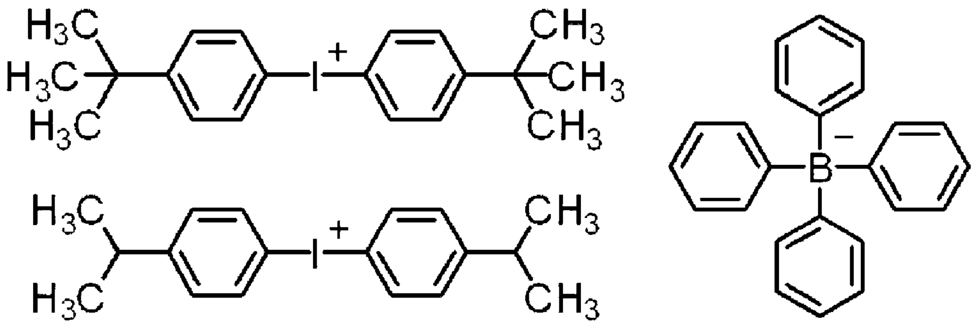

Int - 3

[Acid color developing agent]

C-1 to C-9: the following compounds

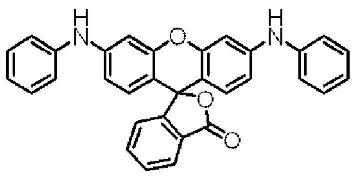

C - 1

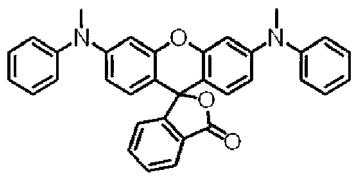

C - 2

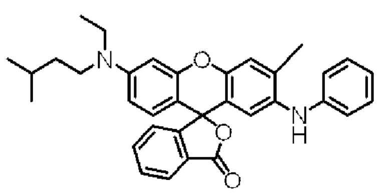

C - 3

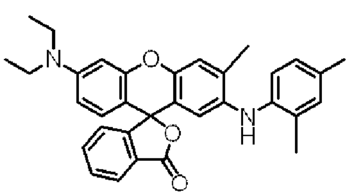

C - 4

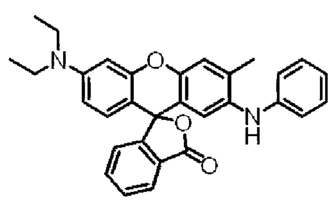

C - 5

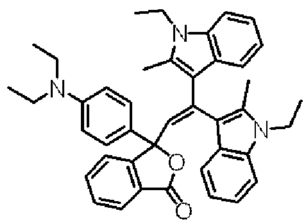

C - 6

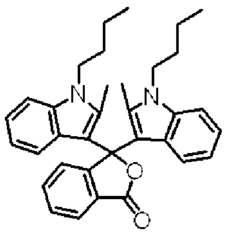

C - 7

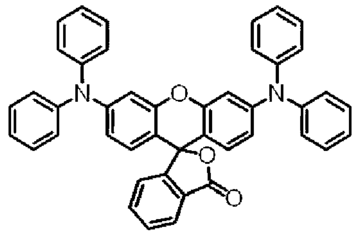

C - 8

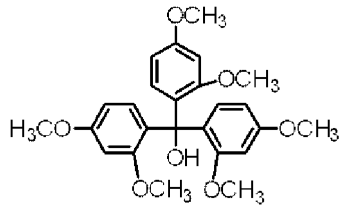

C - 9

C-10 to C-13: the following compounds

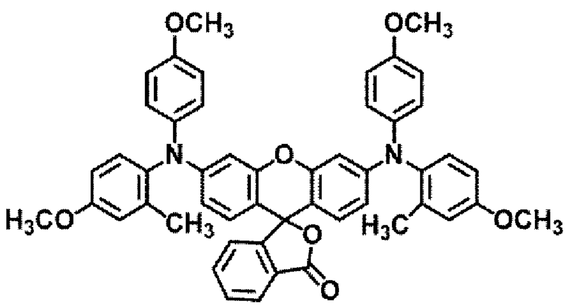

**C - 10**

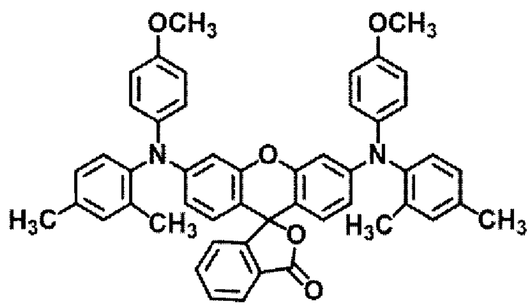

**C - 11**

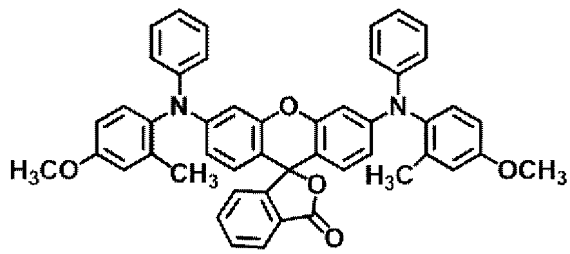

**C - 12**

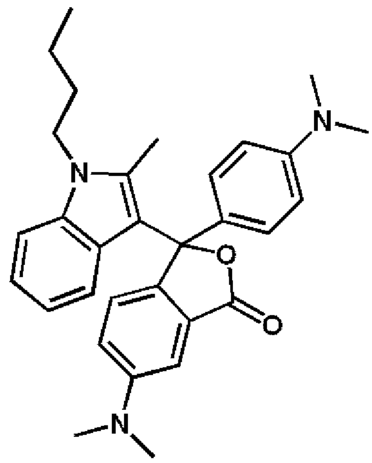

C - 13

[Polymerizable compound]

M-1: dipentaerythritol pentaacrylate, SR-399 manufactured by Sartomer Company Inc.
M-2: ε-caprolactone-modified tris(2-acryloxyethyl) isocyanurate, A-9300-CL1 manufactured by SHIN-NAKAMURA CHEMICAL CO, LTD.
M-3: compound synthesized as below
M-4 to M-7: the following compound
MP-1: compound synthesized as below

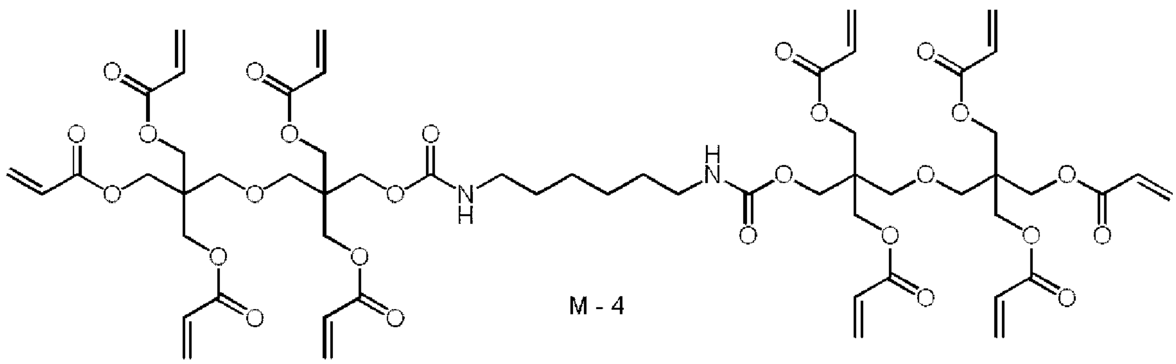

M - 4

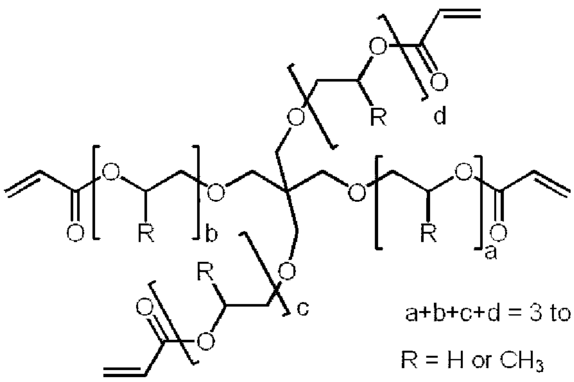

a+b+c+d = 3 to 7

R = H or $CH_3$

M - 5

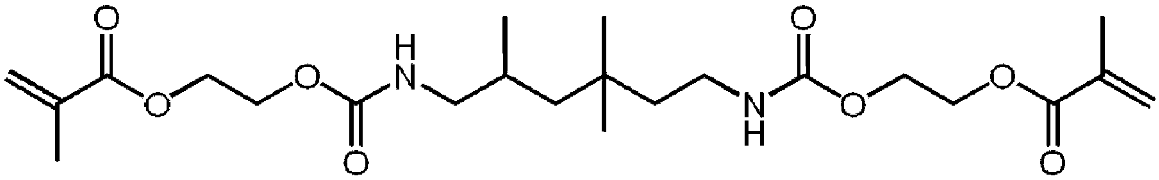

M - 6

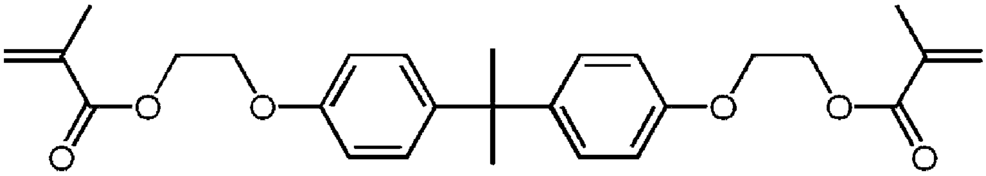

M - 7

<Synthesis method of polymerizable compound M-3>

A mixed solution of 4.7 parts by mass of TAKENATE D-160N (polyisocyanate trimethylolpropane adduct, manufactured by Mitsui Chemicals, Inc.), ARONIX M-403 (manufactured by TOAGOSEI CO., LTD.) in an amount yielding the ratio of NCO value of TAKENATE D-160N:hydroxyl number of ARONIX M-403 = 1:1, 0.02 parts by mass of t-butylbenzoquinone (0.02 parts by mass), and 11.5 parts by mass of methyl ethyl ketone was heated at 65°C. NEOSTANN U-600 (bismuth-based polycondensation catalyst, manufactured by NITTO KASEI CO., LTD., 0.11 parts by mass) was added to the reaction solution, and the reaction solution was heated at the same temperature for 4 hours. The reaction solution was cooled to room temperature (25°C), and methyl ethyl ketone was added thereto, thereby synthesizing a urethane acrylate (polymerizable compound M-3) solution having a solid content of 50% by mass.

Then, by using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight of the polymerizable compound M-3 was 20,000.

<Synthesis of polymerizable compound MP-1>

1-Methoxy-2-propanol (78.0 parts) was weighed, put into a three-neck flask, and heated to 70°C under a nitrogen stream. A mixed solution consisting of BLEMMER PME-100 (methoxydiethylene glycol monomethacrylate, manufactured by NOF CORPORATION.): 52.1 parts, methyl methacrylate: 21.8 parts, methacrylic acid: 14.2 parts, hexakis(3-mercaptopropionic acid)dipentaerythritol: 2.15 parts, V-601 (dimethyl 2,2'-azobis(isobutyrate), manufactured by FUJIFILM Wako Pure Chemical Corporation): 0.38 parts, 1-methoxy-2-propanol: 54 parts was added dropwise to the reaction vessel for 2 hours and 30 minutes. After dropwise addition ended, the solution was heated to 80°C, and the reaction was continued for 2 more hours. A mixed solution consisting of V-601: 0.04 parts and 1-methoxy-2-propanol: 4 parts was added to the aforementioned mixed solution, the obtained mixed solution was heated to 90°C, and the reaction was continued for 2.5 hours. After the reaction ended, the reaction solution was cooled to room temperature.

1-Methoxy-2-propanol: 137.2 parts, 4-hydroxytetramethylpiperidine-N-oxide: 0.24 parts, glycidyl methacrylate: 26.0 parts, and tetraethylammonium bromide: 3.0 parts were added to the reaction solution, and the reaction solution was well stirred and heated at 90°C.

After 18 hours, the reaction solution was cooled to room temperature (25°C), and then 1-methoxy-2-propanol: 99.4 parts were added thereto for dilution.

The binder polymerizable compound MP-1 obtained in this way had a concentration of solid contents of 23% by mass and a polystyrene-equivalent weight-average molecular weight of 35,000 measured by GPC.

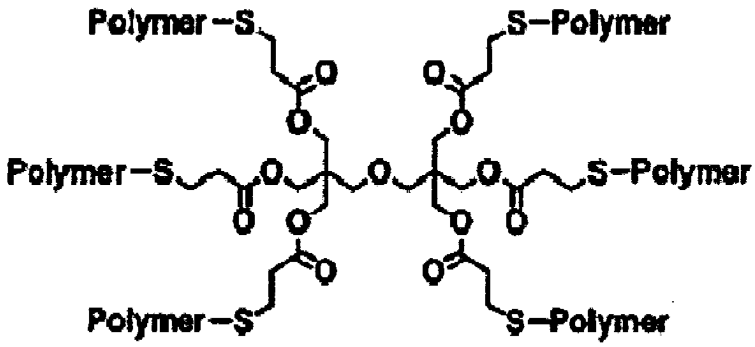

Polymer moiety

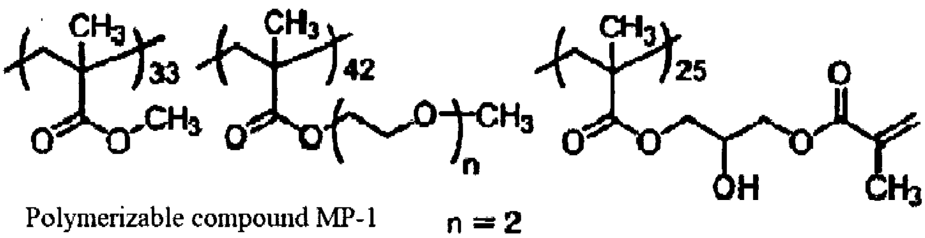

Polymerizable compound MP-1 n = 2

[Anionic surfactant]

A-1: compound having the following structure

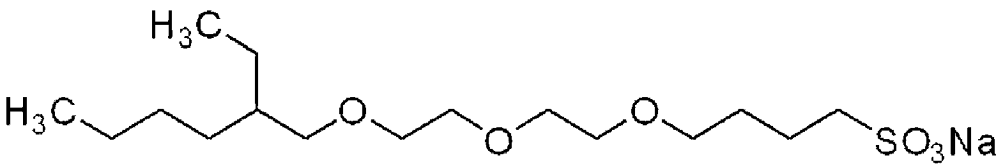

A - 1

[Fluorine-based surfactant]

W-1: compound having the following structure

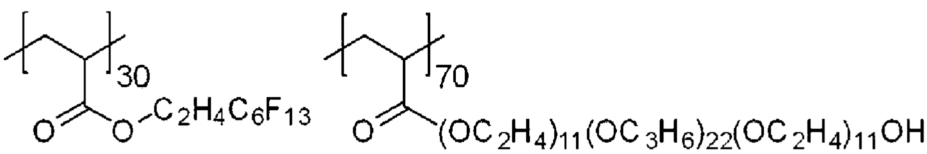

W - 1
Mw = 13,000

[Polymer particles]

Polymer particles 1: resin particles consisting of the following resin (n = 45, Mw = 50,000, average particle diameter 200 nm)

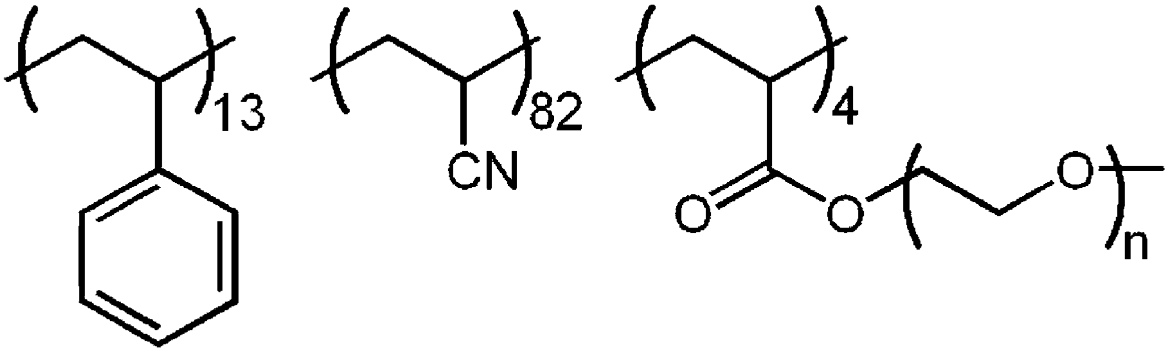

<Formation of outermost layer>

The image-recording layer was bar-coated with the coating liquid for an outermost layer composed as described in Table 3 (here, the coating liquid for an outermost layer contained the components described in Table 2, and the solid content thereof was adjusted to 6% by mass by using deionized water), followed by drying in an oven at 120°C for 60 seconds, thereby forming an outermost layer having a dry coating amount of 0.15 g/$m^2$.

[Table 2]

| | Water-soluble polymer | | | | | Hydrophobic polymer | Acid color developing agent | Others | | |
|---|---|---|---|---|---|---|---|---|---|---|
| | GOHSENX L-3266 | METOLOSE SM04 | Mowiol 4-88 | Mowiol 8-88 | WP-1 | FINE SPHERE FS-102 | Phenol red | Microgel liquid 2 | WIR-1 | EMALEX 710 |
| Coating liquid 1 for outermost layer | 0.05000 | - | - | - | - | - | - | - | - | 0.00350 |
| Coating liquid 2 for outermost layer | 0.05000 | - | - | - | - | 0.01700 | - | - | - | 0.00350 |
| Coating liquid 3 for outermost layer | 0.05000 | - | - | - | - | 0.01700 | - | 0.03500 | - | 0.00350 |
| Coating liquid 4 for outermost layer | 0.50000 | - | - | - | - | 0.17000 | - | 0.35000 | - | 0.03500 |
| Coating liquid 5 for outermost layer | - | 0.05000 | - | - | - | 0.01700 | - | 0.03500 | - | 0.00350 |
| Coating liquid 6 for outermost layer | - | 0.05000 | - | - | - | 0.01700 | 0.02500 | 0.03500 | - | 0.00350 |
| Coating liquid 7 for outermost layer | - | - | 0.70000 | 0.20000 | 0.20000 | - | - | - | 0.02000 | - |

Details of the components described in Table 2 are as below.

[Water-soluble polymer]

GOHSENX L3266: sulfonic acid-modified polyvinyl alcohol, Mw = 17,000, manufactured by Mitsubishi Chemical Corporation.

METOLOSE SM04: methyl cellulose, manufactured by Shin-Etsu Chemical Co., Ltd.

Mowiol 4-88: polyvinyl alcohol, manufactured by Sigma-Aldrich Co. LLC.

Mowiol 8-88: polyvinyl alcohol, manufactured by Sigma-Aldrich Co. LLC.

WP-1: the following compound (Mw 45,000)

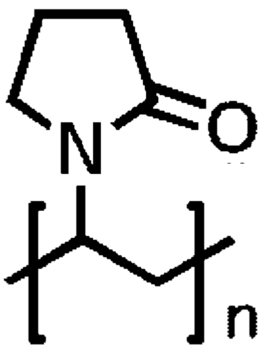

[Hydrophobic polymer]

FINESPHERE FS102: the following resin, manufactured by Resin shown below, manufactured by Nippon Paint Industrial Coatings Co., Ltd.

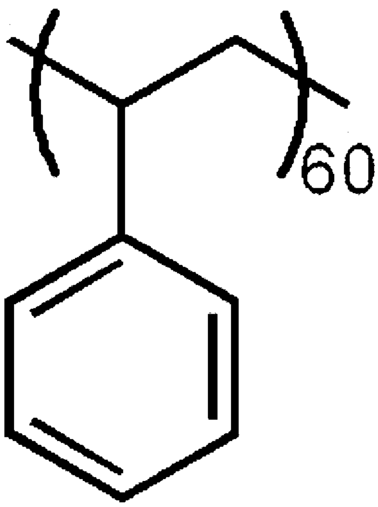

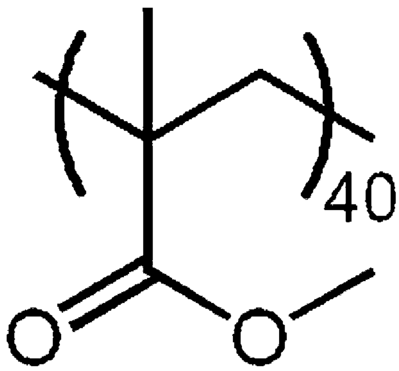

[Acid color developing agent]

Phenol Red: the following compounds

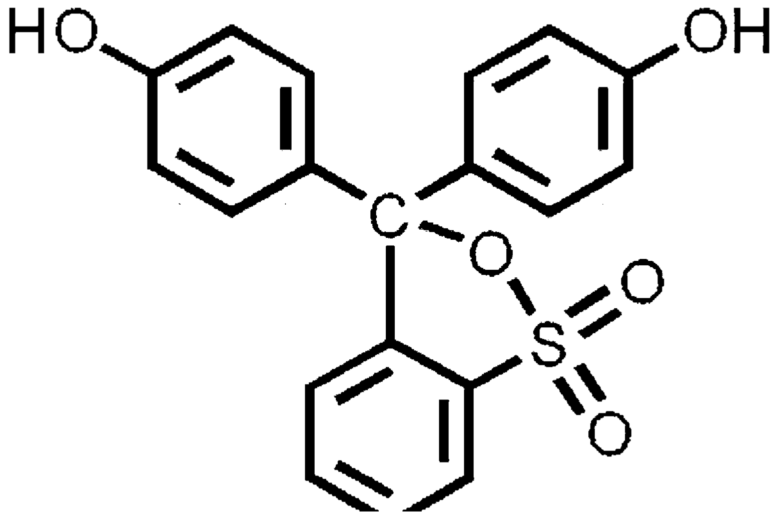

[Others]

Microgel 2: resin prepared as below
WR-1: the following compound
EMALEX 710: polyoxyethylene lauryl ether, surfactant, manufactured by Nihon Emulsion Co., Ltd.

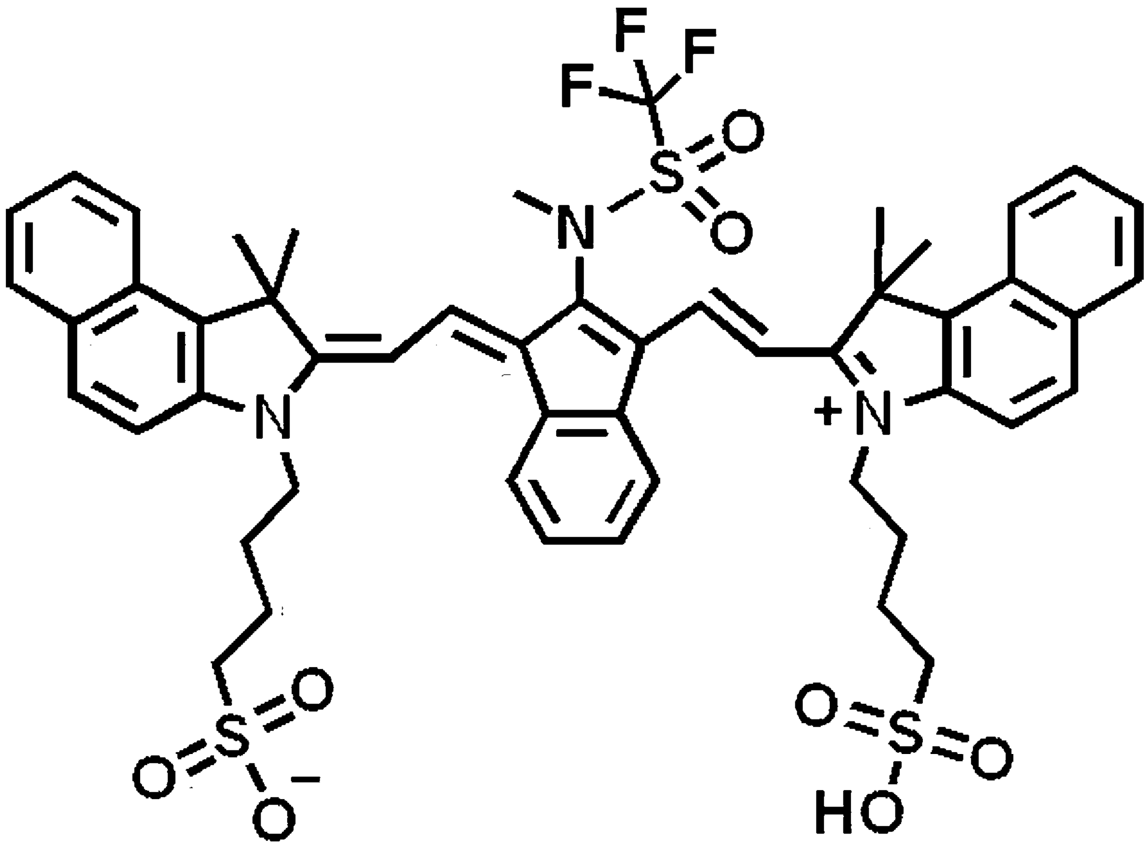

<Preparation of microgel 2>

A polyfunctional isocyanate compound (polymeric MDI WANNATE (registered trademark) PM-200: manufactured by Wanhua Chemical Group Co., Ltd.): 6.66 g, a 50% by mass ethyl acetate solution of "TAKENATE (registered

trademark) D-116N (adduct of trimethylolpropane (TMP), m-xylylene diisocyanate (XDI), and polyethylene glycol monomethyl ether (EO90) (the following compound)" manufactured by Mitsui Chemicals, Inc.: 5.46 g, a 65% by mass ethyl acetate solution of a polymerizable compound M-2 having the following structure": 11.53 g, ethyl acetate: 18.66 g, 0.36 g of 1-docosanol (KALCOL 220-80, manufactured by Kao Corporation, solubility in water: < 1% by mass), and PIONIN (registered trademark) A-41-C manufactured by TAKEMOTO OIL & FAT Co., Ltd.: 0.45 g were mixed together and stirred at room temperature (25°C) for 15 minutes, thereby obtaining an oil-phase component.

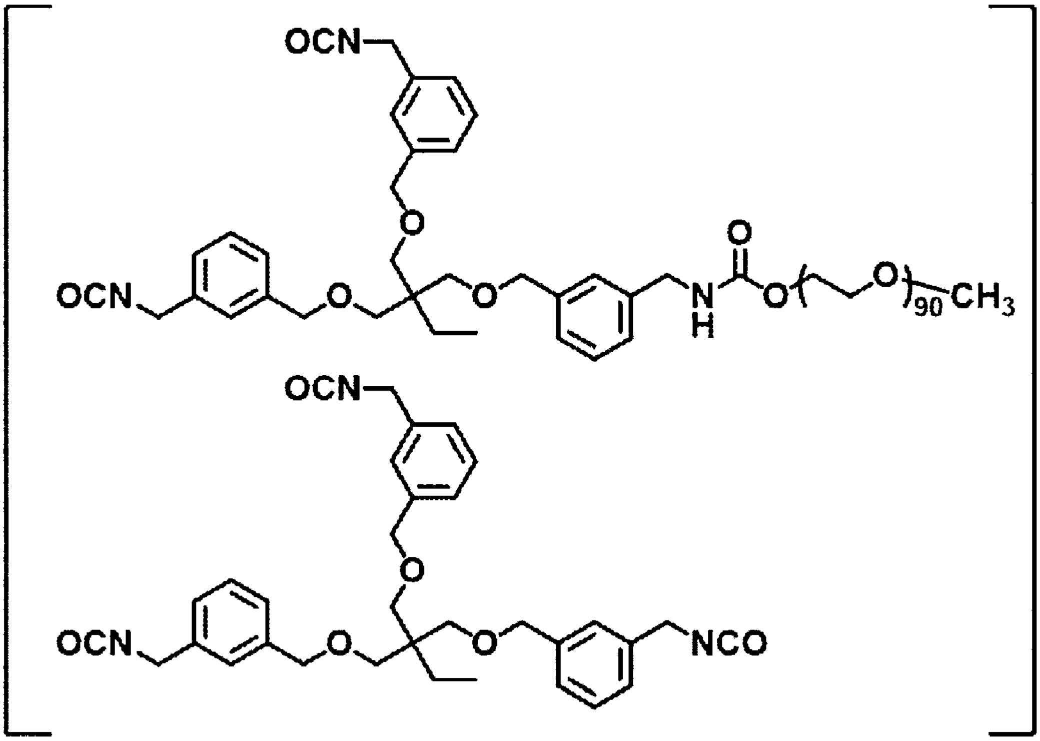

D-116N

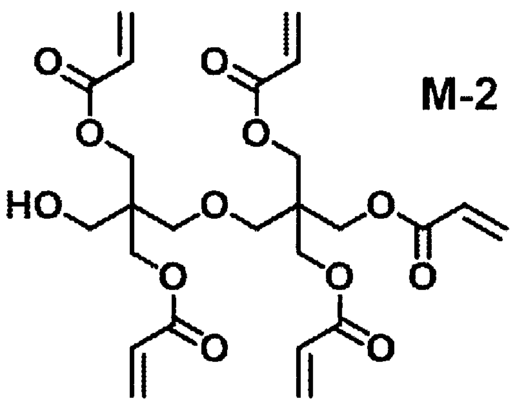

M-2

As a water-phase component, distilled water: 46.89 g was added to the obtained oil-phase component and mixed together, and the obtained mixture was emulsified at a rotation speed of 12,000 rpm for 12 minutes by using a homogenizer, thereby obtaining an emulsion.

The obtained emulsion was added to 16.66 g of distilled water, and stirred. Then, the obtained liquid was heated to 45°C, and stirred for 4 hours in a state of being kept at 45°C such that ethyl acetate was distilled off from the liquid. Then, the liquid from which ethyl acetate was distilled off was heated to 45°C and stirred for 48 hours in a state of being kept at 45°C, thereby obtaining microcapsule-type particles 2 made of a polyaddition-type resin in a liquid. Thereafter, the liquid containing the particles 2 was diluted with distilled water such that the concentration of solid contents was 20% by mass, thereby obtaining an aqueous dispersion of the particles 2.

The arithmetic mean particle diameter of the particles 2 measured by the aforementioned method was 200 nm.

<Preparation of lithographic printing plate precursor>

As described in Table 3, lithographic printing plate precursors used in Examples 1 to 27 and Comparative Examples 1 to 12 were prepared according to the methods of forming the support and each of the above layers.

<Preparation of interleaving paper>

Insertion paper having pH 7: interleaving paper prepared by the following production method.
Insertion paper having pH 5: interleaving paper prepared by the following production method.
Insertion paper having pH 4: interleaving paper prepared by the following production method.
Insertion paper having pH 2: interleaving paper prepared by the following production method.

-Production method of interleaving paper having pH 7-

As a neutral sizing agent, 0.4% by mass of an alkyl ketene dimer (AKD) was added to paper stock obtained by beating bleached kraft pulp and diluting the beaten pulp to a concentration of 4% by mass, and 5.0% by mass of calcium carbonate was added thereto. The paper stock was coated with 3.0% by mass of a paper strengthening agent containing starch as a main component, thereby making paper. The paper was subjected to calendering using soft calenders with the number of times of nip of 2 and resin rolls at a linear pressure of 18 kg/cm, thereby preparing interleaving paper having a pH of 7.0 (measured by the method described above, the same shall be applied hereinafter), a basis weight of 48 g/$m^2$, and a moisture content of 5.5% by mass.

-Production method of interleaving paper having pH 5-

A rosin-based sizing agent (0.4% by mass) was added to paper stock obtained by beating bleached kraft pulp and diluting the beaten pulp to a concentration of 4% by mass, and aluminum sulfate was added thereto until the pH reached 5.0. The paper stock was coated with 3.0% by mass of a paper strengthening agent containing starch as a main component, thereby making paper. The paper was subjected to calendering as in the preparation of the interleaving paper having a pH 7, thereby preparing interleaving paper having a pH of 5.0, a basis weight of 42 g/$m^2$, and a moisture content of 7.0% by mass.

-Production method of interleaving paper having pH 4-

A rosin-based sizing agent (0.4% by mass) was added to paper stock obtained by beating bleached kraft pulp and diluting the beaten pulp to a concentration of 4% by mass, and aluminum sulfate was added thereto until the pH reached 4.0. The paper stock was coated with 3.0% by mass of a paper strengthening agent containing starch as a main component, thereby making paper. The paper was subjected to calendering as in the preparation of the interleaving paper having a pH 7, thereby preparing interleaving paper having a pH of 4.0, a basis weight of 42 g/$m^2$, and a moisture content of 7.0% by mass.

-Production method of interleaving paper having pH 2-

A rosin-based sizing agent (0.4% by mass) was added to paper stock obtained by beating bleached kraft pulp and diluting the beaten pulp to a concentration of 4% by mass, and aluminum sulfate was added thereto until the pH reached 2.0. The paper stock was coated with 3.0% by mass of a paper strengthening agent containing starch as a main component, thereby making paper. The paper was subjected to calendering as in the preparation of the interleaving paper having a pH 7, thereby preparing interleaving paper having a pH of 2.0, a basis weight of 42 g/$m^2$, and a moisture content of 7.0% by mass.

<Preparation of laminate>

The aforementioned lithographic printing plate precursor having a size of 62 cm × 40 cm and the following interleaving paper, protector cardboard (ABC-5), and aluminum kraft paper having the same size as the lithographic printing plate precursor were humidified for 1 hour in an environment at 25°C and 70% RH, and the state where the humidity of the interleaving paper and the humidity of the protector cardboard were in equilibrium was confirmed. In the environment at 25°C and 70% RH, 50 sheets of the lithographic printing plate precursors and 50 sheets of the interleaving paper were alternately laminated, the protector cardboard (ABC-5) was additionally attached to the top and bottom of the obtained product, and the product was packaged with aluminum kraft paper. The packaged product was left to stand for 3

days in an environment at 50°C at a humidity that was not under control, thereby preparing laminates of Examples 1 to 27 and Comparative Examples 1 to 12. In all the laminates, the lithographic printing plate precursors were laminated with the support side facing down.

<Evaluation of laminate>

[Speck-like color defect suppressiveness]

The lithographic printing plate precursor in each of the laminates prepared as above was observed, and the number of speck-like defects having a size of 1 cm × 1 cm was counted and evaluated as follows. The higher the score, the smaller the number of speck-like defects.

5 points: The number of speck-like defects is 0 or more and less than 5.
4 points: The number of speck-like defects is 5 or more and less than 30.
3 points: The number of speck-like defects is 30 or more and less than 80.
2 points: The number of speck-like defects is 80 or more and less than 120.
1 point: The number of speck-like defects is 120 or more.

[On-press developability]

By using Magnus 800 Quantum manufactured by Kodak Japan Ltd. that was equipped with an infrared semiconductor laser, the lithographic printing plate precursor in each of the laminates prepared as above was exposed under the conditions of output of 27 W, an outer drum rotation speed of 450 rpm, and a resolution of 2,400 dpi (dots per inch, 1 inch is equal to 2.54 cm) (irradiation energy equivalent to 110 $mJ/cm^2$). The exposure images included a solid image and an amplitude modulated screening (AM screening) as a 3% halftone dot chart.

The obtained exposed precursor was mounted on a Kikuban-sized (636 mm × 939 mm) cylinder of a printer SX-74 manufactured by Heidelberger Druckmaschinen AG without being developed. This printer was connected to a 100 L-capacity dampening water circulation tank having a non-woven fabric filter and a temperature control device. A circulation device was filled with 80 L of dampening water containing 2.0% by mass of dampening water S-Z1 (manufactured by FUJIFILM Corporation), and an ultraviolet-curable ink (UV ink) T&K UV OFS K-HS black GE-M (manufactured by T&K TOKA CO., LTD.) was used as printing ink. The dampening water and ink were supplied by a standard automatic printing start method, and then printing was performed 500 sheets of TOKUBISHI art paper (ream weight: 76.5 kg, manufactured by MITSUBISHI PAPER MILLS LIMITED.) at a printing rate of 10,000 sheets/hour.

During printing, the number of printing papers used until no ink was transferred to a non-image area was measured as the on-press developability. It can be said that the smaller the number of printing papers, the better the on-press developability. The results are shown in Table 3.

[Conditions of visibility evaluation]

Image exposure was performed on the lithographic printing plate precursor under the same conditions as in the evaluation of on-press developability, such that the characters "Fuji" having a size of 3 to 14 points form exposed portions. Under a white light of 800 lux, the exposed lithographic printing plate precursor was placed perpendicular to the floor. An experimenter stood at a distance of 1 m from the just exposed precursor and evaluated the points of the smallest characters that could be read accurately by both eyes. The evaluation was performed within 30 minutes after the exposure of the lithographic printing plate precursor. The average points given by 10 experimenters was calculated, and the visibility was evaluated based on the following standard.

Evaluation standard

A 3 points or more and less than 5 points
B 5 points or more and less than 6 points
C 6 points or more and less than 7 points
D 7 points or more and less than 9 points
E 9 points or more and less than 11 points
F 11 points or more

[Table 3]

| | pH of interleaving paper | ΔL | Coating liquid for image-recording layer | Acid color developing agent in image-recording. layer | ε | λmax (nm) | Ring-opening rate of acid color developing agent (mol%) | Polymerizable compound in image-recording layer | Ratio of polymerizable compound molecular weight of 2.500 or less | Ratio of Ratio of polymerizable compound having Mw 10.000 or more | Coating liquid for outermost layer | Support | Speck-like color defect suppressiveness | On-press developability | Visibility |
|---|---|---|---|---|---|---|---|---|---|---|---|---|---|---|---|
| Example 1 | 7 | 10 | 1 | C-1 | 55000 | 550 | 40 | M-3 | 35% | 15% | 3 | B | 5 | 20 | A |
| Example 2 | 5 | 10 | 1 | C-1 | 55000 | 550 | 40 | M-3 | 35% | 15% | 3 | B | 3 | 35 | A |
| Example 3 | 7 | 10 | 1 | C-2 | 72000 | 500 | 40 | M-3 | 35% | 15% | 3 | B | 5 | 30 | A |
| Example 4 | 7 | 5 | 1 | C-3 | 13000 | 440<br>580 | 10 | M-3 | 35% | 15% | 3 | B | 5 | 20 | D |
| Example 5 | 5 | 5 | 1 | C-3 | 13000 | 440 | 10 | M-3 | 35% | 15% | 3 | B | 4 | 25 | D |
| Example 6 | 7 | 5 | 1 | C-4 | 13000 | 440<br>580 | 10 | M-3 | 35% | 15% | 3 | B | 5 | 20 | D |
| Example 7 | 7 | 5 | 1 | C-5 | 13000 | 440<br>580 | 10 | M-3 | 35% | 15% | 3 | B | 5 | 20 | D |
| ExamplePp 8 | 7 | 7 | 1 | C-6 | 22000 | 570<br>680 | 10 | M-3 | 35% | 15% | 3 | B | 5 | 20 | C |
| Example 9 | 7 | 5 | 1 | C-7 | 20000 | 520 | 5 | M-3 | 35% | 15% | 3 | B | 5 | 20 | D |
| Example 10 | 7 | 7 | 1 | C-8 | 25000 | 570 | 40 | M-3 | 35% | 15% | 3 | B | 5 | 20 | C |
| Example | 7 | 5 | 1 | C-9 | 20000 | 540 | 5 | M-3 | 35% | 15% | 3 | B | 5 | 20 | D |
| $Example_{12}$ | 7 | 3 | 1 | Added to outermost layer | 38000 | 560 | 3 | M-3 | 35% | 15% | 6 | B | 5 | 20 | F |
| Example 13 | 7 | 10 | 1 | C-1 | 55000 | 550 | 40 | M-3 | 35% | 15% | - | B | 5 | 40 | A |
| Example 14 | 7 | 10 | 1 | C-1 | 55000 | 550 | 40 | M-3 | 35% | 15% | 1 | B | 5 | 20 | A |
| Example 15 | 7 | 10 | 1 | C-1 | 55000 | 550 | 40 | M-3 | 35% | 15% | 2 | B | 5 | 20 | A |
| Example | 5 | 10 | 1 | C-1 | 55000 | 550 | 40 | M-3 | 35% | 15% | 4 | B | 3 | 45 | A |
| Example 17 | 7 | 10 | 1 | C-1 | 55000 | 550 | 40 | M-3 | 35% | 15% | 5 | B | 5 | 20 | A |
| Example | 5 | 10 | 1 | C-1 | 55000 | 550 | 40 | M-1 | 55% | 0% | 3 | B | 3 | 15 | A |
| Example 19 | 5 | 10 | 1 | C-1 | 55000 | 550 | 40 | M-2 | 55% | 0% | 3 | B | 3 | 15 | A |

(continued)

| | pH of interleaving paper | ΔL | Coating liquid for image-recording layer | Acid color developing agent in image-recording. layer | ε | λmax (nm) | Ring-opening rate of acid color developing agent (mol%) | Polymerizable compound in image-recording layer | Ratio of polymerizable compound molecular weight of 2.500 or less | Ratio of Ratio of polymerizable compound having Mw 10.000 or more | Coating liquid for outermost layer | Support | Speck-like color defect suppressiveness | On-press developability | Visibility |
|---|---|---|---|---|---|---|---|---|---|---|---|---|---|---|---|
| Example 20 | 5 | 10 | 1 | C-1 | 55000 | 550 | 40 | P-1 | 20% | 30% | 3 | B | 5 | 25 | A |
| Example 21 | 7 | 5 | 2 | C-4 | 13000 | 440<br>580 | 10 | M-1<br>M-4<br>M-5 | 40% | 40% | - | A | 5 | 40 | D |
| Example 22 | 7 | 5 | 3 | C-6 | 22000 | 570<br>680 | 10 | M-6<br>M-7 | 65% | 20% | 7 | c | 5 | 40 | D |
| Example 23 | 7 | 8 | 1 | C-10 | 55000 | 590 | 20 | M-3 | 35% | 15% | 3 | B | 5 | 20 | B |
| Example 24 | 7 | 8 | 1 | C-11 | 55000 | 590 | 20 | M-3 | 35% | 15% | 3 | B | 5 | 20 | B |
| Example 25 | 7 | 8 | 1 | C-12 | 55000 | 590 | 20 | M-3 | 35% | 15% | 3 | B | 5 | 20 | B |
| Example 26 | 7 | 7 | 2 | C-13 | 50000 | 540<br>590 | 15 | M-1<br>M-4<br>M-5 | 40% | 40% | - | A | 5 | 40 | C |
| Example 27 | 7 | 7 | 1 | C-13 | 50000 | 540 590 | 15 | M-3 | 35% | 15% | 3 | B | 5 | 20 | C |
| Comparative Example 1 | 4 | 10 | 1 | C-1 | 55000 | 550 | 40 | M-3 | 35% | 15% | 3 | B | 2 | 50 | A |
| Comparative Example 2 | 2 | 10 | 1 | C-1 | 55000 | 550 | 40 | M-3 | 35% | 15% | 3 | B | 1 | 100 | A |
| Comparative Example 3 | 4 | 10 | 1 | C-2 | 72000 | 500 | 40 | M-3 | 35% | 15% | 3 | B | 2 | 50 | A |
| Example 4 | 4 | 5 | 1 | C-3 | 13000 | 440<br>580 | 10 | M-3 | 35% | 15% | 3 | B | 2 | 50 | D |
| Comparative Example 5 | 4 | 5 | 1 | C-4 | 13000 | 440<br>580 | 10 | M-3 | 35% | 15% | 3 | B | 2 | 50 | D |
| Comparative Example 6 | 4 | 7 | 1 | C-6 | 22000 | 570<br>680 | 10 | M-3 | 35% | 15% | 3 | B | 2 | 50 | C |

(continued)

| | pH of interleaving paper | ΔL | Coating liquid for image-recording layer | Acid color developing agent in image-recording. layer | ε | λmax (nm) | Ring-opening rate of acid color developing agent (mol%) | Polymerizable compound in image-recording layer | Ratio of polymerizable compound molecular weight of 2.500 or less | Ratio of Ratio of polymerizable compound having Mw 10.000 or more | Coating liquid for outermost layer | Support | Speck-like color defect suppressiveness | On-press developability | Visibility |
|---|---|---|---|---|---|---|---|---|---|---|---|---|---|---|---|
| Comparative Example 7 | 4 | 5 | 2 | C-4 | 13000 | 440<br>580 | 10 | M-1<br>M-4<br>M-5 | 40% | 40% | - | A | 2 | 100 | D |
| Comparative Example 8 | 4 | 5 | 3 | C-6 | 22000 | 570<br>680 | 10 | M-6<br>M-7 | 65% | 20% | 7 | C | 2 | 100 | D |
| Comparative Example 9 | 4 | 8 | 1 | C-10 | 55000 | 590 | 20 | M-3 | 35% | 15% | 3 | B | 2 | 50 | B |
| Comparative Example 10 | 4 | 8 | 1 | C-11 | 55000 | 590 | 20 | M-3 | 35% | 15% | 3 | B | 2 | 50 | B |
| Comparative Example 11 | 4 | 8 | 1 | C-12 | 55000 | 590 | 20 | M-3 | 35% | 15% | 3 | B | 2 | 50 | B |
| Comparative Example 12 | 4 | 7 | 2 | C-13 | 50000 | 540<br>590 | 15 | M-1<br>M-4<br>M-5 | 40% | 40% | - | A | 2 | 100 | C |

Examples 8 and 11 are not according to the invention.

ΔL represents a brightness change of an exposed portion of the lithographic printing plate precursor before and after exposure, the brightness change being obtained in a case where the lithographic printing plate precursor is subjected to exposure to infrared having a wavelength of 830 nm at an energy density of 110 $mJ/cm^2$. ε represents the maximum value of a molar absorption coefficient ε that the color developing substance generated from the aforementioned acid color developing agent has at 400 nm to 800 nm. λmax represents a maximum absorption wavelength (and a second maximum absorption wavelength) that the image-recording layer has in a wavelength range of 380 nm to 750 nm in a case where the image-recording layer is exposed to infrared having a wavelength of 830 nm at an energy density of 110 $mJ/cm^2$.

As is evident from the results shown in Table 3, compared to the laminates according to comparative examples, the laminates according to examples are better in the speck-like color defect suppressiveness of the laminated lithographic printing plate precursors.

Furthermore, it has been confirmed that the laminate according to the present invention is also excellent in on-press developability of the laminated lithographic printing plate precursors.

By the comparison of the laminates of examples, it has been found that the results of visibility evaluation are better in the examples having a larger ΔL than in the examples having a smaller ΔL. Furthermore, in a case where alkaline (pH 7) interleaving paper was used in examples having a larger ΔL (for example, Examples 1 to 3), the obtained laminate also exhibited excellent speck-like color defect suppressiveness even after the passage of time.

Explanation of References

12a, 12b: aluminum support
14: undercoat layer
16: image-recording layer
18: aluminum plate
20a, 20b: anodic oxide film
22a, 22b: micropore
24: large diameter portion
26: small diameter portion
D: depth of large diameter portion
610: anodization treatment device
612: power supply tank
614: electrolytic treatment tank
616: aluminum plate
618, 26: electrolytic solution
620: power supply electrode
622, 628: roller
624: nip roller
630: electrolytic electrode, 632: cell wall
634: direct current power source

## Claims

**1.** A laminate comprising:

a lithographic printing plate precursor; and
interleaving paper,
wherein the lithographic printing plate precursor is an on-press development type lithographic printing plate precursor containing an acid color developing agent in at least any of layers, and
a pH of the interleaving paper is 5 or more,
the acid color developing agent comprises a compound represented by any one of the following Formulae (Le-1) to (Le-3) or the following compound CL-5:

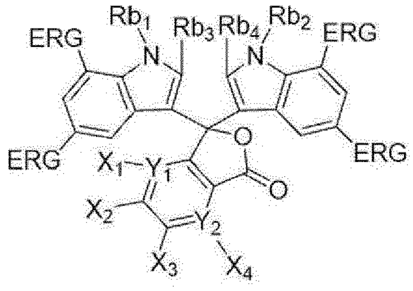

( Le - 1 )

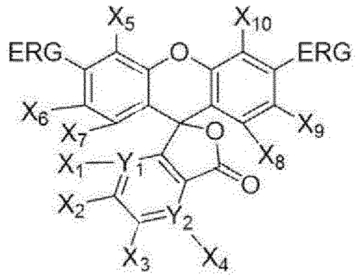

( Le - 2 )

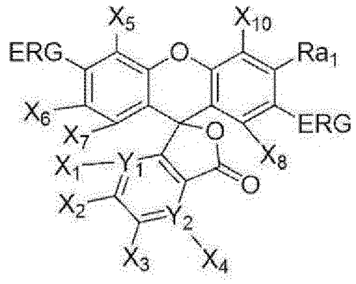

( Le - 3 )

wherein, in Formula (Le-1) to Formula (Le-3), ERG each independently represent an electron-donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, or an aryl group,

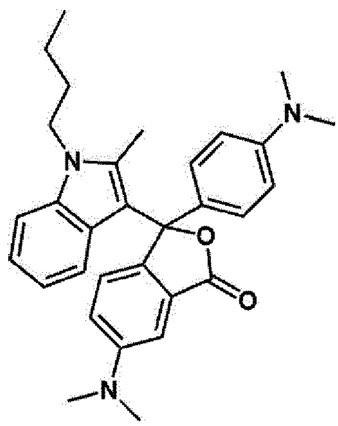

CL - 5

2. The laminate according to claim 1,
wherein in a case where the lithographic printing plate precursor is subjected to exposure to infrared having a wavelength of 830 nm at an energy density of 110 mJ/$cm^2$, a brightness change $\Delta L$ of an exposed portion of the lithographic printing plate precursor before and after the exposure is 5.0 or more.

3. The laminate according to claim 1 or 2,
wherein a maximum value of a molar absorption coefficient $\varepsilon$ that a color developing substance generated from the acid color developing agent has at 400 nm to 800 nm is 25,000 to 200,000.

4. The laminate according to any one of claims 1 to 3,
wherein the lithographic printing plate precursor has a support and an image-recording layer.

5. The laminate according to claim 4,
wherein the image-recording layer contains the acid color developing agent.

6. The laminate according to claim 4 or 5,

wherein the image-recording layer contains a polymerizable compound having a molecular weight of 2,500 or less, and
a content of the polymerizable compound having a molecular weight of 2,500 or less is 50% by mass or less with respect to a total mass of the image-recording layer.

7. The laminate according to any one of claims 4 to 6, wherein the lithographic printing plate precursor further has an outermost layer on the image-recording layer.

8. The laminate according to claim 7, wherein the outermost layer contains a discoloring compound.

9. The laminate according to claim 8, wherein the discoloring compound includes a compound that develops color due to exposure to infrared.

10. The laminate according to claim 8 or 9, wherein the discoloring compound includes a decomposable compound that decomposes due to exposure to infrared.

11. The laminate according to any one of claims 8 to 10, wherein the discoloring compound is a cyanine dye.

12. The laminate according to any one of claims 8 to 11,

wherein the discoloring compound is a compound represented by Formula 1-1,

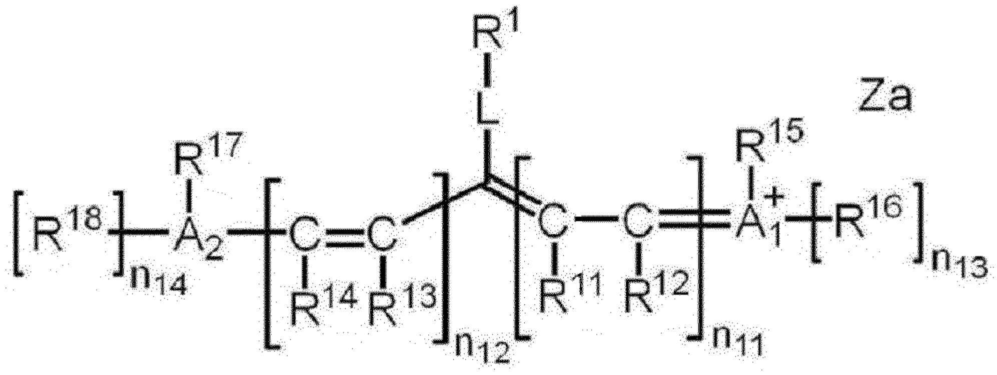

Formula 1-1

in Formula 1-1, $R^1$ represents a group represented by any of Formula 2-1 to Formula 4-1, $R^{11}$ to $R^{18}$ each independently represent a hydrogen atom, a halogen atom, $-R^a$, $-OR^b$, $-SR^c$, or $-NR^dR^e$, $R^a$ to $R^e$ each independently represent a hydrocarbon group, $A_1$, $A_2$, and a plurality of $R^{11}$ to $R^{18}$ may be linked to each other to form a monocyclic or polycyclic ring, $A_1$ and $A_2$ each independently represent an oxygen atom, a sulfur atom, or a nitrogen atom, $n_{11}$ and $n_{12}$ each independently represent an integer of 0 to 5, a sum of $n_{11}$ and $n_{12}$ is 2 or more, $n_{13}$ and $n_{14}$ each independently represent 0 or 1, L represents an oxygen atom, a sulfur atom, or $-N(R^{10})-$, $R^{10}$ represents a hydrogen atom, an alkyl group, or an aryl group, and Za represents a counterion that neutralizes charge,

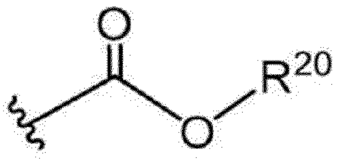

Formula 2-1

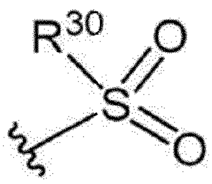

Formula 3-1

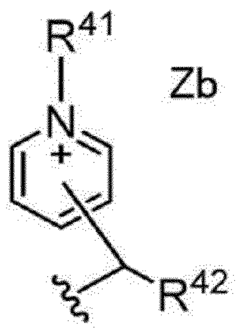

Formula 4-1

in Formula 2-1 to Formula 4-1, $R^{20}$, $R^{30}$, $R^{41}$, and $R^{42}$ each independently represent an alkyl group or an aryl group, Zb represents a counterion that neutralizes charge, and a wavy line represents a bonding site with a group represented by L in Formula 1-1.

**13.** The laminate according to any one of claims 8 to 12, wherein the discoloring compound includes the acid color developing agent.

**14.** The laminate according to any one of claims 7 to 13, wherein the outermost layer contains a water-soluble polymer.

**15.** The laminate according to any one of claims 4 to 14, wherein the image-recording layer contains an infrared absorber, an electron-accepting polymerization initiator, and an electron-donating polymerization initiator.

**16.** The laminate according to any one of claims 1 to 15, wherein the pH of the interleaving paper is 6.5 to 8.

## Patentansprüche

**1.** Laminat, umfassend:

einen lithographischen Druckplattenvorläufer; und
Zwischenpapier,
wobei der lithographische Druckplattenvorläufer ein lithographischer Druckplattenvorläufer des Auf-Presse-Entwicklungstyps ist, der ein Säurefarbentwicklungsmittel in mindestens beliebigen von Schichten enthält, und ein pH des Zwischenpapiers 5 oder mehr beträgt,
das Säurefarbentwicklungsmittel eine Verbindung umfasst, die durch eine beliebige der folgenden Formeln (Le-1) bis (Le-3) oder die folgende Verbindung CL-5 dargestellt wird:

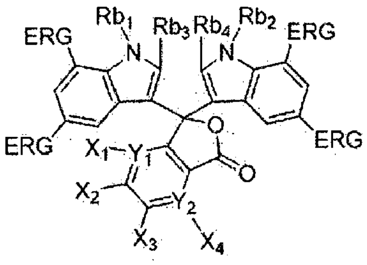

(Le - 1)

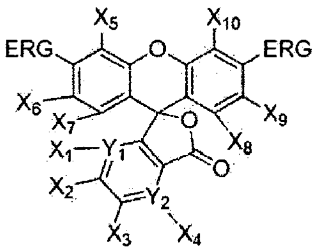

(Le - 2)

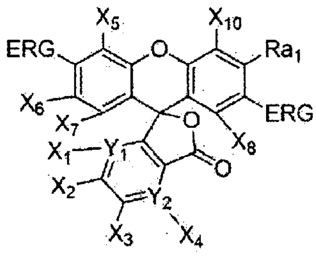

(Le - 3)

wobei in Formel (Le-1) bis Formel (Le-3) ERG jeweils unabhängig voneinander eine elektronenspendende Gruppe darstellen, $X_1$ bis $X_4$ jeweils unabhängig voneinander ein Wasserstoffatom, ein Halogenatom oder eine Dialkylanilino-Gruppe darstellen, $X_5$ bis $X_{10}$ jeweils unabhängig voneinander ein Wasserstoffatom, ein Halogenatom oder eine monovalente organische Gruppe darstellen, $Y_1$ und $Y_2$ jeweils unabhängig voneinander C oder N darstellen, $X_1$ in einem Fall, in dem $Y_1$ N ist, nicht existiert, $X_4$ in einem Fall, in dem $Y_2$ N ist, nicht existiert, $Ra_1$ ein Wasserstoffatom, eine Alkylgruppe oder eine Alkoxygruppe darstellt und $Rb_1$ bis $Rb_4$ jeweils unabhängig voneinander ein Wasserstoffatom, eine Alkylgruppe oder eine Arylgruppe darstellen,

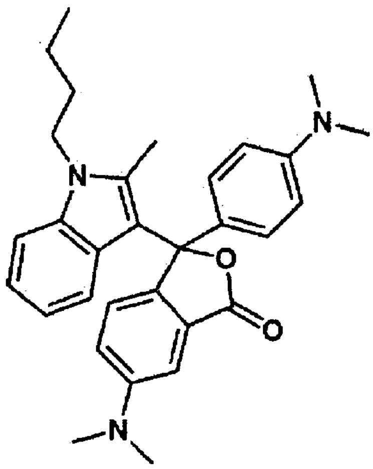

CL - 5

2. Laminat nach Anspruch 1,
wobei in einem Fall, in dem der lithographische Druckplattenvorläufer einer Belichtung mit Infrarot mit einer Wellenlänge von 830 nm bei einer Energiedichte von 110 $mJ/cm^2$ unterzogen wird, eine Helligkeitsänderung $\Delta L$ eines belichteten Abschnitts des lithographischen Druckplattenvorläufers vor und nach der Belichtung 5,0 oder mehr beträgt.

3. Laminat nach Anspruch 1 oder 2,
wobei ein Maximalwert eines molaren Absorptionskoeffizienten $\varepsilon$, den eine Farbentwicklungssubstanz, die aus dem Säurefarbentwicklungsmittel erzeugt wird, bei 400 nm bis 800 nm aufweist, 25.000 bis 200.000 beträgt.

4. Laminat nach einem der Ansprüche 1 bis 3,
wobei der lithographische Druckplattenvorläufer einen Träger und eine Bildaufzeichnungsschicht aufweist.

5. Laminat nach Anspruch 4,
wobei die Bildaufzeichnungsschicht das Säurefarbentwicklungsmittel enthält.

6. Laminat nach Anspruch 4 oder 5,

wobei die Bildaufzeichnungsschicht eine polymerisierbare Verbindung mit einem Molekulargewicht von 2.500 oder weniger enthält, und
ein Gehalt der polymerisierbaren Verbindung mit einem Molekulargewicht von 2.500 oder weniger 50 Massen-% oder weniger in Bezug auf eine Gesamtmasse der Bildaufzeichnungsschicht beträgt.

7. Laminat nach einem der Ansprüche 4 bis 6,
wobei der lithographische Druckplattenvorläufer ferner eine äußerste Schicht auf der Bildaufzeichnungsschicht aufweist.

8. Laminat nach Anspruch 7,
wobei die äußerste Schicht eine Verfärbungsverbindung enthält.

9. Laminat nach Anspruch 8,
wobei die Verfärbungsverbindung eine Verbindung, die Farbe aufgrund von Belichtung mit Infrarot entwickelt, enthält.

10. Laminat nach Anspruch 8 oder 9,
wobei die Verfärbungsverbindung eine zersetzbare Verbindung, die aufgrund von Belichtung mit Infrarot zersetzt wird, enthält.

11. Laminat nach einem der Ansprüche 8 bis 10,

wobei die Verfärbungsverbindung ein Cyaninfarbstoff ist.

**12.** Laminat nach einem der Ansprüche 8 bis 11,

wobei die Verfärbungsverbindung eine durch Formel 1-1 dargestellte Verbindung ist,

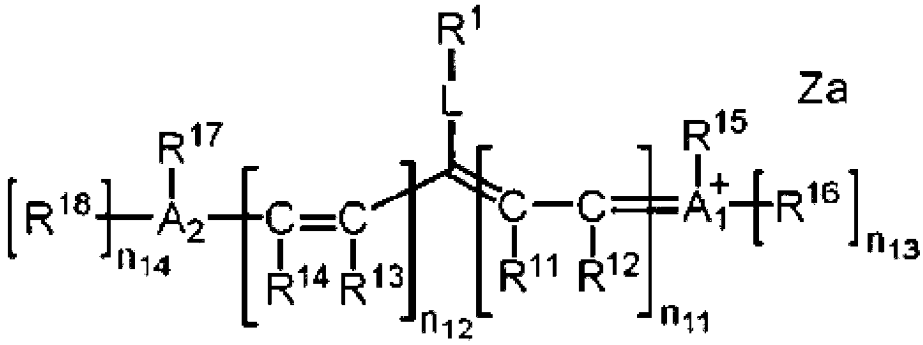

Formel 1-1

in Formel 1-1 $R^1$ eine Gruppe darstellt, die durch beliebige von Formel 2-1 bis Formel 4-1 dargestellt wird, $R^{11}$ bis $R^{18}$ jeweils unabhängig voneinander ein Wasserstoffatom, ein Halogenatom, $-R^a$, $-OR^b$, $-SR^c$ oder $-NR^dR^e$ darstellen, $R^a$ bis $R^e$ jeweils unabhängig voneinander eine Kohlenwasserstoffgruppe darstellen, $A_1$, $A_2$ und mehrere von $R^{11}$ bis $R^{18}$ so miteinander verbunden sein können, dass sie einen monozyklischen oder polyzyklischen Ring bilden, $A_1$ und $A_2$ jeweils unabhängig voneinander ein Sauerstoffatom, ein Schwefelatom oder ein Stickstoffatom darstellen, $n_{11}$ und $n_{12}$ jeweils unabhängig voneinander eine ganze Zahl von 0 bis 5 darstellen, eine Summe aus $n_{11}$ und $n_{12}$ 2 oder mehr beträgt, $n_{13}$ und $n_{14}$ jeweils unabhängig voneinander 0 oder 1 darstellen, L ein Sauerstoffatom, ein Schwefelatom oder $-N(R^{10})-$ darstellt, $R^{10}$ ein Wasserstoffatom, eine Alkylgruppe oder eine Arylgruppe darstellt und Za ein Gegenion, das Ladung neutralisiert, darstellt,

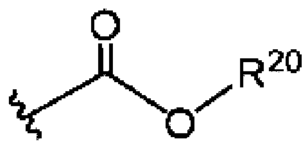

Formel 2-1

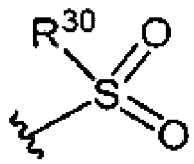

Formel 3-1

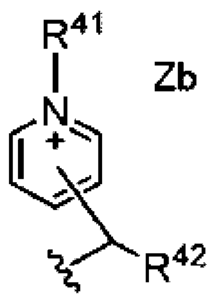

Formel 4-1

in Formel 2-1 bis Formel 4-1 $R^{20}$, $R^{30}$, $R^{41}$ und $R^{42}$ jeweils unabhängig voneinander eine Alkylgruppe oder eine Arylgruppe darstellen, Zb ein Gegenion darstellt, das Ladung neutralisiert, und eine Wellenlinie eine Bindungsstelle mit einer Gruppe, die durch L in Formel 1-1 dargestellt wird, darstellt.

**13.** Laminat nach einem der Ansprüche 8 bis 12,
wobei die Verfärbungsverbindung das Säurefarbentwicklungsmittel enthält.

**14.** Laminat nach einem der Ansprüche 7 bis 13,
wobei die äußerste Schicht ein wasserlösliches Polymer enthält.

**15.** Laminat nach einem der Ansprüche 4 bis 14,
wobei die Bildaufzeichnungsschicht einen Infrarotabsorber, einen elektronenannehmenden Polymerisationsinitiator und einen elektronenspendenden Polymerisationsinitiator enthält.

**16.** Laminat nach einem der Ansprüche 1 bis 15,
wobei das pH des Zwischenpapiers 6,5 bis 8 beträgt.

## Revendications

**1.** Stratifié comprenant :

un précurseur de plaque d'impression lithographique ; et
du papier intercalaire,
dans lequel le précurseur de plaque d'impression lithographique est un précurseur de plaque d'impression lithographique de type développement sur presse contenant un agent de développement de couleur acide dans au moins l'une quelconque des couches, et
un pH du papier intercalaire est de 5 ou plus,
l'agent de développement de couleur acide comprend un composé représenté par l'une quelconque des Formules (Le-1) à (Le-3) suivantes ou le composé CL-5 suivant :

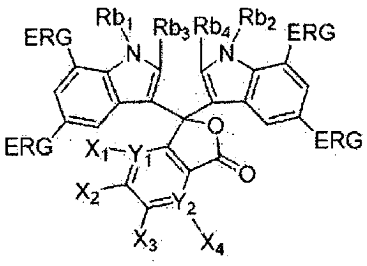
( Le - 1 )

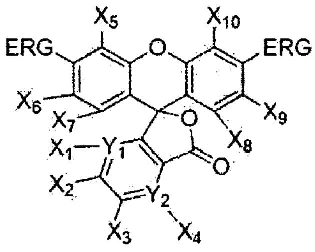
( Le - 2 )

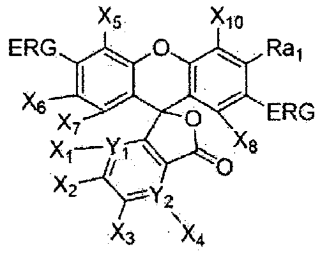
( Le - 3 )

dans Formule (Le-1) à Formule (Le-3), ERG représentent chacun indépendamment un groupe donneur d'électrons, $X_1$ à $X_4$ représentent chacun indépendamment un atome d'hydrogène, un atome d'halogène ou un groupe dialkylanilino, $X_5$ à $X_{10}$ représentent chacun indépendamment un atome d'hydrogène, un atome d'halogène ou un groupe organique monovalent, $Y_1$ et $Y_2$ représentent chacun indépendamment C ou N, $X_1$ n'existe pas dans un cas où $Y_1$ est N, $X_4$ n'existe pas dans un cas où $Y_2$ est N, $Ra_1$ représente un atome d'hydrogène, un groupe alkyle ou un groupe alkoxy, et $Rb_1$ à $Rb_4$ représentent chacun indépendamment un atome d'hydrogène, un groupe alkyle ou un groupe aryle,

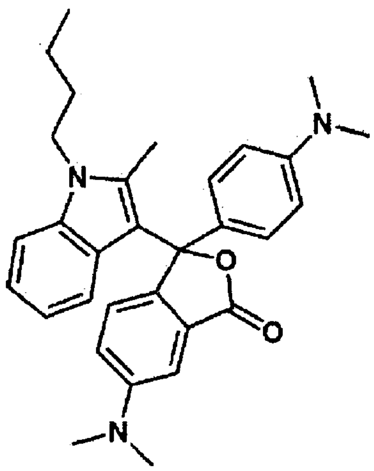

CL - 5

**2.** Stratifié selon la revendication 1,
dans lequel dans un cas où le précurseur de plaque d'impression lithographique est soumis à une exposition à l'infrarouge ayant une longueur d'onde de 830 nm à une densité d'énergie de 110 mJ/$cm^2$, un changement de luminosité $\Delta L$ d'une partie exposée du précurseur de plaque d'impression lithographique avant et après l'exposition est de 5,0 ou plus.

**3.** Stratifié selon la revendication 1 ou la revendication 2,
dans lequel une valeur maximale d'un coefficient d'absorption molaire ε que présente une substance de développement de couleur générée à partir de l'agent de développement de couleur acide à 400 nm à 800 nm est de 25 000 à 200 000.

**4.** Stratifié selon l'une quelconque des revendications 1 à 3,
dans lequel le précurseur de plaque d'impression lithographique comporte un support et une couche d'enregistrement d'images.

**5.** Stratifié selon la revendication 4,
dans lequel la couche d'enregistrement d'images contient l'agent de développement de couleur acide.

**6.** Stratifié selon la revendication 4 ou la revendication 5,

dans lequel la couche d'enregistrement d'images contient un composé polymérisable ayant un poids moléculaire de 2 500 ou moins, et
une teneur en composé polymérisable ayant un poids moléculaire de 2 500 ou moins est de 50 % en masse ou moins par rapport à une masse totale de la couche d'enregistrement d'images.

**7.** Stratifié selon l'une quelconque des revendications 4 à 6,
dans lequel le précurseur de plaque d'impression lithographique comporte en outre une couche la plus externe sur la couche d'enregistrement d'images.

**8.** Stratifié selon la revendication 7,
dans lequel la couche la plus externe contient un composé décolorant.

**9.** Stratifié selon la revendication 8,
dans lequel le composé décolorant inclut un composé qui développe une couleur sous l'effet d'une exposition à infrarouge.

**10.** Stratifié selon la revendication 8 ou la revendication 9,
dans lequel le composé décolorant inclut un composé décomposable qui se décompose sous l'effet d'une exposition à infrarouge.

**11.** Stratifié selon l'une quelconque des revendications 8 à 10,
dans lequel le composé décolorant est un colorant cyanine.

**12.** Stratifié selon l'une quelconque des revendications 8 à 11,

dans lequel le composé décolorant est un composé représenté par Formule 1-1,

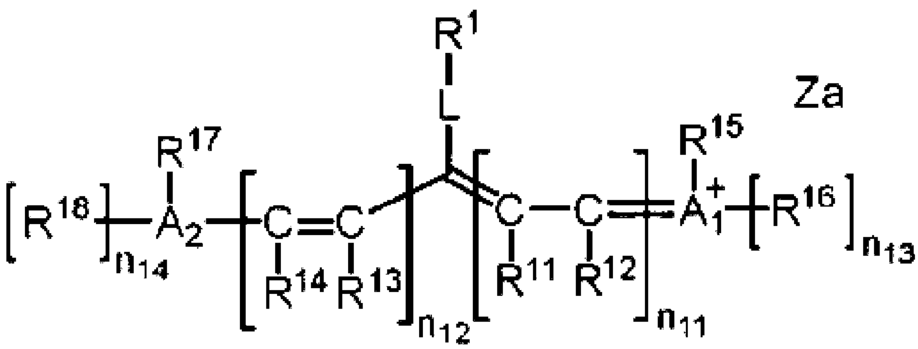

Formule 1-1

dans Formule 1-1, $R^1$ représente un groupe qui est représenté par l'une quelconque de Formule 2-1 à Formule 4-1, $R^{11}$ à $R^{18}$ représentent chacun indépendamment un atome d'hydrogène, un atome d'halogène, $-R^a$, $-OR^b$, $-SR^c$ ou $-NR^dR^e$, $R^a$ à $R^e$ représentent chacun indépendamment un groupe hydrocarboné, $A_1$, $A_2$, et une pluralité de $R^{11}$ à $R^{18}$ peuvent être liés entre eux pour former un cycle monocyclique ou polycyclique, $A_1$ et $A_2$ représentent chacun indépendamment un atome d'oxygène, un atome de soufre ou un atome d'azote, $n_{11}$ et $n_{12}$ représentent

chacun indépendamment un entier de 0 à 5, une somme de $n_{11}$ et $n_{12}$ est de 2 ou plus, $n_{13}$ et $n_{14}$ représentent chacun indépendamment 0 ou 1, L représente un atome d'oxygène, un atome de soufre ou - $N(R^{10})$-, $R^{10}$ représente un atome d'hydrogène, un groupe alkyle ou un groupe aryle, et Za représente un contre-ion qui neutralise une charge,

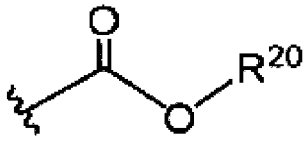

Formule 2-1

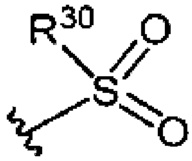

Formule 3-1

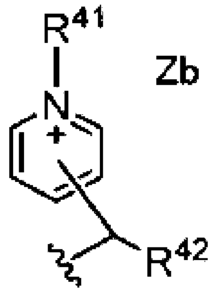

Formule 4-1

dans Formule 2-1 à Formule 4-1, $R^{20}$, $R^{30}$, $R^{41}$ et $R^{42}$ représentent chacun indépendamment un groupe alkyle ou un groupe aryle, Zb représente un contre-ion qui neutralise une charge, et une ligne ondulée représente un site de liaison avec un groupe représenté par L dans Formule 1-1.

**13.** Stratifié selon l'une quelconque des revendications 8 à 12,
dans lequel le composé décolorant inclut l'agent de développement de couleur acide.

**14.** Stratifié selon l'une quelconque des revendications 7 à 13,
dans lequel la couche la plus externe contient un polymère hydrosoluble.

**15.** Stratifié selon l'une quelconque des revendications 4 à 14,
dans lequel la couche d'enregistrement d'images contient un absorbeur infrarouge, un initiateur de polymérisation accepteur d'électrons et un initiateur de polymérisation donneur d'électrons.

**16.** Stratifié selon l'une quelconque des revendications 1 à 15,
dans lequel le pH du papier intercalaire est de 6,5 à 8.

FIG. 1

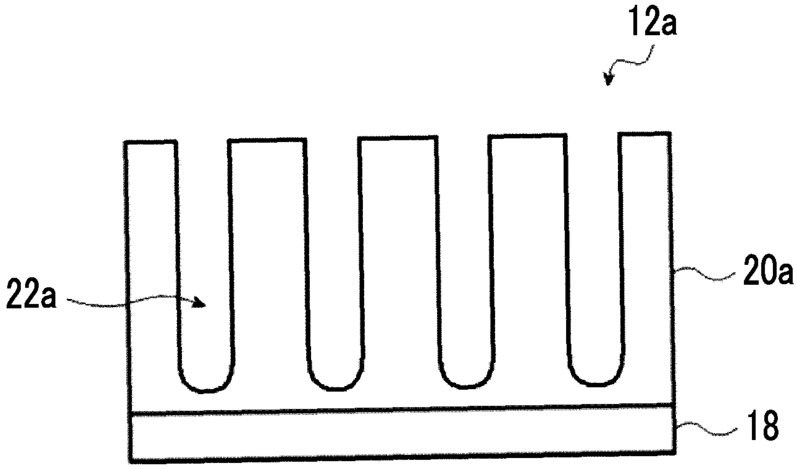


FIG. 2

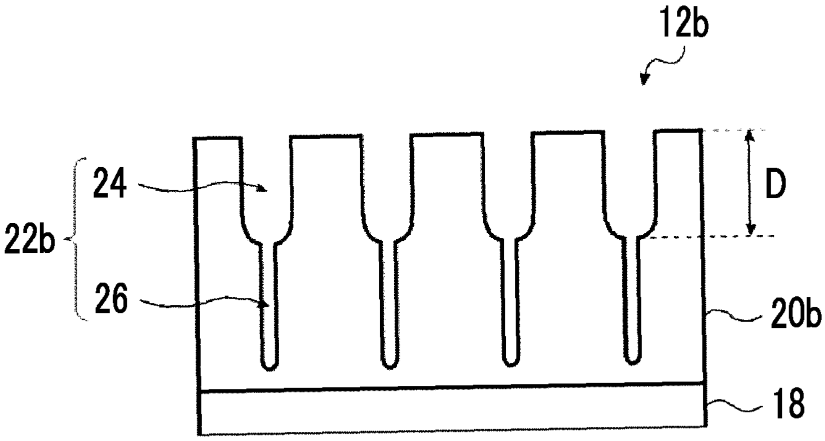


FIG. 3

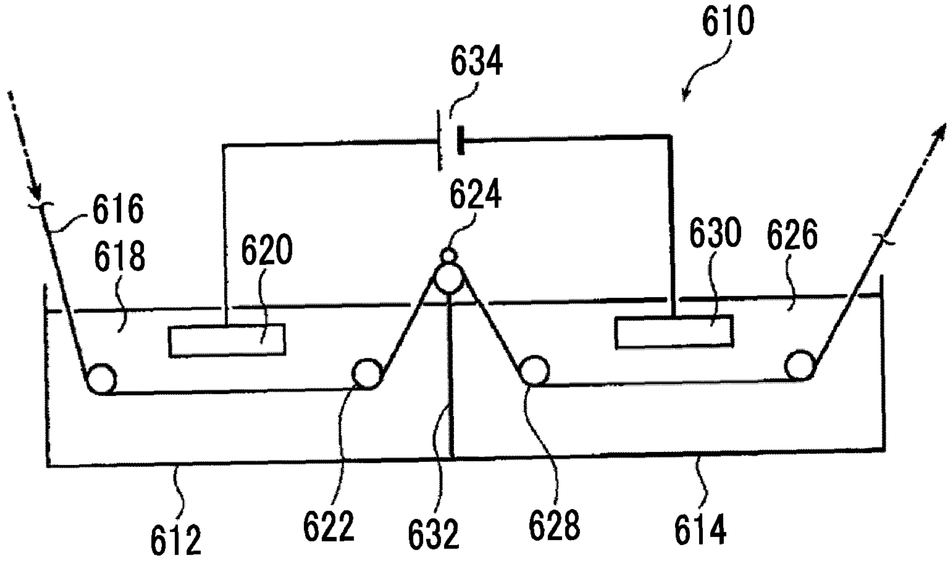

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2010076336 A
- JP 2005246966 B
- JP 2010008561 B
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- WO 2019013268 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- WO 2018043259 A
- JP 2019064269 A
- JP 2009255434 A
- JP 2012187907 A
- JP 2012148555 A
- WO 2019219560 A
- JP 2005250216 A
- JP 2006259137 A
- JP 2006297907 A
- JP 2007050660 A
- JP 2008284858 A
- JP 2009090645 A
- JP 2009208458 A
- WO 2016047392 A
- JP 2019162855 A
- JP 5045885 A
- JP H545885 A
- JP 6035174 A
- JP H635174 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A

### Non-patent literature cited in the description

- Dye Handbooks. Society of Synthetic Organic Chemistry, 1970
- *Research Disclosure*, January 1992 (33303)
- Iwanami Dictionary of Physics and Chemistry. Iwanami Shoten, Publishers, 1998